(19) Europäisches Patentamt
European Patent Office
Office européen des brevets

(11) EP 4 534 494 A1

(12) EUROPEAN PATENT APPLICATION

(43) Date of publication:
09.04.2025 Bulletin 2025/15

(21) Application number: 24182338.4

(22) Date of filing: 14.06.2024

(51) International Patent Classification (IPC):
C03C 15/00 (2006.01)      C03C 17/34 (2006.01)
C03C 23/00 (2006.01)      B23K 26/082 (2014.01)
G03F 7/00 (2006.01)

(52) Cooperative Patent Classification (CPC):
G03F 7/0015; B23K 26/082; C03C 15/00;
C03C 17/34; C03C 23/0025; G03F 7/0005;
G03F 7/70891; B23K 2103/54

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 14.06.2023 DE 102023205568

(71) Applicant: Carl Zeiss SMT GmbH
73446 Oberkochen (DE)

(72) Inventors:
• Bielke, Uwe
  73447 Oberkochen (DE)
• Dauth, Markus
  73447 Oberkochen (DE)
• Dier, Oliver
  73447 Oberkochen (DE)
• Faas, Sebastian
  73447 Oberkochen (DE)
• Fetzer, Matthias
  73447 Oberkochen (DE)
• Gatzen, Caren
  73447 Oberkochen (DE)
• Hermann, Ingo
  73447 Oberkochen (DE)
• Hussein, Rudy
  73447 Oberkochen (DE)

• Lenz, Daniel
  73447 Oberkochen (DE)
• Mettenleiter, Luca
  73447 Oberkochen (DE)
• Mysliwitz, Eric
  73447 Oberkochen (DE)
• Nolte, Stefan
  07743 Jena (DE)
• Pflanz, Ulrich
  73447 Oberkochen (DE)
• Ross, Benjamin
  73447 Oberkochen (DE)
• Ruck, Simon
  73447 Oberkochen (DE)
• Seifert, Andreas
  73447 Oberkochen (DE)
• Suleiman, Samer
  73447 Oberkochen (DE)
• Ullsperger, Tobias
  73447 Oberkochen (DE)
• Zipfel, Jonas
  73447 Oberkochen (DE)

(74) Representative: Ostertag & Partner Patentanwälte
mbB
Azenbergstraße 35
70174 Stuttgart (DE)

Remarks:
Claims 16 to 49 are deemed to be abandoned due to
non-payment of the claims fees (Rule 45(3) EPC).

(54) METHOD FOR INCORPORATING TEMPERATURE-REGULATING HOLLOW STRUCTURES INTO A SUBSTRATE, IN PARTICULAR INTO A SUBSTRATE FOR AN OPTICAL ELEMENT

(57) In a method for incorporating temperature-regulating hollow structures (22) into a substrate (12), in particular into a substrate for an optical element, in particular for a mirror (10) for an EUV projection exposure apparatus, there are the following steps: (A) providing a substrate (12) consisting of a substrate material (12a); (8) progressively focusing a processing light beam (46) on ablation locations (56) at which temperature-regulating hollow structures (22) are intended to arise, such that the substrate material (12a) is modified or ablated at the ablation locations (54), wherein that side of the temperature-regulating hollow structure (22) which is reached first by the processing light beam (46) defines the top side of the temperature-regulating hollow structure (22) and the direction upward as positive z-direction of a coordinate system which is anchored in a rotationally fixed manner with the substrate (12); wherein (C) a scanning process is carried out in which the processing light beam (46) is guided with a focus (48) in such a way that an ablation focus (48A) is moved along a scanning trajectory (78) through the substrate (12), wherein at the ablation focus (48A) the processing light beam (46) inputs energy with an energy density H into the substrate material (12a), which is high enough that the substrate material (12a) is modified or ablated. (D) The scanning trajectory (78) comprises a plurality of scanning patterns (64, 116, 120) which each define a pattern scanning path and are scanned in scanning positions (74), such that an ablation volume defining a slice (62, 114, 166) is ablated in each scanning position (74(n)). (E) The scanning positions (74) are spaced apart from one another in a longitudinal direction (60) of the temperature-regulating hollow structure (22) to be produced. (F) The scanning trajectory (78) additionally comprises pattern jump paths (76) in each case between a scanning pattern (64) of a first scanning position (74(n)) and a scanning pattern (64) of a second scanning position (74(m)). Moreover, a method and a substrate (12) for producing an optical element (8), an optical element (8) and also a processing system (40) and an apparatus pertaining to semiconductor technology (6) are specified.

Fig. 1

**Description**

REFERENCE

The present application claims the priority of German patent application 102023205568.6, which was filed on 14 June 2023. The entire disclosure of that earlier application is hereby incorporated by reference in the present application.

BACKGROUND OF THE INVENTION

1. Field of the invention

The invention relates to a method for incorporating temperature-regulating hollow structures into a substrate, in particular into a substrate for an optical element, in particular for a mirror for an EUV projection exposure apparatus, comprising the following steps:

(A) providing a substrate consisting of a substrate material;

(B) progressively focusing a processing light beam on ablation locations at which temperature-regulating hollow structures are intended to arise, such that the substrate material is modified or ablated at the ablation locations, wherein that side of the temperature-regulating hollow structure which is reached first by the processing light beam defines the top side of the temperature-regulating hollow structure and the direction upward as positive z-direction of a coordinate system which is anchored in a rotationally fixed manner with the substrate;
wherein

(C) a scanning process is carried out in which the processing light beam is guided with a focus in such a way that an ablation focus is moved along a scanning trajectory through the substrate, wherein at the ablation focus the processing light beam inputs energy with an energy density H into the substrate material, which is high enough that the substrate material is modified or ablated.

Moreover, the invention relates to a method for producing an optical element, in particular for producing a mirror for an EUV projection exposure apparatus.
Furthermore, the invention relates to a substrate for producing an optical element, in particular for producing a mirror for an EUV projection exposure apparatus, wherein the substrate has temperature-regulating hollow structures, and also an optical element, in particular a mirror for an EUV projection exposure apparatus comprising a substrate.
The invention further relates to a processing system for incorporating temperature-regulating hollow structures into a substrate, in particular into a substrate for a mirror for an EUV projection exposure apparatus, comprising

a) a light source, by which a processing light beam is generable;

b) a focusing device, by means of which the processing light beam is focusable on ablation locations at which temperature-regulating hollow structures are intended to arise;

c) a control device, by means of which the focusing device is controllable.

In addition, the invention relates to an apparatus pertaining to semiconductor technology and to a structured electronic component.
The following description of the invention is given on the basis of an optical element in the form of a mirror and the use thereof in an EUV projection exposure apparatus, wherein heat is dissipated from the mirror by a temperature-regulating fluid in the form of a cooling fluid being caused to flow through the temperature-regulating hollow structures present in said mirror.
In principle, however, the following explanations apply generally to optical elements which can be assigned a substrate composed of a substrate material into which temperature-regulating hollow structures are incorporated, through which a temperature-regulating fluid can be caused to flow for temperature compensation during operation of the optical element.
In particular, optical elements are used in apparatuses pertaining to semiconductor technology in which an object is irradiated with a working radiation with the aid of one or more optical elements. Besides an EUV projection exposure apparatus, such apparatuses for semiconductor technology include, in particular, mask inspection apparatuses and wafer inspection apparatuses.

On the one hand, temperature regulation can be cooling or heating of the optical element or of at least one region of the optical element. That is to say that, with the aid of the temperature-regulating fluid, the optical element as a whole or at least in a volume region is brought to a temperature which it was not at previously.

On the other hand, however, temperature regulation can also have the effect that a specific temperature or a specific temperature range of the optical element or of at least one region of the optical element is or stays maintained.

These considerations furthermore generally apply to components comprising a corresponding substrate which carries or can carry one or more functional units and into which temperature-regulating hollow structures are incorporated, through which a temperature-regulating fluid can be caused to flow for temperature regulation during operation of the component. Such a component can provide a sensor device, for example; in this case, the substrate carries sensor units as functional units.

2. Description of the prior art

Microlithographic projection exposure apparatuses are used in chipmaking for the production of micro-structured and nanostructured circuits in order to transfer structures on a mask to a photoresist that has previously been applied to a wafer. For this purpose, the mask is illuminated with light and imaged onto the light-sensitive layer in a reduced size. In EUV projection exposure apparatuses, the light has a wavelength of between approximately 5 nm and approximately 30 nm; the apparatuses commercially available at the present time use light having a wavelength of 13.5 nm.

However, there are no optical materials which have a sufficiently high transmissivity for such short wavelengths. Therefore, in EUV projection exposure apparatuses, the lens elements that have been customary at longer wavelengths are replaced by mirrors and the mask, too, thus contains a pattern of reflective structures.

The provision of mirrors for EUV projection exposure apparatuses is technologically demanding. The substrate consists of a substrate material, which is generally glass, e.g. titanium-doped quartz glass such as ULE®, or a glass ceramic. Suitable glass ceramics are offered under the trade names Clearceram® or Zerodur® and have the property of having a very low coefficient of thermal expansion at the operating temperature of the mirror.

A coating which reflects the EUV light and consists of a multiplicity of thin double layers having alternating refractive indices is applied to the substrate.

Even with such complexly constructed coatings, however, the reflectivity of the mirrors for the EUV light is rarely more than 70%, and even this is only for light which impinges on the reflective coating with normal incidence or with angles of incidence of a few degrees. The portion of the EUV light which is not reflected by the coating is absorbed in the substrate, where it leads to considerable heating since the EUV light sources used are very powerful. Even if glass ceramics having low coefficients of thermal expansion are used, the heating may lead to unacceptable changes in shape of the mirrors.

It has therefore been proposed to provide the substrates with temperature-regulating hollow structures, which in this case are cooling hollow structures, wherein in particular temperature-regulating channels in the form of cooling channels are provided, through which water or some other temperature-regulating fluid, i.e. here a cooling fluid, flows during operation and dissipates heat in this way. Such temperature-regulating channels may have small cross-sectional diameters of the order of magnitude of only approximately 1 $mm^2$ and ideally run closely below the reflective coating.

An overview of the hitherto known methods for producing temperature-regulating channels is contained in the application DE 10 2021 214 310.5, the disclosure of which is hereby incorporated in its entirety. In one advantageous method, by way of example, an ablation light beam is progressively focused on ablation locations at which temperature-regulating channels are intended to arise and the substrate material is ablated by the ablation light beam.

In one variant of this method, ablated substrate material is rinsed away by a rinsing fluid. In that case, a temperature-regulating channel is incorporated into the substrate material proceeding from the surface of the substrate, such that a temperature-regulating channel section that lengthens in the course of the process progressively forms until the desired temperature-regulating channel has been fully incorporated. In general, the externally accessible temperature-regulating channel section is used as a connecting path for the rinsing fluid toward and away from the processing locations.

When flowing through such a temperature-regulating hollow structure, the temperature-regulating fluid or cooling fluid may induce so-called FIVs ("flow induced vibrations"), i.e. vibrations of the mirror during operation, the influence of which ought to be minimized.

It has been found that the effectiveness of the temperature regulation of the substrate and the heat transfer between the substrate and a temperature-regulating fluid flowing through a temperature-regulating hollow structure is determined by many factors, which are in turn influenced by the course, the formation and the surface properties of the temperature-regulating hollow structures. A rapid reaction to changed parameters or else to new insights is desirable when producing the temperature-regulating hollow structures.

## SUMMARY OF THE INVENTION

Therefore, the object of the invention is to specify the abovementioned methods, a substrate, an optical element, a processing system and an apparatus pertaining to semiconductor technology of the type mentioned in the introduction which take account of these concepts and in particular provide possibilities for flexibly counteracting the FIVs in a substrate. Temperature-regulating hollow structures are intended to be introduced into the substrate with high precision and quality and with good process speed and process effectiveness.

In the case of a method of the type mentioned in the introduction, this object is achieved by virtue of the fact that

(D) the scanning trajectory comprises a plurality of scanning patterns which each define a pattern scanning path and are scanned in scanning positions, such that an ablation volume defining a slice is ablated in each scanning position;

wherein

(E) the scanning positions are spaced apart from one another in a longitudinal direction of the temperature-regulating hollow structure to be produced;

(F) the scanning trajectory additionally comprises pattern jump paths in each case between a scanning pattern of a first scanning position and a scanning pattern of a second scanning position.

Such a set-up of a scanning trajectory makes possible high flexibility in the programming of a control device used to predefine a corresponding scanning trajectory. In particular, relatively long sections of the scanning trajectory can stay predefined by predefined scanning patterns and just their sequence and position within the substrate can be reconfigured and the control commands to that end can be recalculated.

In different scanning positions, different scanning patterns or else identical scanning patterns can be scanned, individual or all scanning patterns of which can then also be implemented repeatedly.

Details concerning the advantages and effects and also concerning applications of the features explained below will become apparent from the description of the exemplary embodiments.

A finer resolution of the scanning trajectory and the adaptation thereof to desired formations of the temperature-regulating hollow structure are possible in any case if a scanning pattern defines a number of one or a plurality of hatch lines along which the ablation focus is guided in a scanning direction from a beginning to an end of a respective hatch line, wherein given a number of a plurality of hatch lines a hatch jump path comprised by the scanning trajectory is in each case defined between the end of a first hatch line and the beginning of a second hatch line, wherein

(G1) as scanning patterns line-to-line scanning patterns with hatch lines which have the same scanning direction are scanned
and/or

(G2) as scanning patterns meandering scanning patterns with hatch lines which have opposite scanning directions are scanned;
and/or

(G3) as scanning patterns sector scanning patterns are scanned which

(a) have sectors, each of which is assigned a hatch distance hd at which two adjacent hatch lines run, wherein the hatch distance hd in a sector differs from the hatch distance hd in at least one adjacent sector;
and/or

(b) have sectors in which the sequence of the scanning directions of the hatch lines is different;
and/or

(G4) as scanning patterns groove scanning patterns with hatch lines which run at a hatch distance hd from one another which is greater than the beam diameter of the processing light beam at the ablation focus are scanned;
and/or

(G5) as scanning pattern an intermediate scanning pattern is scanned in a scanning position which defines an intermediate scanning position, wherein the hatch lines of the intermediate scanning pattern cover a smaller area than the hatch lines of a scanning pattern which was scanned previously in a preceding scanning position which is not an intermediate scanning position;
and/or

(G6) as scanning pattern a contour scanning pattern is scanned which has hatch lines as core region and additionally a contour region which at least sectionally surrounds the core region and in which one or more hatch lines are scanned as contour hatch lines which supplement the hatch lines in the core region and have a course along the contour of the contour scanning pattern, wherein the contour hatch lines comprise in particular circular hatch lines or at least one spiral hatch line;
and/or

(G7) as scanning patterns single-hatch scanning patterns are scanned in which the number of hatch lines is equal to one;
and/or

(G8) as scanning pattern a partial cross-section scanning pattern is scanned which covers only a radially outer part of the cross-section of a section of the temperature-regulating hollow structure to be produced;

where in these steps (G1), (G2), (G3), (G4), (G5), (G6), (G7) or (G8) the scanning pattern is in each case scanned as such or as part of a then superordinate scanning pattern.

It can be advantageous if a pattern jump path in each case runs between the end of a hatch line of a scanning pattern in a first scanning position and the beginning of a hatch line of a scanning pattern in a second scanning position and

(H1) the scanning trajectory between two adjacent scanning positions comprises exactly one pattern jump path;
and/or

(H2) the scanning trajectory between two adjacent scanning positions comprises two or more pattern jump paths.

If step (G5) is carried out, this is preferably effected in such a way that

(a) an intermediate scanning position runs between two scanning positions which are not intermediate scanning positions;
or

(b) a plurality of intermediate scanning positions are adjacent.

In this case, if each end of each hatch line of the intermediate scanning pattern is the beginning of a pattern jump path, advantageously after each scanned hatch line scanning in a different scanning position can take place.

The scanning of a scanning pattern results in a slice being ablated in an ablation direction ad, with the advantageous alternatives that

(11) slices are ablated in two or more successive scanning positions in the same ablation direction ad;
or

(I2) slices are ablated in two or more successive scanning positions with different ablation directions ad.

Here it is preferred that

(J1) step (11) is carried out with the ablation direction ad from the bottom upward or with the ablation direction ad from the top downward, in particular with the ablation direction ad from the bottom upward;
or

(J2) step (I2) is carried out, wherein the scanning patterns are scanned in two successive scanning positions in a manner rotated relative to one another by a rotation angle $\beta$, in particular where $\beta = 10°$, in the circumferential direction;
or

(J3) step (I2) is carried out, wherein the scanning patterns are scanned in such a way that slices are ablated in two successive scanning positions with opposite ablation directions ad;
or

(J4) step (J3) is carried out and the ablation direction ad in the first of the two successive scanning positions runs from the bottom upward or from the top downward.

If step (G3)(a) is carried out, preferably the hatch lines of the sector with a larger hatch distance hd are scanned with a processing light beam having a greater pulse energy $E_P$ than the pulse energy $E_P$ of the processing light beam when scanning a sector with a smaller hatch distance hd.

In this case, it can be advantageous if the hatch lines with larger hatch distances hd, in two successive scanning positions, are scanned in a manner offset relative to one another in a direction transversely with respect to the scanning direction of the hatch lines.

Advantageously, the pulse energy $E_P$ of the processing light beam can be set in such a way that the ablation focus is attained in a defocus plane at a distance D above the focus, in which defocus plane the processing light beam has a larger beam diameter than the focus of the processing light beam.

Preferably, the peak pulse power Ps of the processing light beam is then less than the pulse power $P_L$ of the self-focusing threshold of the processing light beam.

It can be advantageous if the processing light beam is a processing beam operated in a burst mode.

If step (G4) is carried out, a groove scanning pattern can advantageously be scanned twice in the same scanning position and the groove scanning pattern during the second scan can be scanned in a manner rotated, in particular rotated by 90°, relative to the groove scanning pattern of the first scan, such that the hatch lines of the two groove scanning patterns cross one another in the relevant scanning position.

If step (G6) is carried out, it is advantageous if in the case of the contour scanning pattern a groove scanning pattern is scanned in the core region and contour scanning patterns are scanned in a plurality of scanning positions in such a way that lateral webs composed of substrate material are formed.

If step (G6) is carried out, it is advantageous if

(a) the contour hatch lines are circular hatch lines and the hatch lines in the core region are circular hatch lines or spiral hatch lines;
or
(b) the contour hatch lines are spiral hatch lines and the hatch lines in the core region are circular hatch lines or spiral hatch lines.

Preferably, the contour hatch lines and the hatch lines in the core region are then spiral hatch lines, such that the contour scanning pattern defines a spiral scanning pattern, in particular a spiral scanning pattern with a continuous spiral hatch line.

Great flexibility in the ablation of ellipses, in particular, can be achieved if the spiral hatch line of the spiral scanning pattern

(a) is an Archimedes' spiral; or
(b) is a logarithmic spiral; or
(c) is a complex spiral which

(c1) is defined in its xy-plane by $r = \sqrt{\cos(\alpha)\, r(x)^2 + \sin(\alpha) r(y)^2}$ ; or
(c2) is defined in its xy-plane by the function

$$y = \frac{(1+a)*x^b}{(x^{b-1}+a)} ;$$

or
(c3) is defined in its xy-plane by a sigmoid function and in particular by the functions

$$y = \frac{a}{1+e^{-bx+c}} ; \quad a * e^{e^{-bx+c}} + d$$

or

$$y = \quad a * tan(bx + c) + d \;.$$

If step (G6) is carried out, it is expedient in terms of control engineering and associated with a time gain if a circular hatch line or a spiral hatch line is scanned by polylines and/or microvectors.

Step (G7) is primarily advantageous if in this case the single-hatch scanning patterns are scanned in a helix scanning process in a sequence in which the respective hatch lines in different scanning positions each extend in the radial direction between a longitudinal central axis and an outer screw line of a geometric reference helix screw with a screw flight, such that a screw volume is ablated in the longitudinal direction.

In this case, it is expedient if

(a) the helix scanning process is carried out once in such a way that the ablated screw volume corresponds to a single-flight helix screw with a single screw flight;
or

(b) the helix scanning process is carried out repeatedly in such a way that the ablated screw volume corresponds to a multi-flight helix screw with a plurality of screw flights by virtue of two or more helix scanning processes being carried out in such a way that in a common scanning position the single-hatch scanning patterns of the helix scanning processes carried out separately are rotated by a rotation angle $\gamma$ in the circumferential direction.

Preferably, one or more pitches (h) of each reference helix screw for a helix scanning process are chosen in such a way that a string full volume is ablated.

If step (G7) is carried out, it is alternatively or supplementarily advantageous if a contour helix scanning process is carried out in such a way that

(a) a plurality of single-hatch scanning patterns are scanned in a sequence in which successively scanned single-hatch scanning patterns follow the course of the outer screw line of a geometric reference helix screw or lie approximately tangentially against the screw line;
or

(b) a single single-hatch scanning pattern is scanned with a hatch line which corresponds to the screw line of a geometric reference helix screw;
or

(c) wherein a plurality of single-hatch scanning patterns with a direction component pointing in the same direction as a longitudinal central axis of a geometric reference helix screw or as the longitudinal direction of the temperature-regulating hollow structure are scanned along the screw line of the reference helix screw.

Step (G8) is preferably carried out in such a way that partial cross-section scanning patterns are scanned in a partial pattern scanning process in which these are arranged in the scanning positions in such a way that each ablated slice lies on the outside against a screw line of a geometric reference helix screw.

In this case, identical or different partial cross-section scanning patterns can be scanned in each scanning position, wherein the partial cross-section scanning patterns in two successive scanning positions are rotated by a rotation angle $\gamma$ in the circumferential direction.

A change in the cross-section of the temperature-regulating hollow structure in the longitudinal direction can advantageously be achieved if, in two adjacent scanning positions, scanning patterns that are scanned are such that the slice in the second scanning position has at least regionally a larger radial extent than the slice in the first scanning position, wherein the deepest marginal line of the temperature-regulating hollow structure remains in the same xy-plane of the coordinate system.

In order to be able to flexibly follow the course of the temperature-regulating hollow structures to be produced, it is expedient if slices are ablated which are tilted by a pitch angle $\alpha$ relative to the yz-plane of the coordinate system which is anchored in a rotationally fixed manner with the substrate, wherein there are at least two slices which are ablated with different pitch angles $\alpha$.

In this case, the pitch angle $\alpha$ of a slice is preferably selected depending on the angle formed between the longitudinal direction of the temperature-regulating hollow structure to be produced and the yz-plane of the coordinate system which is anchored in a rotationally fixed manner with the substrate.

In the case of a method for producing an optical element, the object mentioned above is achieved by virtue of the fact that temperature-regulating hollow structures are incorporated into the substrate in accordance with the method explained above and further processing comprises one or more steps of chemical and/or physical processing of at least one surface of the substrate and also producing or applying a coating on the substrate, which coating is configured at least to reflect at least 50% of EUV light impinging with normal or almost normal incidence.

The object mentioned above is achieved by a substrate of the type mentioned in the introduction which comprises temperature-regulating hollow structures incorporated in accordance with the method.

The abovementioned FIVs, in particular, can be counteracted if, in the case of the substrate, at least one temperature-regulating hollow structure defines an internal lateral surface which is formed at least regionally by a periodic structure with a radial shaping and/or is formed at least regionally by a roughness structure having a mean roughness Ra in accordance with DIN EN ISO 25178, version as at 06/2023, of between 10.0 $\mu$m and 5.0 $\mu$m, which in particular is between 10.0 $\mu$m and 6.5 $\mu$m, between 10.0 $\mu$m and 8.0 $\mu$m, between 8.5 $\mu$m and 5.0 $\mu$m, between 7.0 $\mu$m and 5.0 $\mu$m or between 8.5 $\mu$m and 6.5 $\mu$m, or having a mean roughness Ra of 5.0 $\mu$m and less, which in particular is between 5.0 $\mu$m and 0.1 $\mu$m, preferably between 4.5 $\mu$m and 0.125 $\mu$m, between 4.0 $\mu$m and 0.15 $\mu$m, between 3.5 $\mu$m and 0.175 $\mu$m or between 3.0 $\mu$m and 0.2 $\mu$m.

Advantageously, the periodic structure is formed in such a way that, upon a projection of successive cross-sections of a section of the temperature-regulating hollow structure into an image plane, said periodic structure defines a contour line of the internal lateral surface which has a periodic course of recurring structural elements at least in a section in the circumferential direction. Alternatively or supplementarily, the roughness structure is formed in such a way that it extends out along the full circumference in the circumferential direction at least in a section in the longitudinal direction of the temperature-regulating hollow structure.

Different kinds of structural elements which occur periodically in the circumferential direction can be formed in this case. These structural elements can also be superimposed.

It is advantageous if the periodic structure is formed in the form of a rib structure with ribs as structural elements, which extends in the longitudinal direction of the temperature-regulating hollow structure and has a radial shaping.

In this case, the ribs of the rib structure preferably in the circumferential direction are at a distance of the order of magnitude of 0.5 to 1.5 times the distance between two adjacent hatch lines (66), in particular between 10 $\mu$m and 30 $\mu$m, with preference between 15 $\mu$m and 25 $\mu$m and preferably approximately 20 $\mu$m, and radially have a shaping with a ratio of 1:100 to 1:7 relative to the average diameter at a cross-section of the temperature-regulating hollow structure. In the case of a temperature-regulating channel having an exemplary diameter of 2 mm, the radial shaping thus lies in a cross-section of between 20 $\mu$m and approximately 285 $\mu$m.

An even more advantageous flow behavior of a temperature-regulating fluid can be achieved if the periodic structure, in particular in the form of the rib structure, is formed in a first region of the internal lateral surface of the temperature-regulating hollow structure and the internal lateral surface of the temperature-regulating hollow structure, in a second region, is formed by a structure which is different than the periodic structure and which has a more uniform area with smaller shaping in the radial direction than the periodic structure.

It is particularly advantageous if the first region and the second region are arranged on opposite sides of the temperature-regulating hollow structure.

FIVs can likewise be reduced if the temperature-regulating hollow structure, in particular periodically, repeatedly widens and narrows in the longitudinal direction.

In this case, the cross-sections of the temperature-regulating hollow structure in the repeatedly widening section can be asymmetrical with respect to the longitudinal central axis of the temperature-regulating hollow structure.

What has proved to be particularly advantageous is a flow surface with periodically occurring elevations and depressions which is formed in such a way that the internal lateral surface of the temperature-regulating hollow structure, in longitudinal sections through the longitudinal central axis, follows a wavy line at least on one side, wherein there is in particular at least one longitudinal section through the longitudinal central axis in which the internal lateral surface of the temperature-regulating hollow structure follows a wavy line on one side and a straight line on the other side.

What can be advantageous in respect of the heat transfer and optionally the heat dissipation is if the temperature-regulating hollow structure has recesses which are spaced apart from one another in the longitudinal direction and which have at least one height h at which vortex flows of a temperature-regulating fluid flowing through the temperature-regulating hollow structures occur, in which the temperature-regulating fluid circulates at least at times.

Alternatively or supplementarily, flow structures which reduce the frictional resistance vis-à-vis a flowing liquid temperature-regulating fluid can be formed on the internal lateral surface of the temperature-regulating hollow structure.

Particularly advantageously, the flow structures are riblet structures with ribs formed in the longitudinal direction.

The riblet structures can preferably correspond to the surface of a scale structure composed of a multiplicity of individual scales with ribs.

In the case of an optical element of the type mentioned in the introduction, the object specified above is achieved if the substrate is a substrate having some or all of the features described above.

The substrate can be used particularly effectively if the optical element is a mirror for an EUV projection exposure apparatus, and the substrate has a carrier surface bearing a coating configured at least to reflect at least 50% of EUV light impinging with normal or almost normal incidence.

In the case of the processing system mentioned in the introduction, the object specified above is achieved by virtue of the fact that the processing system is configured in such a way that it controls the focusing device in the manner such that the method specified above for incorporating temperature-regulating hollow structures into a substrate is carried out.

In particular, for this purpose, the control device is programmed in such a way that the method steps are carried out.

In the case of an apparatus pertaining to semiconductor technology, the object is achieved by such an optical element.

This is particularly advantageous in the case of an EUV projection exposure apparatus.

BRIEF DESCRIPTION OF THE DRAWINGS

Exemplary embodiments of the invention are explained in greater detail below with reference to the drawings. In these drawings:

figure 1    schematically shows a section through an optical element in the form of a mirror for an EUV projection exposure apparatus, which mirror comprises temperature-regulating hollow structures in the form of temperature-regulating channels, through which a cooling fluid is caused to flow by means of a cooling system;

figure 2    shows a processing system used to incorporate temperature-regulating hollow structures into a substrate by means of a processing light beam;

figure 3    shows the detail III in figure 2 on a larger scale;

figure 4    shows a projection view of a line-to-line scanning pattern and foci of the processing light beam on a hatch line;

figure 5    shows a perspective view and a side view of a plurality of scanning positions with line-to-line scanning patterns;

figure 6    shows a projection view of a meandering scanning pattern;

figure 7    shows a perspective view and a side view of a plurality of scanning positions with meandering scanning patterns;

figure 8    shows views of scanning patterns and illustrations of the internal lateral surface of a temperature-regulating hollow structure produced by said scanning patterns;

figure 9    shows scanning patterns during a rotation process;

figure 10    shows an illustration of the internal lateral surface of a temperature-regulating hollow structure obtained by the rotation process;

figure 11    shows the overlap of pulses for increasing the ablation efficiency;

figure 12    shows a sector scanning pattern and a first scanning variant;

figure 13    shows a second scanning variant with sector scanning patterns;

figure 14    schematically shows a displacement of the ablation focus of a laser beam into a defocus plane;

figure 15    shows scanning variants with different pulse energies $E_P$;

figure 16    shows the temporal profile of a 3-pulse burst in the case of traditional surface processing;

figure 17    shows a groove scanning pattern with foci of the laser beam;

figure 18 shows scanning positions with the groove scanning patterns and a micrograph of an exemplary internal lateral surface of a temperature-regulating hollow structure;

figure 19 shows a photograph of an arc section of a temperature-regulating hollow structure with filaments;

figure 20 schematically shows the ablation of slices in different ablation directions;

figure 21 shows a plurality of scanning planes during a scan with the same ablation direction in each case;

figure 22 shows an intermediate scanning pattern;

figure 23 shows a perspective view of a sequence of scanning positions and intermediate scanning positions with scanning patterns;

figure 24 shows variants with a plurality of intermediate scanning positions arranged one behind another;

figure 25 shows a modification with a plurality of pattern jump paths between two scanning positions with modified scanning patterns;

figure 26 shows a variant with a plurality of intermediate scanning positions arranged one behind another;

figure 27 shows a micrograph of a section of the internal lateral surface of a temperature-regulating hollow structure thus obtained;

figure 28 shows views of contour scanning patterns and schematically thereby obtained internal lateral surfaces of temperature-regulating hollow structures;

figure 29 shows a modified contour scanning pattern and a modified scanning concept;

figure 30 shows scanning concepts for a change in the cross-section of the temperature-regulating hollow structure during the scanning process;

figure 31 shows a longitudinal section in respect of a temperature-regulating hollow structure with periodic widened portions and narrowed portions;

figure 32 shows a longitudinal section and a cross-section in respect of a temperature-regulating hollow structure with vortex zones for a temperature-regulating fluid;

figure 33 shows concepts for periodic structures which reduce the frictional resistance to a liquid temperature-regulating fluid;

figure 34 schematically shows an apparatus pertaining to semiconductor technology on the basis of the example of an EUV projection exposure apparatus;

figure 35 shows the detail in accordance with figure 3, the application of single-hatch scanning patterns in a helix scanning process being elucidated;

figure 36 shows illustrations of carrying out the helix scanning process once;

figure 37 shows illustrations of carrying out the helix scanning process a number of times;

figure 38 shows the detail in accordance with figure 3, the supplementary application of a contour helix scanning process being elucidated;

figure 39 shows an enlarged detail from figure 38, the application of a modified contour helix scanning process being elucidated;

figure 40 shows the detail in accordance with figure 3, the application of a partial pattern scanning process being elucidated;

figure 41    shows the detail in accordance with figure 3, scanning of scanning patterns with different pitch angles being elucidated;

figure 42    shows a concept for producing contour scanning patterns in accordance with figures 28 and 29 with circular hatch lines in the contour region;

figure 43    shows a concept for producing contour scanning patterns in accordance with figure 28 with spiral hatch lines in the contour region;

figure 44    shows concepts for producing spiral scanning patterns with spiral hatch lines both in the contour region and in the core region.

## DESCRIPTION OF PREFERRED EXEMPLARY EMBODIMENTS

1. Set-up of an optical element on the basis of the example of an EUV mirror

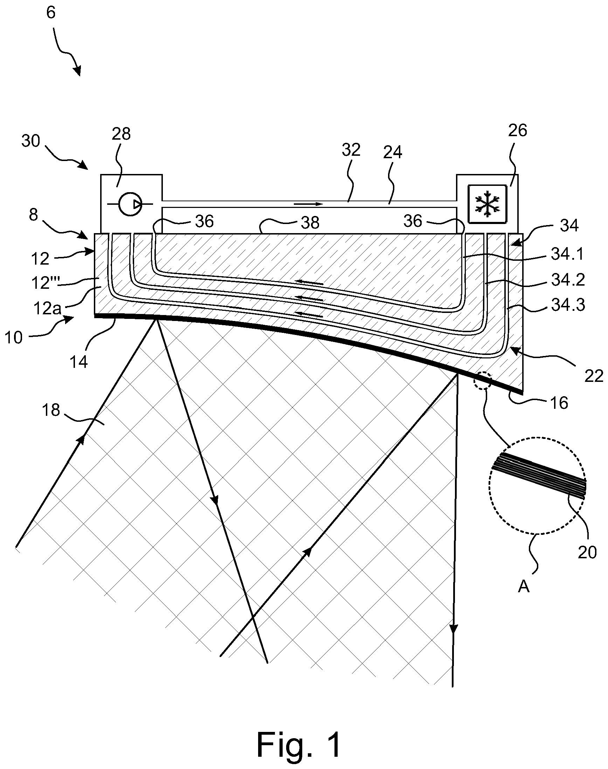

In figure 1, an apparatus pertaining to semiconductor technology explained in the introduction is designated overarchingly by 6 and a section through an optical element designated in its entirety by 8 is shown, which optical element is illustrated by way of example as a mirror 10 for an EUV projection exposure apparatus. The mirror 10 can be arranged there in the illumination system or in the projection lens.

The optical element 8 and thus the mirror 10 comprises a substrate 12 composed of a substrate material 12a, which is therefore a mirror substrate in the case of the present exemplary embodiment of the mirror 10. Such a mirror substrate is in practice a glass ceramic, in particular.

The substrate 12 is monolithic in the case of the present exemplary embodiment, which is also the preferred embodiment. In modifications not shown separately, however, the substrate 12 can also be joined together from partial segments. In principle, additive manufacturing methods are suitable in this case. By way of example, 3D printing methods are also appropriate just like laser welding methods or techniques for the thermal bonding of workpieces.

In the case of the mirror 10, the substrate 12 has a precisely processed surface 14, the curvature of which determines the optical properties of the mirror 10. The surface 14 of the substrate 12 serves as a carrier surface and will also be referred to thus hereinafter. The carrier surface 14 bears a coating 16 ensuring the optical properties of the optical element 8. In the case of the mirror 10 shown here, the coating 16 is configured in such a way that it predominantly reflects incident EUV light 18. As is illustrated in the enlarged detail A, in the case of the present exemplary embodiment, this coating 16 is embodied in multilayer fashion and is constructed in particular from a plurality of double layers 20 which were applied to the carrier surface 14. The coating 16 has a reflection coefficient of at least 50%, preferably of more than 72%, for normal-incidence EUV light 18. The reflectance achieved during operation depends on the angle of incidence of the EUV light 18.

Besides the double layers 20, the coating 16 can comprise further layers, too, which do not contribute to reflection, but optionally to stabilization and/or to protection of the coating 16 or of the optical element 8 or the mirror 10. By way of example, protection against components of a hydrogen plasma can be established by this means. Such further layers can be provided between the double layers 20 within the coating 16, between the double layers 20 and the carrier surface 14 and/or on the side of the double layers 20 that is remote from the carrier surface 14.

In the case of an optical element 8, the coating 16 can also be formed by the outer surface of the substrate 12 being modified by processing and/or treatment. In this case, the coating 16 is therefore not a separately applied coating, but rather defines a layer of the substrate 12 as such; the underlying surface as a transition to the substrate material 12a is then the carrier surface 14.

In the case of the mirror 10 explained here and the application of EUV light 18, the unreflected portion enters the substrate 12 and is absorbed there, specifically predominantly in the vicinity of the carrier surface 14. Owing to this absorption, the substrate 12 heats up primarily in the vicinity of the regions of the carrier surface 14 which are exposed to the EUV light 18. Since the coefficient of thermal expansion of the substrate material 12a is not equal to zero and in addition is itself temperature-dependent, the heating up can give rise to changes in shape of the substrate 12 which affect the optical properties of the mirror 10. In relation to optical elements 8, put generally, temperature changes in the substrate 12 can affect the optical properties of the optical element 8.

On account of the extremely tight specifications in EUV projection exposure apparatuses, however, changes in the optical properties of the mirrors therein are unacceptable or acceptable at most to a negligible extent. However, also on a general level again the optical properties are intended to remain stable in the case of optical elements 8 and the functionality is intended to be maintained in the case of components.

In order to minimize temperature fluctuations in the substrate material 12a and associated changes in shape of the substrate 12, a plurality of temperature-regulating hollow structures 22 are incorporated into the substrate 12.

During the operation of the EUV projection exposure apparatus, a temperature-regulating fluid in the form of a cooling fluid 24 is caused to flow through these temperature-regulating hollow structures 22, cooling water being used in practice; however, other cooling liquids and cooling media are also possible.

The cooling fluid 24 absorbs the quantity of heat input by the EUV light 18 and dissipates it from the substrate 12. For this purpose, the temperature-regulating hollow structures 22 are connected to a cooling unit 26 and a pump unit 28 of a cooling system, designated in its entirety by 30. The pump unit 28 sucks up the cooling fluid 24 from the temperature-regulating hollow structures 22 and guides it via a return line 32 to the cooling unit 26. There the cooling fluid 24 is cooled down to its target temperature before it flows through the temperature-regulating hollow structures 22 once again. This circuit is illustrated by corresponding arrows in figure 1.

The temperature-regulating hollow structures 22 typically run in the vicinity of the carrier surface 14 and at least regionally parallel thereto.

In the case of the exemplary embodiments described here, the temperature-regulating hollow structures 22 are formed as temperature-regulating channels 34, of which three temperature-regulating channels 34.1, 34.2 and 34.3 are illustrated. The temperature-regulating channels 34 each extend between two openings 36, which are designated only for the temperature-regulating channel 34.1 in figure 1, with each temperature-regulating channel 34 being connected via its openings 36 to the cooling unit 26 and to the pump unit 28. Consequently, depending on assignment, the openings 36 each define an inlet or an outlet of the temperature-regulating channels 34 for the cooling fluid 24. The cross-section of the temperature-regulating channels 34 need not be constant and can be e.g. circular, oval, rectangular or else ring-shaped. The temperature-regulating hollow structures 22 can have varying cross-sections and shapes depending on the position in the substrate 12. In the case of the present exemplary embodiments, the openings 36 of the temperature-regulating channels 34 are arranged on the underside or rear side 38 of the substrate 12, the opposite side to the carrier surface 14.

In the case of modifications not shown separately, the temperature-regulating hollow structures 22 can also be more extensive chambers in which the cooling fluid 24 is exchanged only slowly and in which no longitudinal axis is defined, as is characteristic of a channel.

Moreover, the arrangement of the temperature-regulating channels 34 illustrated in the figures is merely by way of example and can be different in real systems; the number of temperature-regulating channels 34 can also be larger or smaller. By way of example, the openings 36 can also be arranged at the lateral flanks of the substrate 12 or provision can be made of at least one temperature-regulating channel 34 which runs meanderingly or spirally through the substrate 12 or a part thereof.

In a further modification, it is also possible for one or more temperature-regulating channels 34 to extend proceed from a distribution section or a distribution chamber in the substrate 12; such temperature-regulating channels 34, with their openings 36, at one end or at both ends, then join such a distribution section or distribution chamber, from which the temperature-regulating channels 34 are then supplied with the temperature-regulating fluid. The distribution section or the distribution chamber and optionally that end of a temperature-regulating channel 34 which is remote therefrom are then correspondingly connected to the cooling system 30.

During the production of an optical element 8 by way of applying the method described here for producing temperature-regulating hollow structures 22, various stages of the substrate 12 are defined.

A first stage of the substrate 12 defines a kind of raw substrate 12', which is still largely unprocessed and untreated and in which a carrier surface 14 has not yet been formed structurally. In the case of the substrate 12 explained above, which is a mirror substrate, such a raw substrate is for example a glass parallelepiped composed of glass ceramic.

A second stage of the substrate 12 defines a carrier substrate 12", in which the carrier surface 14 is produced and formed. This may necessitate a plurality of chemical and/or physical work steps which may comprise processes such as grinding, turning, polishing and/or etching.

A third stage of the substrate 12 then defines an element substrate 12‴, in which the carrier surface 14 is provided at least with the coating 16 determining the optical properties. If the resulting optical element is a mirror, the element substrate 12‴ is thus terminologically a mirror substrate. Accordingly, the substrate 12 in figure 1 also bears the reference sign 12‴ since it is shown there in the stage of the element substrate. If the substrate 12 is for example part of a sensor device, as described in the introduction, the element substrate 12‴ is accordingly terminologically a sensor substrate.

The production of the temperature-regulating hollow structures 22 in the substrate 12 described below can take place, in principle, in any stage of the substrate 12. In general, this takes place in the stage of the raw substrate 12', but can also be carried out for example in the stage of the carrier substrate 12" or even in the stage of the element substrate 12‴.

In the present case, the production of the temperature-regulating hollow structures 22 is explained in particular on the basis of the example of the carrier substrate 12" in order to illustrate the function envisaged in the present exemplary embodiment for the mirror 10 obtained later.

2. Processing system

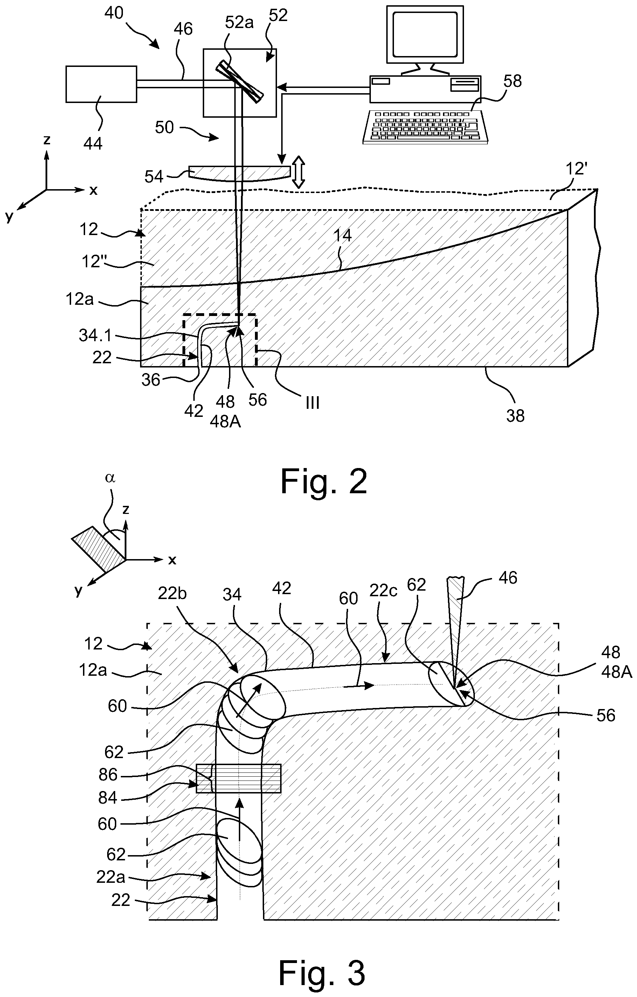

Figure 2 shows a processing system designated in its entirety by 40, which is used to incorporate the temperature-regulating hollow structures 22 into the substrate 12.

The substrate 12 is illustrated both as raw substrate 12' and as carrier substrate 12". In this case, the carrier substrate 12" is shown with the aid of solid contour lines. That part of the substrate material 12a of the raw substrate 12' which is removed in later processing steps is delimited by dashed contour lines, such that the solid and dashed contour lines taken as a whole illustrate the raw substrate 12'. Hereinafter, reference is made just generally to the substrate 12.

In general, the ablation of substrate material 12a is begun at the location of one of the openings 36. This is illustrated on the basis of the example of the temperature-regulating channel 34.1, of which a section of a temperature-regulating hollow structure 22 that has already been incorporated into the substrate 12, and here specifically a temperature-regulating channel section 42, is present, which extends into the substrate 12 proceeding from that opening 36 which forms the outlet to the pump unit 28 in the case of the configuration shown in figure 1. Hereinafter in all the exemplary embodiments reference is made to the temperature-regulating channel 34.1 as representative of the other temperature-regulating channels 34 and of generally any type and arrangement of temperature-regulating hollow structures 22.

The processing system 40 comprises a light source 44, which generates a processing light beam, which is a laser beam 46 in all the exemplary embodiments explained here. However, all explanations in respect thereof are analogously applicable, mutatis mutandis, to other suitable processing light beams. The light source 44 is thus preferably a powerful laser that generates ultrashort pulses. These can be pulses in the femto-, pico- or nanoseconds range. In this case, the processing system 40 realizes a laser ablation system such as is implemented in the present exemplary embodiments.

The substrate 12 intrinsically defines a reference coordinate system which is anchored in a rotationally fixed manner with the substrate 12, such that the coordinate system concomitantly moves with the substrate 12 in space, and defines the positive z-direction thereof upward, the positive x-direction thereof toward the right, and the positive y-direction thereof forward. The direction indications downward, toward the left and backward indicate the respectively opposite direction. A vertical in relation to the substrate 12 thus extends in the z-direction, and a horizontal in relation to the substrate 12 lies in an xy-plane.

The coordinate system is expediently assigned to the substrate 12 after it has been positioned in an initial position in the processing system 40. Taking this reference coordinate system into account, the processing system 40 is thus arranged above the substrate 12. That side of the temperature-regulating hollow structure 22 which is reached first by the laser beam 46 thus defines the top side of said structure and the direction upward. In the present case, the positive z-direction points in the direction from the rear side 38 of the substrate 12 to the carrier surface 14, which still needs to be formed in the case of the raw substrate 12'.

The laser beam 46 or the focus 48 thereof can be directed at various ablation locations 56 in the substrate 12 with the aid of a focusing device 50, which is shown schematically by a scanning device 52 comprising a mirror 52a and a focusing lens element 54. The focus 48 in each case represents a processing light pulse with this focus 48. Moreover, it is assumed schematically that the focus area $A_F$ of the focus 48 corresponds to the irradiated area. When mention is made hereinafter of the beam diameter of the laser beam 46, this is taken to mean the diameter of the focus 48 or of the focus area $A_F$.

The relative arrangement between the substrate 12 and the processing system 40 can alternatively or supplementarily be changed with the aid of a movement system (not illustrated), which is likewise assigned to the focusing device 50, in such a way that the laser beam 46 can be directed at any location of the substrate 12 after passing through the focusing lens element 54. In the case of small substrates 12, movement processes can be dispensed with, provided that the scanning device 52 covers a sufficiently large region.

The scanning device 52, the focusing lens element 54 and a movement system - optionally present - of the focusing device 50 are controlled by a control device 58 in such a way that the laser beam 46 is progressively focused on all ablation locations 56 of the substrate 12 at which temperature-regulating channels 34 are intended to arise.

At the respective focus 48, the intensity of the laser beam 46 is high enough that the substrate material 12a of the substrate 12 is ablated. Put generally, the laser beam 46 defines an ablation focus 48A, at which the laser beam 46 inputs energy with an energy density H, i.e. its fluence, into the substrate material 12a, which is high enough that the substrate material 12a is modified or ablated. In the case of the configuration described here, this ablation focus 48A is the focus 48.

In this case, the region in which the laser beam 46 ablates material outlines a respective ablation location 56, which by its nature moves concomitantly with the focus 48 of the laser beam 46. The foci 48 and thus the ablation location 56 determine where a temperature-regulating channel 34 arises in the substrate 12.

As can be discerned with reference to figure 3, a temperature-regulating hollow structure 22 is incorporated into the substrate 12 by the laser beam 46 being guided with the aid of the focusing device 54 in such a way that substrate material 12a is ablated layer by layer in the form of so-called slices 62 in the longitudinal direction 60 of the temperature-regulating hollow structure 22. Each slice 62 is defined by a respective layer of an ablation volume. Where the laser beam 46 ablates a slice 62, that is where the ablation front of the laser beam 46 is situated.

The longitudinal direction 60 of a temperature-regulating hollow structure 22 is not a rigid direction, but rather is defined in each case at a midpoint of a considered cross-section of the temperature-regulating hollow structure 22 taking account of the preceding and the succeeding course of the temperature-regulating hollow structure 22, which is indicated by a dotted line. The longitudinal direction 60 is shown by way of example at three points in figure 3. In a lower vertical region 22a of the temperature-regulating hollow structure 22, the longitudinal direction 60 is correspondingly identical to the z-direction, and in the arc region 22b there, the longitudinal direction 60 corresponds to a tangent to the arc described by the cross-section midpoints. In the right-hand region 22c in figure 3, extending with a horizontal direction component, the longitudinal direction 60 shown points slightly upward.

The slices 62 are tilted by a pitch angle $\alpha$ relative to the yz-plane. If, as is shown here by way of example, a temperature-regulating channel 34 with a circular cross-section can be produced, the contour of a slice 62 thus describes an ellipse. The pitch angle $\alpha$ is preferably 45°, but other pitch angles are also possible. In addition, the pitch angles $\alpha$ can differ from slice to slice.

In this way, it is possible that, by means of successive ablation of slices 62, the substrate material 12a can be ablated with a uniform cross-section in a vertical and/or horizontal direction. Figure 3 illustrates this on the basis of some slices 62 along the temperature-regulating channel section 42. Particularly in the arc section thereof, it is evident that successively adjacent slices 62 with direction components in x- and z-directions are offset with respect to one another, without resulting in a change in the cross-section of the temperature-regulating channel 34.

The ablation processing system 40 additionally comprises a rinsing device (not shown separately) used to apply a rinsing fluid to the ablation locations 56 while the substrate material 12a is being ablated. The ablated material is transported away from the ablation location 56 by the rinsing fluid. For this purpose, a rinsing line is inserted into the already formed temperature-regulating channel section 42, the delivery end of which is tracked to the ablation locations 56. In general, during the ablation of the substrate material 12a, the already formed temperature-regulating channel section 42 always has the rinsing fluid flowing through it and is thus filled.

As explained in the introduction, the substrate material 12a is modified or ablated at the ablation locations 56. A substrate material which is modified rather than directly ablated by the processing light beam 46 has, relative to the substrate material 12a, an increased susceptibility to a chemically active treatment medium. If such a modified substrate material arises, the method described here is supported in that during or after the performance of the scanning process, a chemically active treatment medium is guided to the modified substrate material and chemically removes the modified substrate material. In particular, the chemically active treatment medium is an etchant, such that the modified substrate material 12a is etched away. However, chemical active treatment media having an oxidative or reductive action can also be used.

The ablation processing system 40 comprises corresponding devices for this purpose, although these are not shown separately for the sake of clarity.

Hereinafter the invention is also explained further always on the basis of the example of the production of temperature-regulating hollow structure 22 in the form of temperature-regulating channels 34 with a circular cross-section. However, the cross-section of the temperature-regulating hollow structures 22 only depends on the outer contour of the slices 62. Adjacent slices 62 can also have different outer contours, which leads to cross-sections which change in the longitudinal direction 60.

3. Scanning patterns

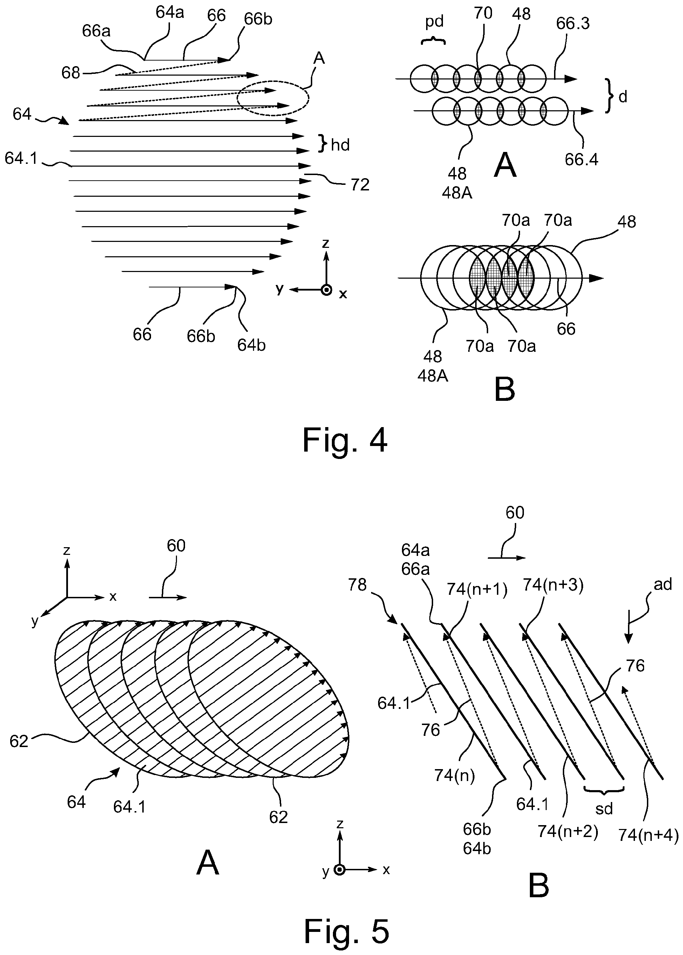

In order then to remove substrate material 12a as such a slice 62, the focus 48 of the laser beam 46 is moved through the substrate 12 following the predefinition of scanning patterns 64, which will firstly be explained generally with reference to figure 4.

Scanning patterns 64 are illustrated in two ways in the figures. Firstly, perspective views are shown which each correspond to the orientation of the slices 62 in the substrate 12, the elliptical contour of the slices 62 also being shown in each case. Secondly, there are projection views which correspond to a projection of the scanning pattern 64 into a yz-plane of the substrate 12 with a view in the negative x-direction and in which the scanning patterns 64 correspondingly describe a circular contour.

All of the scanning patterns 64 described below are described as scanning patterns as such which are scanned as such. However, all of the scanning patterns 64 described below can also describe only a part of a then superordinate scanning pattern and can correspondingly be scanned as part of the then superordinate scanning pattern.

3.1 Line-to-line scanning pattern

Figure 4 then shows a scanning pattern 64 in such a projection view, which is clarified once again by the shown coordinate system of the substrate 12.

A scanning pattern 64 defines a pattern scanning path by way of a number of so-called hatch lines 66 along which the focus 48 of the laser beam 46 is guided in a scanning direction from a beginning 66a to an end 66b of the respective hatch line 66. Each hatch line 66 is shown in the respective scanning direction as an arrow pointing from its beginning 66a to its end 66b.

Figures 4 and 5 show a line-to-line scanning pattern 64.1 as an example of a scanning pattern 64 according to a line-to-line concept, in which the hatch lines 66 have the same scanning direction.

Furthermore, each scanning pattern 64 defines for its part a starting point 64a and a pattern end point 64b for the scanning process for this scanning pattern 64. In this case, the starting point 64a coincides with the beginning 66a of that hatch line 66 of the scanning pattern 64 which is scanned first. The end point 64b of the scanning pattern 64 matches the end 66b of that hatch line 66 of the scanning pattern 64 which is scanned last.

Moreover, a scanning pattern 64 defines hatch jump paths 68 to be bridged between the end 66b of a first hatch line 66 and the beginning 66a of a second hatch line 66, which then define a jump end and respectively a jump beginning of the relevant hatch lines 66. In figure 4, only four of such hatch jump paths 68 are shown by dashed lines. A jump path is generally not traversed, but rather symbolizes that the focus 48 "jumps" from a jump end 66b to the associated jump beginning 66a. For this purpose, it is necessary to adjust the focusing device 50, in particular the mirrors 50a thereof, and optionally the relative position between substrate 12 and processing system 40, which takes up a certain time period, referred to in the present case as hatch jump time hat. Different hatch jump paths 68 can also lead to different hatch jump times.

In modifications, however, the focus 48 of the laser beam 46 can also be positioned on jump paths and be guided along jump paths.

The hatch lines 66 of a scanning pattern 64 need not be scanned in the adjacent sequence demonstrated by the scanning pattern 64 as implemented in the present exemplary embodiment. That is to say that within a scanning pattern 64 there can also be jumping such that a plurality of hatch lines 66 are situated between the first hatch line 66 with the jump end 66b and the second hatch line 66 with the associated jump beginning 66a.

The hatch lines 66 of a scanning pattern 64 preferably run parallel and the scanning pattern 64 then defines a hatch distance hd.

Figure 4A illustrates in the form of circles the pulses of the laser beam 46 with the foci 48 along the hatch lines 66.3 and 66.4 in a plan view from above the plane of the drawing. The distance between two adjacent pulses defines a pulse distance pd relative to the midpoint of the foci 48 on the hatch line 66. As is evident with reference to figure 4, along the hatch lines 66 between two adjacent foci 48 there is a pulse overlap region 70 of these two foci 48. In such overlap regions 70, the substrate 12 is thus reached by different pulses which are superimposed there. In this case, regions in the substrate 12 can also be reached by more than two pulses. In the case of an overlap region of 75% between two pulses, there is for example a superimposition of four pulses; this is shown supplementarily by figure 4B, in which such fourfold superimpositions are designated by 70a.

The hatch lines 66 of the scanning pattern 64 define a scanning area 72, which describes the area extent of the scan. In the present exemplary embodiments, the scanning area 72 is planar and the hatch lines 66 are rectilinear. In modifications that are not shown, the hatch lines 66 can also be curved or have at least curved sections. Depending on the formation and position of the hatch lines 66, a curved scanning area 72 can also arise for a scanning pattern 64. The result in this case is not disk-shaped slices 62, but rather ablation volumes with a correspondingly modified geometry, which however are likewise ablated layer by layer as slices 62. By way of example, the scanning area 72 can be curved in such a way that it follows the lateral surface of a circular cylinder. Resulting slices 62 then have a correspondingly curved geometry.

Figure 5 shows the scanning principle which involves scanning in the longitudinal direction 60 of the temperature-regulating hollow structure 22 in succession in scanning positions 74 spaced apart from one another in the substrate 12 using the laser beam 46 in accordance with the scanning pattern 64. Figure 5A is a perspective view of the scanning patterns 64. The outer contours discernible there are not part of the scanning patterns 64, but rather supplementarily illustrate corresponding slices 62, two of which bear a reference sign. Figure 5B is a side view.

The scanning positions 74 are spaced apart from one another in the longitudinal direction 60 of the temperature-regulating hollow structure 22 to be produced. The longitudinal direction 60 of the temperature-regulating hollow structure 22 to be produced thus predefines the advance direction of the focusing device 50 relative to the scanning positions 74. The scanning positions 74 are tilted by the pitch angle $\alpha$ relative to the yz-plane, such that the slices 62 are carved with this pitch angle $\alpha$.

Along a temperature-regulating hollow structure 22 to be produced there are a number of scanning positions 74(n) where n = 1 to i, wherein two scanning positions 74(n) and 74(n+1) are adjacent to one another. The number i depends on the length of the temperature-regulating hollow structure 22 and the distance between respective adjacent scanning positions 74(n) and 74(n+1).

The distance between two scanning positions 74(n) and 74(n+1) in each case defines a slice distance sd. The slice distance sd is generally in a range of between 0.5 $\mu$m and 1.5 $\mu$m. In practice, the slice distance sd is often 0.77 $\mu$m.

The slice distance sd is generally chosen such that the slices 62 overlap in the longitudinal direction 60, wherein the thickness of a slice 62 depends on the beam diameter. A slice 62 is defined in principle by the volume carved out of solid material and is thus of a theoretical nature if a slice 62 overlaps the region of a preceding slice 62 in which substrate material 12a is already no longer present.

In the present case, the direction in the z-axis of the substrate 12 in which a slice 62 is ablated by the scanning of the scanning pattern 64 in the substrate 12 is referred to as the ablation direction ad.

Figure 5 illustrates one example of a congruent process involving ablation of the slices 62 in two or more successive scanning positions 74(n) in the same ablation direction ad. In the case of the example shown here, this is the direction from the top downward, which is shown with the aid of an arrow ad in figure 5B. For this purpose, the starting points 64a of the scanning pattern 64 are situated at the top in all the scanning positions 74.

Figure 5B shows five scanning positions 74, designated by 74(n), 74(n+1), 74(n+2), 74(n+3) and 74(n+4). In the following figures, substantially all scanning positions uniformly bear the general reference sign 74 for the sake of clarity. Generally, two scanning positions 74(n) and 74(n+1) define two directly adjacent scanning positions.

Generally - and not just in relation to the exemplary embodiment shown here with the scanning pattern 64.1 - between a first scanning position 74(n) and a second scanning position 74(m) there are pattern jump paths 76 from a scanning pattern 64 of this first scanning position 74(n) to a scanning pattern 64 of this second scanning position 74(m).

In this case, a pattern jump path 76 proceeds from a jump end 66b of a hatch line 66 of the scanning pattern 64 of the first scanning position 74(n) to a jump beginning 66a of a hatch line 66 of the scanning pattern 64 of the second scanning position 74(m).

In the case of the exemplary embodiment shown here in figure 5B, it is the case for all of the pattern jump paths 76 that m = n+1, i.e. the two scanning positions 74 considered are adjacent scanning positions 74(n) and 74(n+1).

Optionally, m = n+2, n+3,... n+i can also apply, and these cases involve jumping over correspondingly multiple scanning positions 74. This will be discussed again further below.

If m > n, this means that the jump takes place in the direction of a succeeding scanning position 74 in the scanning process. As will become clear further below, it can also be the case that, depending on the magnitude of n, m = n-1, n-2, ..., 1. If m < n, this consequently means that the direction of the pattern jump path 76 points in the direction of a preceding scanning position 74 in the scanning process. This will be taken up again further below.

Moreover, in the case of the exemplary embodiment shown here in figure 5B, the jump end 66b of the hatch line 66 of the scanning pattern 64 of the first scanning position 74(n) coincides with the end point 64b thereof and the jump beginning 66a of the hatch line 66 of the scanning pattern 64 of the second scanning position 74(n+1) coincides with the starting point 64a thereof. If this is the case, therefore, each scanning pattern 64 of a scanning position 74 is scanned completely between its starting point 64a and its end point 64b and only then is there a jump to the next scanning position 74.

The time period required for adjusting the focusing device 50 and optionally the relative position between substrate 12 and processing system 40 for a jump between two scanning positions 74 is referred to in the present case as the pattern jump time pt, the designated abbreviation being derived here from this English term "pattern jump time". Different pattern jump paths 76 can also lead to different pattern jump times st.

Put generally, for the purpose of incorporating a temperature-regulating hollow structure 22 into the substrate 12, a scanning process is carried out in which the laser beam 46 is guided with the aid of the focusing device 50 in such a way that the ablation focus 48A is moved along a scanning trajectory 78 through the substrate 12. This is referred to in the present case as scanning of the scanning trajectory 78. This involves a relative movement, i.e. the laser beam 46 or the substrate 12a or both is/are moved and controlled.

Once again put generally, this scanning trajectory 78 comprises a plurality of scanning patterns 64 which are scanned in each case in the scanning positions 74. The scanning patterns 64 here each per se define a pattern scanning path by way of associated hatch lines 66 and hatch jump paths 68. The scanning trajectory 78 additionally comprises the pattern jump paths 76 between a scanning pattern 64 of a first scanning position 74(n) and a scanning pattern 64 of a second scanning position 74(m).

Figures 4 and 5 show a line-to-line scanning pattern 64.1 as an example of a scanning pattern 64 according to a line-to-line concept, in which the hatch lines 66 point in the same direction.

3.2 Meandering scanning pattern

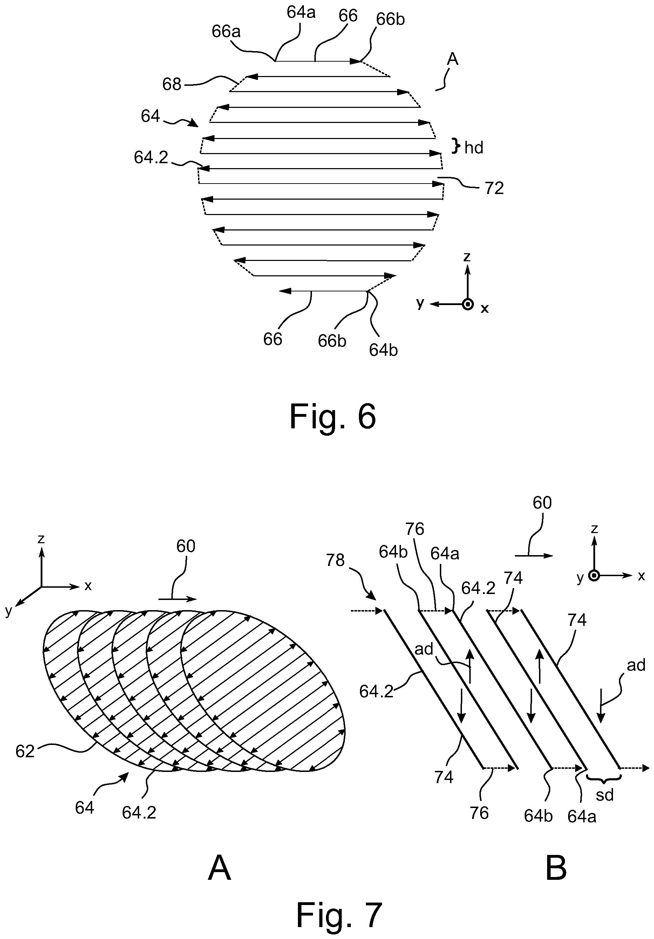

Figure 6 illustrates, in a projection view, a meandering scanning pattern 64.2 as an example of a scanning pattern 64 according to a meandering concept, in which adjacent hatch lines 66 have opposite scanning directions. Therein the hatch jump paths 68 are considerably shorter than in the case of the line-to-line concept, since the end 66b of a first hatch line 66 and the beginning of a second hatch line 66 are spatially closer to one another. This also results in each case in shorter hatch jump times ht, since the mechanical adjustment of the relevant components of the focusing device 50 proves to be smaller.

In the following figures, the hatch jump paths are not always shown in the illustration of scanning patterns 64.

The application of a meandering scanning pattern in comparison with the application of a complementary line-to-line scanning pattern leads to a time saving of approximately 250 sec for example during the formation of a temperature-regulating channel 34 with a constant diameter of 2 mm over a length of 10 mm.

The application of a meandering scanning pattern 64.2 can take place in the manner as shown in figure 5B, such that starting points 64a of all the meandering scanning patterns 64.2 are situated at the top and the ablation of all the slices 62 takes place from the top downward.

A further time gain is possible if the scanning positions 74 are also scanned with the aim of a meandering process. This involves scanning the scanning patterns 64 in two scanning positions 74(n) and 74(n+1) in such a way that the ablation direction ad is in opposite directions in these two scanning positions 74(n) and 74(n+1). On the basis of the example of the meandering scanning patterns 64.2, figure 7B shows that always in alternation an upper end point 64b of a meandering scanning pattern 64.2 is defined next to an upper starting point 64a of an adjacent meandering scanning pattern 64.2 and the then lower end point 64b thereof is defined next to a lower starting point 64a of a next adjacent meandering scanning pattern 64.2, or vice versa. Figure 7A shows the sequence of the meandering scanning patterns 64.2 once again in a perspective view of the scanning patterns.

In this way, the slices 62 are ablated with alternating ablation directions ad alternately from the top downward and from the bottom upward.

A corresponding meandering process is also possible with line-to-line scanning patterns 64.1.

By way of example, during the formation of a temperature-regulating channel 34 with a constant diameter of 2 mm over a length of 10 mm, in relation to the change in the pattern jump paths 76 a time gain of 3 sec is achieved in comparison with the process according to figure 5.

4. Rotation process

The temperature-regulating hollow structures 22 each define an internal lateral surface 80, the structural formation of which depends on the completed scanning trajectory 78, inter alia.

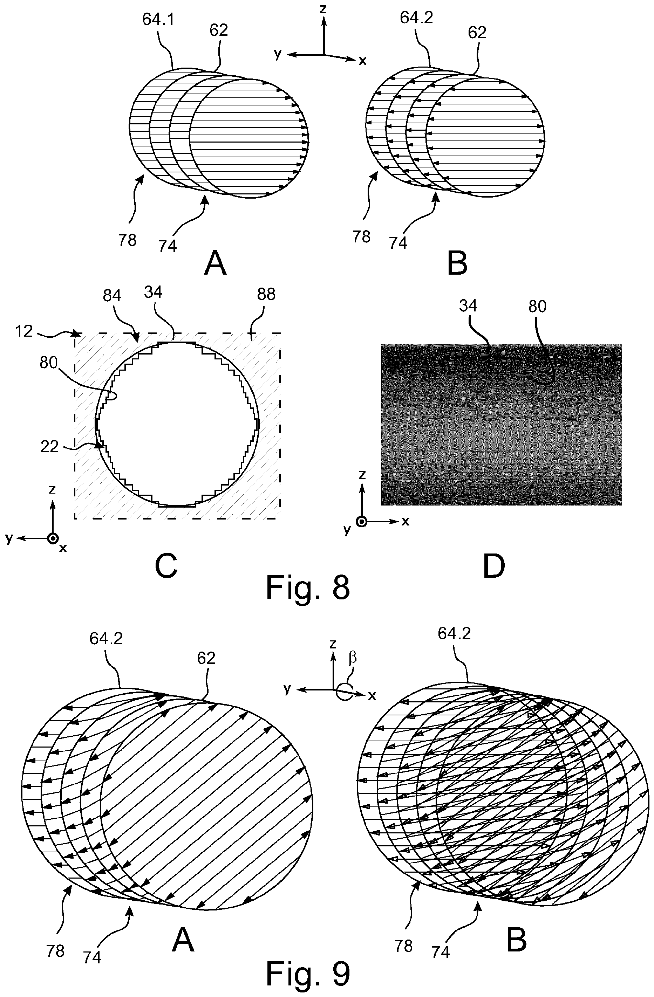

Figure 8 shows a scanning process with a scanning trajectory 78 in which the scanning positions 74 in the substrate 12 are each scanned with the same scanning pattern 64, which also have the same orientation. This is illustrated by figures 8A and 8B with in each case four scanning positions 74, which are scanned with the scanning patterns 64.1 and 64.2, respectively. Here, too, the outer contours once again each illustrate a slice 62.

The identical orientation results in the formation of a structured internal lateral surface 80 of the temperature-regulating hollow structure, which is stepped in the circumferential direction, which is illustrated schematically on the basis of a stepped structure 82 in figure 8C. This is independent of which of the processes explained above, the congruent process or the meandering process, is implemented.

In this case, figure 8C shows a projection of a plurality of cross-sections 84 - following one behind another - of a section 86 of the temperature-regulating channel 34 in the longitudinal direction 60 into an image plane 88, which here corresponds to the plane of the drawing. The section 86 with the cross-sections 84 projected here by way of example is identified in figure 3 and is situated in the vertical region of the temperature-regulating channel 34, which is why the longitudinal direction 60 here corresponds to the z-direction. The circle on the stepped structure 82 in figure 8C illustrates the theoretical ideal course of the internal lateral surface 80.

Figure 8D shows a micrograph of the internal lateral surface 80 of a temperature-regulating channel 34 obtained in this way in a substrate 12, in which the substrate material 12a is a titanium-doped quartz glass.

As is evident from both figures 8C, 8D, the stepped structure 82 is not uniform in the circumferential direction; rather, different regions with different stepped geometries arise.

Such stepped structures 82 can promote the effects resulting from FIVs ("flow induced vibrations") explained in the introduction, which is why it is desirable to obtain the internal lateral surface 80 of a temperature-regulating hollow structure 22 in a more regular form by comparison.

This can be achieved by implementing a rotation process in which the scanning patterns 64 are scanned in two successive scanning positions 74(n) and 74(n+1) in a manner rotated relative to one another by a rotation angle $\beta$ in the circumferential direction. Such a rotation process is illustrated by figure 9 on the basis of the example of the meandering scanning pattern 64.2, wherein by way of example $\beta = 10°$. Figure 9A here shows the slices 62, the ablation direction ad of which, not shown separately, correspondingly rotates concomitantly. Figure 9B reveals the rotated scanning patterns 64.2 in a see-through view.

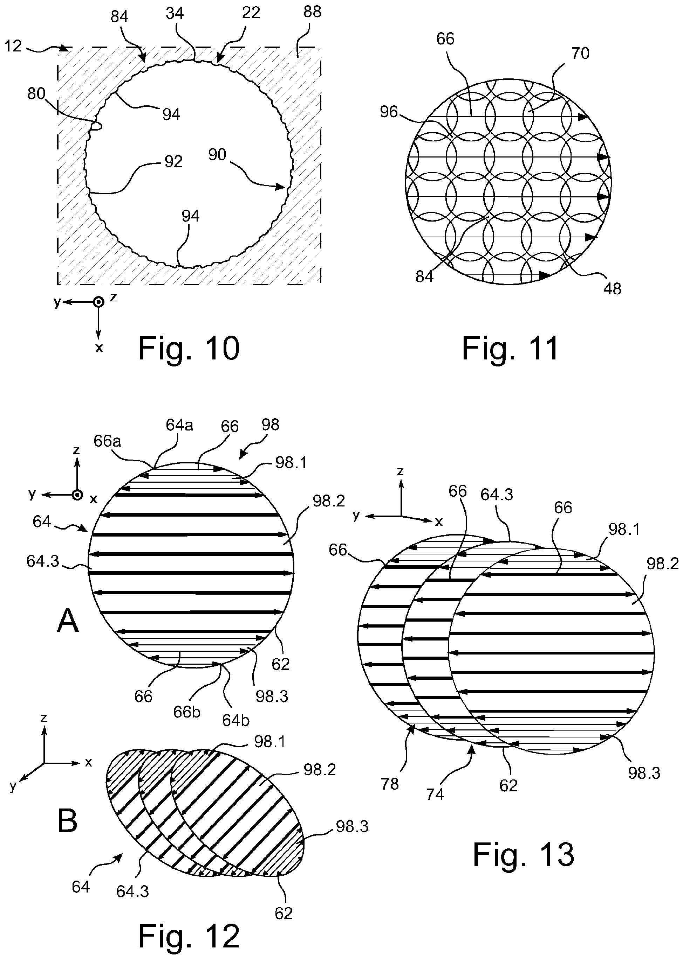

With application of the rotation process, the internal lateral surface 80 of the temperature-regulating hollow structure 22 is formed by a periodic structure 90, which is demonstrated by figure 10 again in a projection of a plurality of cross-sections 84 into the image plane 88, as was explained with regard to figure 8C.

This periodic structure 90 of the internal lateral surface 80 of the temperature-regulating hollow structures 22 is formed in such a way that, upon such a projection of successive cross-sections 84 of a section 86 of a temperature-regulating hollow structure 22 into an image plane 88, said periodic structure defines a contour line 92 of the internal lateral surface 80 which has a periodic course of recurring structural elements 94 with a radial shaping in the circumferential direction. In this case, there can be different kinds of structural elements 94, which however each occur periodically in the circumferential direction and optionally can also be superimposed.

Radial shaping should be understood as the extent in the direction of the longitudinal axis of the temperature-regulating hollow structure.

In the longitudinal direction 60, the periodic structure 90 defines a helicity or a helical structure if the rotation of successive scanning patterns 64 is accompanied by the succession of spaced-apart scanning positions 74, which leads to an advance in the scanning direction, i.e. in the longitudinal direction 60.

5. Increase in ablation efficiency

It is desirable to minimize the process time required for incorporating the temperature-regulating hollow structures 22 into the substrate 12. This can be achieved by various approaches.

5.1 Rotation process

Firstly, the rotation process described above additionally has an effect on the intensity distribution of the laser beam 46 and can lead to an increase in the ablation efficiency.

Figure 11 schematically shows the overlap of the pulses of the laser beam 46 with foci 48 in the manner as shown in figure 4A, wherein here the hatch distance hd and the pulse distance pd are chosen such that the pulses on a hatch line 66 and with the pulses of the adjacent hatch lines 66 exhibit a small pulse overlap 70. It is evident that between the pulses there are then regions 96 at which no pulse overlap occurs. As a result, the intensity distribution between the scanning positions 74 is inhomogeneous since such regions 96 arise in a manner covering one another in the case of successive scanning positions 74 in the longitudinal direction 60.

If the slice distance sd is then chosen to be too large, it can happen that no material is ablated in the regions 96. This can result in undesired incoupling effects or defect formation in the scanning process.

By comparison, the rotation process leads to a more homogeneous intensity distribution between the scanning positions 74 in the direction of the longitudinal axis 60 since the regions 96 with lower intensity occur in a manner offset with respect to one another from scanning position 74 to scanning position 74. The risk of defects is reduced as a result.

5.2 Variation of the pulse energy $E_p$

5.2.1 Increase in the pulse energy $E_P$ in conjunction with increase in the energy density H

In the case of the methods explained hitherto, in a scanning pattern 64 all the hatch lines 66 have the same hatch distance hd and the energy is input at the ablation location 56 with the same energy density H relative to the focus area $A_F$, i.e. with the same pulse energy $E_P$/focus area $A_F$, wherein the pulse energy $E_P$ in joules [J] is the average power of the light source 44 of the laser beam in watts [W] divided by the repetition rate of the pulses per second [$s^{-1}$]. The pulse power P results from the quotient of pulse energy $E_P$ and pulse duration $t_P$ as $P = E_P/ t_P$.

In the case of the scanning patterns 64 used here, the hatch distance hd between all the hatch lines 66 is the same.

Figure 12A shows a sector scanning pattern 64.3 in a projection view, in which in contrast thereto the hatch lines 66 run in sectors 98, each of which is assigned a specific hatch distance hd, which differs from the hatch distance hd of at least one adjacent sector 98.

The sector scanning pattern 64.3 shown here takes up by way of example the meandering concept and has three successive sectors 98.1, 98.2 and 98.3, wherein the sectors 98.1 and 98.3 are assigned the same hatch distance hd and the sector 98.2 located therebetween is assigned a hatch distance hd greater by a factor of 3. This can also be understood in such a way that proceeding from a scanning pattern 64 with only identical hatch distances hd in the sector 98.2 only every third hatch line 66 is present and is scanned.

Such a sector scanning pattern 64.3 can be scanned without changing the parameters of the laser beam 46.

The sector scanning pattern 64.3 can be scanned effectively, however, if, during the scanning process, the sector 98.2 is then scanned with a pulse energy $E_P$ of the laser beam 46 which is greater than the pulse energy EP of the laser beam 46 during the scanning of the sectors 98.1, 98.3 with a smaller hatch distance hd. As a result, in the sector 98.2 the energy density H is increased at the focus 48. This is clarified by the thicker hatch lines 66 in the case of the sector scanning pattern 64.3.

In this way, in the central region of the temperature-regulating hollow structure 22, during the scanning of the sector 98.2 more energy per light pulse is radiated into the volume of the substrate 12 at the focus 48 and the substrate material 12a there is damaged to a greater extent than during the scanning of the sectors 98.1 and 98.3. This substrate material 12a damaged to a greater extent is ablated with subsequently overlapping slices 62 and no damage to the substrate 12 occurs.

During the scanning process, the sector scanning pattern 64.3 can be scanned without change in successive scanning positions 74, which is demonstrated once again by figure 12B. In a modification shown in figure 13, here in a projection view again, the sector 98.2 in the case of two scanning patterns 64 scanned in successive scanning positions 74 is arranged offset and begins with different hatch lines 66, such that the hatch lines 66 in the two scanning positions 74 are scanned offset in a direction transversely with respect to the scanning direction of the hatch lines 66. In this way, the intensity distribution in the longitudinal direction 60 is homogenized and the possibility of formation of micro-grooves at the ablation front is reduced.

In addition, optionally the pulse distance pd and/or the slice distance sd can also be increased if the beam diameter is correspondingly enlarged.

Preferably, the parameters for the sector 98.2 are adapted in such a way that the hatch distance hd, the pulse energy $E_P$ and also - taking account of the beam diameter - the pulse distance pd and the slice distance sd are increased by the same factor, relative to the parameters of the preceding sector 98.1. However, it is also possible to depart from this.

Since the energy density H at the focus 48 decreases again, however, if the beam diameter becomes larger in conjunction with constant pulse energy $E_P$, it is necessary to coordinate beam diameter and pulse energy $E_P$ in such a way as to establish the desired increase in the energy density H.

5.2.2 Increase in the pulse energy Ep in conjunction with constant energy density H

Another approach consists in increasing the pulse energy $E_P$ but ensuring that the energy density H of the laser beam 46 remains constant at the ablation location 56.

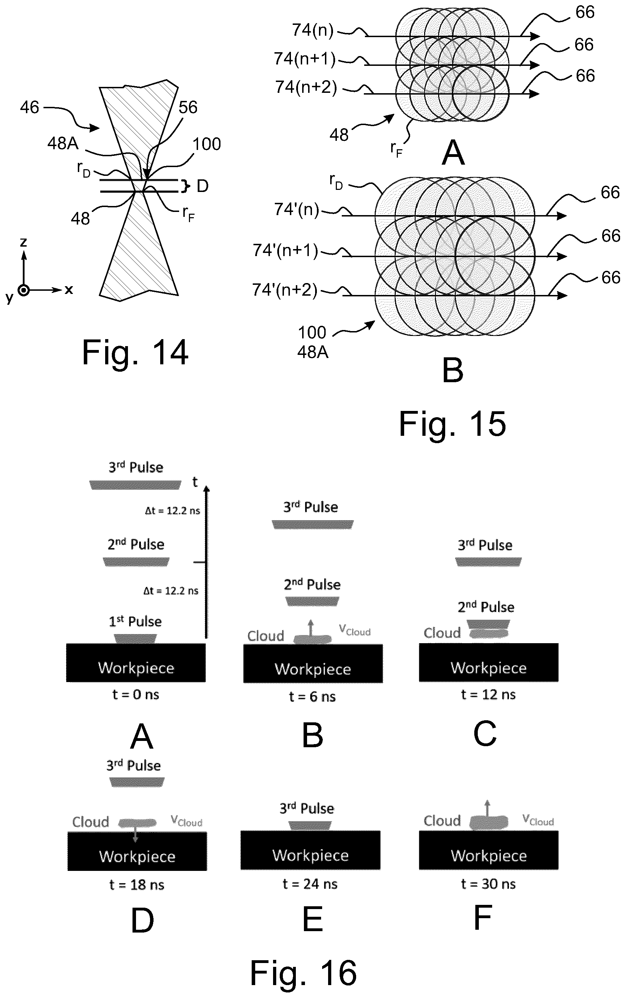

The ablation focus 48A of the laser beam 46 is enlarged in this case. The pulse energy $E_P$ is set in such a way that the intensity of the laser beam 46 that is required for ablation of the substrate material 12a is attained in a defocus plane 100 in which the laser beam 46 has a larger beam diameter than the focus 48. This is illustrated by figure 14, which shows the laser beam 46 in a greatly simplified manner as a typical Gaussian beam along the z-direction. The defocus plane 100 is situated at a defocus distance D above the focus 48; there the laser beam 46 defines a defocus radius $r_D$. The focus 48 of the laser beam 46 is situated in the beam waist below the defocus plane 100, i.e. where the laser beam 46 has the smallest diameter. At the focus 48, the laser beam 46 defines a focus radius $r_F$.

The ablation focus 48A is now defined in the defocus plane 100, however.

Clearly, if the pulse energy $E_P$ is doubled, the irradiated area must likewise be doubled, which is the case for the defocus plane 100 shown, in which the radius r has increased by the factor $\sqrt{2}$ relative to the radius at the focus 48. If the pulse energy $E_P$ is increased in the sense of being multiplied by a factor x, the defocus plane 100 is defined where the laser beam 46 has a radius r greater by the factor $\sqrt{x}$ than at the focus 48.

During the scanning process, this defocus plane 100 is then guided along the scanning trajectory 78. In order to coordinate the scanning process with the increased pulse energy $E_P$, it is necessary to adapt the process parameters of pulse distance pd and hatch distance hd for the scanning pattern(s) 64 used and also the slice distance sd between the scanning positions 74. Here as well it is necessary to increase the values in each case by the factor $\sqrt{x}$. The scanning process is thus adapted in all three spatial directions.

Figure 15 illustrates this on the basis of the example of three scanning positions 74(n), 74(n+1), 74(n+2), wherein figure 15A, for a predefined pulse energy $E_P(1)$, shows the pulses of the laser beam 46 with the foci 48 along respective hatch lines 66 in a side view in the case of the vertical section 86 of the temperature-regulating channel 34 in accordance with figure 3. The pulse overlap along a hatch line 66, here without a reference sign, is 75%, as was explained with regard to figure 4B. The pulse overlap between two adjacent scanning positions 74 is 50%, i.e. there are therefore regions in the substrate 12 which are reached by pulses of two adjacent scanning positions 74(n) and 74(n+1).

Figure 15B shows three scanning positions 74.1', 74.2', 74.3' with a doubled pulse energy $E_P(2) = 2 \times E_P(1)$ with the defocus planes 100. It is evident that the parameters mentioned above are adapted proportionally.

This means as a result that more volume is ablated from the substrate material 12a in the same time.

As a result of the displacement of the ablation focus 48A, the focus 48 at the beam waist is situated below the ablation location 56, which is supplementarily designated in the defocus plane 100 in figure 14.

The laser parameters are then coordinated to the effect that, on the one hand, the substrate material 12a above the temperature-regulating hollow structure 22 is not modified and, on the other hand, it is possible to compensate for fluctuations in the scanning process as a result of the defocus distance D between the defocus plane 100 and the focus 48.

The threshold values for the rear-side ablation and modifications of the substrate material 12a in the existing volume depend on the properties of the substrate material 12a and the pulse duration $t_P$ and can be defined for a specific pulse duration $t_P$ with the aid of the energy density H, i.e. the fluence,

$$H = \frac{2 \cdot E_P}{\pi \cdot w^2}$$

wherein here the peak fluence is described, with the pulse energy $E_P$ and the beam radius w at the corresponding axial position, in the present case in the z-direction.

If the threshold energy density/fluence $H_A$ for the ablation is then reached in an axial direction, on the one hand a part of the radially outer beam profile of the laser beam passes without obstruction and on the other hand, in the case where particles are transported away with the assistance of fluid, a certain portion of the pulse energy after the ablation, as a result of partial adaptation of the refractive index through the fluid, passes into the non-modified substrate material 12a below the temperature-regulating hollow structure 22 and is still focused.

5.2.3 Tuning of the peak pulse power PS

With regard to the operating parameters of the laser beam 46, it has additionally been recognized that in the case of any change in the pulse energy $E_P$, it may be of significant importance for the peak pulse power Ps of the laser beam 46 to be below the pulse power $P_L$ of the self-focusing threshold of the laser beam 46.

The self-focusing threshold describes the state in which a diffraction-governed defocusing of the laser beam 46 and the focusing are in equilibrium as a result of the nonlinear optical Kerr effect. For a laser with - as considered here - a transverse Gaussian intensity profile, this limit for the peak power $P_L$ is dependent only on the wavelength $\lambda_0$ of the laser used in a vacuum, the linear refractive index no and the nonlinear refractive index $n_2$ and results as

$$P_L = \frac{3.79 \cdot \lambda_0^2}{8\pi \cdot n_0 \cdot n_2}$$

In the case of laser beams 46 with other intensity factors, prefactors with values other than 3.79 determine the self-focusing threshold.

The peak pulse power $P_S$ results from the pulse energy P, i.e. the quotient of pulse energy $E_P$ and pulse duration $t_P$, and a profile-dependent factor B as

$$P_S = B \cdot \frac{E_P}{t_P}$$

In the case of a laser beam 46 with a Gaussian profile, B is approximately 0.94.

If the peak pulse power Ps exceeds the self-focusing threshold, i.e. if Ps > $P_L$, the laser beam 46 contracts to below the diffraction limit as a result of the optical Kerr effect, which leads to an extreme intensity boost. This gives rise to a dense plasma which defocuses the laser beam 46. As a result of the optical Kerr effect, however, the beam is focused again after a short propagation distance. By virtue of these two competitive effects, an equilibrium between focusing and defocusing arises below the channel, which ultimately results in a filament 108. Depending on the parameters of the laser pulse and the material properties of the substrate material 12a, such a filament 108 can extend over a plurality of millimeters to centimeters and cause micro-explosions, whereby the enclosed substrate material 12a at the margin of the filament 108 is additionally densified and considerable strain fields are thus produced.

The temperature-regulating hollow structures 22 can therefore be produced in a manner particularly free of strain distinctly below the self-focusing limit if Ps < < $P_L$, i.e. if the peak pulse power Ps is considerably less than the pulse power $P_L$ of the self-focusing threshold.

During the scanning process, in the course of the scanning of the scanning trajectory 78, besides the ablation particles, which are then removed by the rinsing fluid, gas bubbles also arise in the fluid and cause the following laser pulses to be scattered.

Assuming that approximately 50% of the pulse energy $E_P$ - with the temporal and spatial pulse shape being maintained - after ablation can effectively incouple into the substrate material 12a below the temperature-regulating hollow structure 22, the maximum energy density/fluence H of the laser beam at the focus 48 must not be greater than the threshold fluence - designated by Hv in the present case - for damage in the volume of the substrate material 12a.

By way of example, if the pulse duration $t_P$ is reduced in conjunction with constant pulse energy $E_P$, then the laser beam 46 is focused to a greater extent below the ablation location 56 in the substrate material 12a as a result of the Kerr effect and in conjunction with a corresponding pulse duration $t_P$ exceeds the threshold fluence Hv even below the critical power $P_L$. The threshold fluence Hv can likewise be exceeded as a result of an increase in the pulse energy $E_P$.

The material-dependent and laser pulse-dependent difference between $H_A$, i.e. the threshold fluence for the ablation of the substrate material 12a, and Hv, i.e. the threshold fluence for volume damage to the substrate material 12a, is of significant importance for avoiding damage in the substrate material 12a present below the temperature-regulating hollow structure 22 to be formed.

At any rate in the optimum case the distance between the ablation location 56 and the focus 48 should not be greater than the Rayleigh length $z_R$, since otherwise the resulting influence H can exceed the value of $H_v$ as a result of the Kerr effect.

Changing the slice distance sd enables tuning in respect of the magnitude of the portion of the pulse energy $E_P$ which is guided to the ablation of the substrate material 12a, and in respect of ensuring that the transverse portion of the beam profile which can penetrate into the underlying substrate material 12a is not too large.

The use of highly absorbent liquids as rinsing fluid makes it possible to increase the absorption in the temperature-regulating hollow structure 22.

5.2.4 Burst mode laser

In the case of a pulsed laser beam 46 in the form of a laser, pulse rates in the kHz range and optionally in the low MHz range can typically be attained.

A laser with a pulse rate of 400 kHz emits a single pulse with specific pulse energy EP at the interval of 2.5 μs. With lasers which operate in a so-called burst mode, however, this pulse energy EP can also be introduced in each case by individual pulses in a fast pulse train with a temporal distance in the double-digit ns range. Such a fast pulse sequence is referred to as a burst.

If a burst impinges on a material, here the substrate material 12a, the first burst pulse interacts with the material like a single pulse. However, the following burst pulses encounter different boundary conditions; for example, the second pulse in the burst impinges on a cloud of ablation products, with which it then interacts. This can also give rise to material redepositions, such that as a result less material is ablated with a 2-pulse burst than with a single pulse with the pulse energy EP, even though double the energy was introduced. By contrast, a third burst pulse impinges on highly excited substrate material 12a and ablates a very large amount of material.

This is illustrated by figure 16 on the basis of an exemplary temporal profile in the case of a 3-pulse burst with three pulses with the temporal distance of 12.2 ns. At B, material is liberated by the first pulse at A, wherein at C the second pulse gives rise to a material redeposition shown at D. At E, the third pulse is then incident and ablates a large amount of material, which is present as a material cloud at F.

If the ablation direction ad downward is chosen during the formation of the temperature-regulating hollow structures 22, the ablation products propagate with the direction of the laser beam 46. Therefore, in contrast to figure 16, following pulses in the burst are not shielded by the ablation products, but rather act if appropriate as shielding of the substrate material 12a at the bottom against burst pulses yet to follow.

The number of pulses in a burst need not then be odd, although typically the odd pulses provide for material ablation and the even pulses provide for material deposition.

Depending on the desired processing depth in the substrate 12 and the available laser energy, the ideal number of pulses in the burst can vary between 2 and 8 or be even greater. As things stand, however, the maximum number dictated by systems engineering is eight burst pulses.

The pulse energy of the individual pulses in a burst can preferably be set with the aid of the control device 52. Various approaches can be pursued here.

Firstly, the pulse energies $E_P$ of all the burst pulses can be identical.

However, it is also possible to go through ascending pulse ramps, such as

  a pulse train with an ascending energy ramp, for example with pulse no. 1 with $E_PO$, pulse no. 2 with $2E_PO$, pulse no. 3 with $3E_PO$, ...etc.;
  or

  a pulse train with a descending energy ramp, for example with pulse no. 1 with $E_PO$, pulse no. 2 with $1/2E_PO$, pulse no. 3 with $1/3E_PO$, ...etc.;

Alternating variants and combinations of the abovementioned energy ramps are also conceivable, for example pulse no. 1 with $E_PO$, pulse no. 2 with $2E_PO$, pulse no. 3 with $E_PO$, ... or for example pulse no. 1 with $E_PO$, pulse no. ½it $1/2E_PO$, pulse no. 3 with $2E_PO$, pulse no. 4 with $1/3E_PO$, ...

5.2.5 Shock waves - 3D structure scanning principle

During the ablation of the substrate material 12a by means of the laser beam 46, high pressures and temperatures above the melting point of the substrate material 12a occur at the focus 48 at the ablation locations 56. Individual superficial material layers tear off at the ablation front, which is accompanied by a shock wave propagating in all spatial directions.

These shock waves can be used to induce breaking and/or cracking of substrate material 12a in the immediate vicinity of the focus 48 and the shock wave arising there as a result of the thermodynamic stress that arises, such that a quasi-mechanical ablation of the substrate material 12a takes place in addition to the light-induced ablation.

This substrate material 12a ablated quasi-mechanically in this way was not irradiated, which leads to a saving of energy and time.

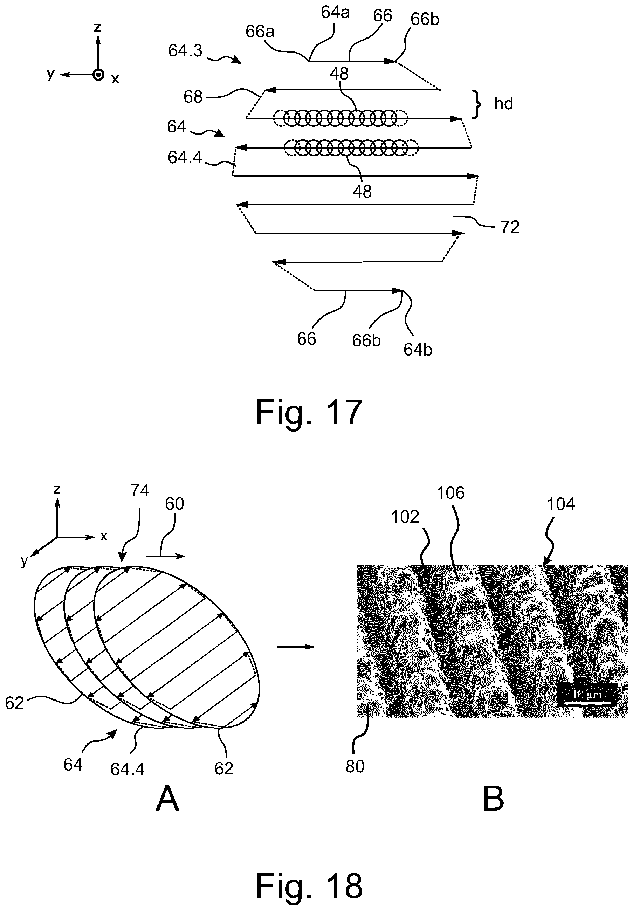

Figure 17 shows a projection view of a groove scanning pattern 64.4 suitable for this, in which pattern by definition the hatch distance hd is greater than the beam diameter at the focus 48. By way of example, the groove scanning pattern 64.4 is additionally a meandering scanning pattern 64.3.

Figure 18A shows the scanning principle, generally illustrating a 3D structure scanning principle, with the sequence of such groove scanning patterns 64.4 in successive scanning positions 74, by way of which grooves 102 are incorporated into the substrate material 12a at the ablation front. This gives rise to a rib structure 104 composed of parallel ribs 106 approximately of the kind as shown as representative with the aid of a photograph shown in figure 18A. As is indicated there, the distance between the ribs 106 is approximately 5 $\mu$m, for example, which would simultaneously reflect the beam diameter at the focus 48.

In a modification, the groove scanning pattern 64.4 is scanned twice in the same scanning position 74, wherein the groove scanning pattern 64.4 during the second scan is scanned in a manner rotated relative to the groove scanning pattern 64.4 of the first scan, such that the hatch lines 66 of the two groove scanning patterns 64.4 cross one another in the relevant scanning position 74. Preferably, the rotation angle is 90°.

As can be understood, a column structure with a multiplicity of individual columns arranged in a column matrix can arise in this way.

As a result of the process dynamics explained, cracks arise in the ribs 106 or columns under the influence of the shock waves, which subsequently leads to substrate material 12a chipping off, which is then rinsed away by the rinsing fluid.

6. Avoiding damage in the marginal region

It has been found in practice that damage can occur in that substrate material 12a which bounds the temperature-regulating hollow structure 22 as encasing material. Damage occurs here on the side of the temperature-regulating hollow structure 14 which is remote from the light source 44 of the laser beam 46, taking account of the reference coordinate system in the lower encasing material of the temperature-regulating hollow structure 22.

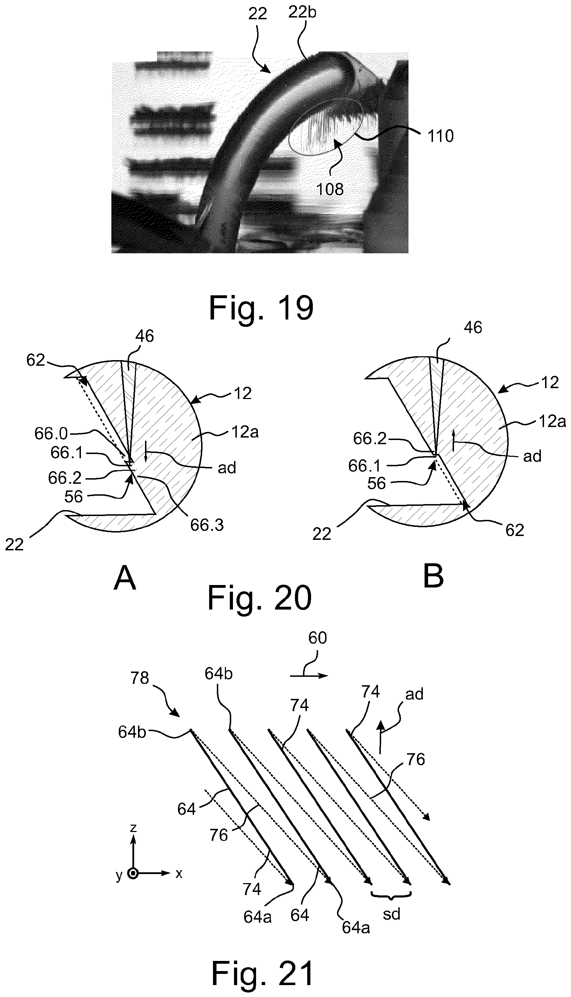

Particularly in an arc region as illustrated at 22b in figure 3, i.e. upon a transition from a vertical section 22a of a temperature-regulating hollow structure 22 to a horizontal section 22c of a temperature-regulating hollow structure 22, the formation of filaments 108 can occur. This is illustrated by figure 19 with the aid of a photograph of a corresponding arc section 22b of a temperature-regulating hollow structure 22, wherein the filaments 108 are discernible in particular in a region 110.

Such filaments 108 constitute just one example of damage in the substrate material 12a. Such damage can adversely influence the long-term stability of the figure of the carrier substrate 12" and it is desirable to minimize corresponding damage.

It has been found that formation of such filaments 108 occurs to a significant extent if slices 62 are ablated with an ablation direction ad from the top downward.

As things stand, this may be based on the fact that the ablation along a first hatch line 66.1 shades the ablation locations 56 of the succeeding hatch line 66.2 of a scanning pattern 64, which is shown schematically in figure 20A. The laser beam 46 emerges from the substrate material 12a situated on top, bridges a material-free region of the previously ablated hatch line 66.0 and then impinges on the substrate material 12 of the active hatch line 66.1.

At the present time, it is assumed that in the center of the slice 62 these shaded regions are presumably concomitantly detached during the processing of the then following hatch line 66.3, which may be due, inter alia, to the shock waves explained above. Therefore, undesired effects do not occur in these regions of the slices 62.

However, if the focus 48 is situated at the lower margin of the slice 62 and thus at the lower encasing surface of the temperature-regulating hollow structure 22, no such ablation takes place there. In the case of the then following slice 62 in the next scanning position 74, which slice begins at the bottom in the meandering process, the effective slice distance ad is doubled, whereby a very large amount of energy of the laser beam 46 is radiated into the substrate material 12a present there as solid material. This in turn leads to the damage, for reasons explained above.

6.1 Uniform ablation direction ad upward

Such filaments 108 or comparable damage into the lower encasing material of a temperature-regulating hollow structure 22 can be avoided if the ablation direction ad is chosen to be from the bottom upward for each slice 62 during the scanning of the scanning patterns 64 in the scanning positions 74.

As illustrated by figure 20B, there is then no comparable shading.

In this respect, a congruent process with a uniform ablation direction ad in the scanning positions 74 belonging to the process is carried out here, as was explained above with regard to figure 5B. The uniform ablation direction ad here however is correspondingly oppositely from the bottom upward, which is shown once again in figure 21 and is discernible there also with the aid of the starting points 64a and end points 64b in the case of the first two adjacent scanning patterns 64.

6.2 Intermediate slices

Formation of filaments 108 or comparable damage in the encasing material of the temperature-regulating hollow structures 22 can also be reduced or avoided by a scanning position 74(n) being followed by a scanning position 74(n+1) that defines an intermediate scanning position 112. In such an intermediate scanning position 112, an intermediate slice 114 is ablated as slice by virtue of an intermediate scanning pattern 116 being scanned there as scanning pattern. In the case of an intermediate scanning pattern 116, all functionally corresponding structural components bear the same reference signs as in the case of the scanning patterns 64 and the explanations for the scanning patterns 64 in this respect analogously apply, mutatis mutandis, to the intermediate scanning patterns 116.

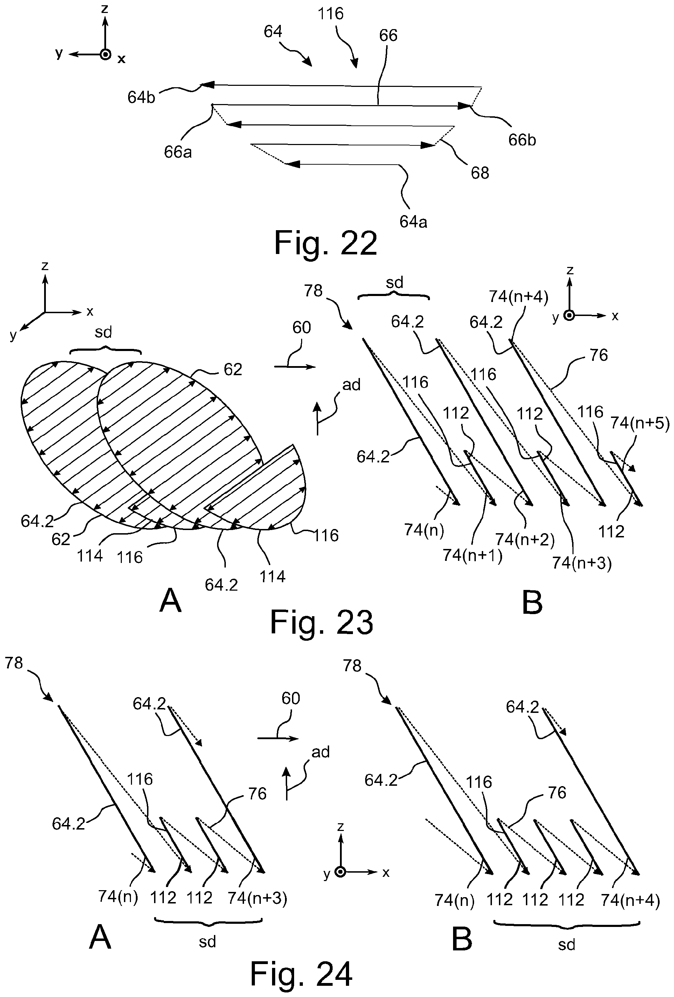

Figure 22 shows the projection view of one example of such an intermediate scanning pattern 116 with its hatch lines 66 and hatch jump paths 68.

Figures 23A and 23B show the scanning principle again in a perspective view and in a side view, respectively, wherein by way of example the meandering scanning pattern 64.2 in accordance with figure 6 is applied in the scanning positions 74.

Six scanning positions 74(n), 74(n+1), 74(n+2), 74(n+3), 74(n+4) and 74(n+5) are shown, every second scanning position 74(n+1), 74(n+3) and 74(n+5) of which respectively defines an intermediate scanning position 112.

An intermediate scanning pattern 116 in an intermediate scanning position 112 is defined in relation to that scanning pattern 64 which is scanned in the preceding scanning position 74. In this case, the hatch lines 66 of the intermediate scanning pattern 116 in the intermediate scanning position 112 cover a smaller area than the hatch lines 66 of the scanning pattern 64 which was scanned previously in a preceding scanning position 74 which is not an intermediate scanning position 112.

This is shown in the projection view, in which an intermediate scanning pattern 116 has at least in one direction y or z a smaller extent than a scanning pattern 64 in a preceding scanning position 74 which is not an intermediate scanning position 112. To put it another way, in the case of the exemplary embodiments shown here, the intermediate scanning patterns 116 are oriented in such a way that said direction is the z-direction.

As a result, an intermediate slice 114 ablated in an intermediate scanning position 112 has only a partial extent in comparison with a slice 62 ablated in a scanning position 74 with a scanning pattern 64.

Figure 23 shows the case where the preceding scanning position 74(n) is the directly preceding scanning position 74 relative to the scanning position 74(n+1) with the intermediate scanning pattern 116. As will become clear further below with reference to figures 24A and B, this need not always be the case, however.

In the exemplary embodiment shown here, the intermediate scanning positions 112 are tilted relative to the yz-plane by the same pitch angle $\alpha$ as the scanning positions 74 with scanning patterns 64. In modifications which are not shown, however, the intermediate scanning positions 112 can also be pitched at angles $\alpha'$ which differ from the pitch angle $\alpha$. Moreover, pitch angles $\alpha$ or $\alpha'$ of different intermediate scanning positions 112 can be different.

An intermediate scanning position 112 can be located centrally between two adjacent scanning positions 74 in the longitudinal direction 60, as is shown by way of example in figure 23B. However, an intermediate scanning position 112 can also be offset in the direction of the preceding scanning position 74 or in the direction of the succeeding scanning position 74.

If scanning positions 74 are provided as intermediate scanning positions 112, the scanning trajectory 78 thus also comprises the trajectory sections in the form of the intermediate scanning patterns 116, which are respectively scanned in the intermediate scanning positions 112, with their hatch lines 66 and hatch jump paths 68.

In different intermediate scanning positions 112, it is also possible to apply differently designed intermediate scanning patterns 116 with different hatch lines 66. Figure 23A shows an exemplary embodiment in which the hatch lines 66 of an intermediate scanning pattern 116 are congruent with hatch lines 66 of the scanning pattern 64 in the preceding scanning position 74. Modifications that are not shown can depart from that, however, that is to say that the hatch lines 66 of the intermediate scanning pattern 116 can be offset upward or downward, for example.

In principle, an intermediate scanning pattern 116 is intended to be formed in such a way that the deepest point of the temperature-regulating hollow structure 22 is covered in a section of the temperature-regulating hollow structure 22 which also extends in a horizontal direction. If the temperature-regulating hollow structure 22 is intended to have for example a rectangular cross-section there, rather than a curved cross-section, this is then at least the lower base surface of the temperature-regulating hollow structure 22.

In the case of the examples shown here, however, the intermediate scanning pattern 116 covers a lower segment of the cut surface of the temperature-regulating hollow structure 22 in the intermediate scanning position 112, i.e. specifically here a segment of an ellipse. As a result, the risk of damage can be reduced again.

It is also possible for two and more intermediate scanning positions 112 to be adjacent, i.e. to be present one behind another in a plurality of adjacent scanning positions 74(n), 74(n+1).

This is shown by figures 24A and 24B on the basis of the example of scanning trajectories 78 with two and three intermediate scanning trajectories 112, respectively. For the sake of clarity, only the first and last scanning trajectories 74 in each case are designated by 74(n) and 74(n+3) and respectively 74(n) and 74(n+4). The intermediate scanning positions 112 in figure 24A are the scanning positions 74(n+1) and 74(n+2), and the intermediate scanning positions 112 in figure 24B are correspondingly the scanning positions 74(n+1), 74(n+2) and 74(n+3).

6.2.1 Multiple jumping between scanning plane and intermediate scanning plane

In the case of the exemplary embodiments explained hitherto, each scanning pattern 64 of a scanning position 74(n), that is to say in other words also each intermediate scanning pattern 116 in an intermediate scanning position 112, is completely scanned between its starting point 64a and its end point 64b and only then is there a jump to the next scanning position 74(n+1). This means that between two adjacent scanning positions 74 or between one scanning position 74 and the following scanning intermediate position 112 or between two scanning intermediate positions 112 or between one scanning intermediate position 112 and the following scanning position 74, a jump is effected only a single time.

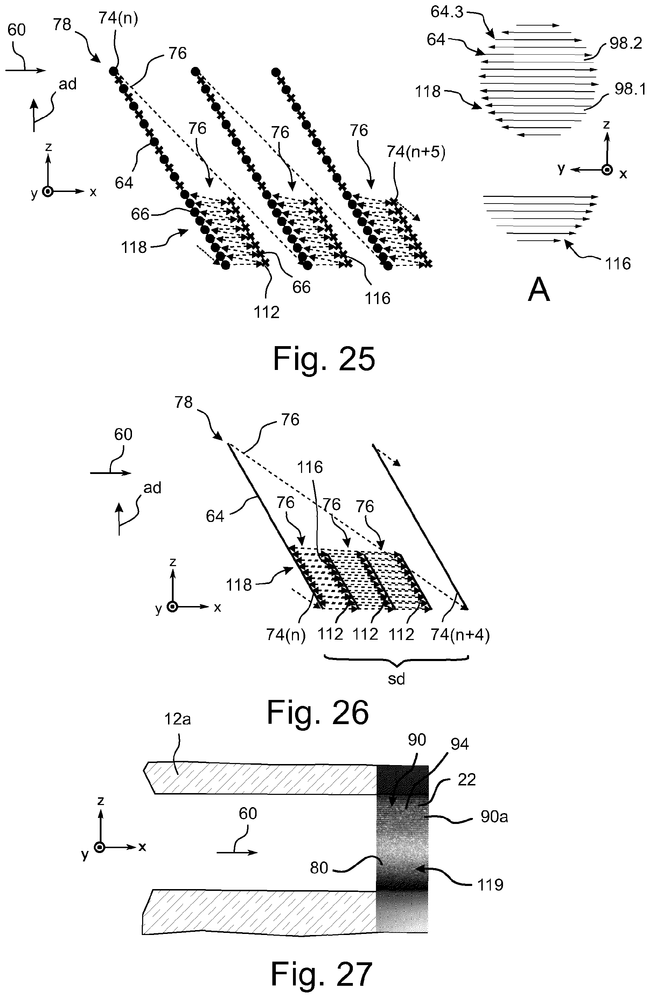

Figure 25 illustrates a scanning concept in which, in contrast thereto, there is multiple jumping between one scanning position 74 and the succeeding intermediate scanning position 112. The scanning direction of the hatch lines 66, relative to the zx-plane, is represented by dots when it points out of the plane of the drawing, and by crosses when it points into the plane of the drawing. The sequence of the scanning positions 74 with the intermediate scanning positions 112 corresponds here to figure 23B.

As is evident in figure 25, an alternation section 118 of a scanning pattern 64 is linked with an intermediate scanning pattern 116 by a multiplicity of pattern jump paths 76.

As was explained above, a pattern jump path 76 always proceeds from a jump end 66b of a hatch line 66 of the scanning pattern 64 of the first scanning position 74(n) to a jump beginning 66a of a hatch line 66 of the scanning pattern 64 of the second scanning position 74(m).

In the case of the pattern jump paths 76 from the intermediate scanning pattern 116 to the scanning pattern 64, the first scanning position 74(n) is thus the intermediate scanning position 112 and the second scanning position 74(m) is the preceding scanning position 74(n-1) with the scanning pattern 64 and it thus holds true that m = n-1, i.e. m < n.

In this case, each end 66b of each hatch line 66 of the intermediate scanning pattern 116 is the beginning of a pattern jump path 76.

In the case of the present exemplary embodiment, from the bottom upward, the hatch lines 66 of a scanning pattern 64 of a scanning position 74(n) are scanned in alternation with the hatch lines 66 of the intermediate scanning pattern 116 in the adjacent intermediate scanning position 112.

The meandering concept is followed here, which has the consequence that the hatch lines 66 of the scanning pattern 64 in the alternation section point in one direction, here the positive y-direction, whereas the hatch lines 66 of the intermediate scanning pattern 116 point in the opposite direction, here the negative y-direction. Figure 25A shows this supplementarily in the case of the scanning pattern 64 and the intermediate scanning pattern 116 in a projection view. Other sequences are possible, however.

This scanning pattern 64 is moreover a representative example of a variant of a sector scanning pattern 64.3 having sectors 98 in which the sequence of the scanning directions of the hatch lines 66 is different. Here these are sectors 98.1 and 98.2. In this case, there can also be two sectors 98 in which the hatch lines 66 are each scanned parallel to one another, but with opposite scanning directions in the sectors. Two meandering sequences can be present, too, which however start with different scanning directions. In addition, in the case of sector scanning patterns 64.3, overlaps of regions with different scanning directions and of regions with different hatch distances hd can occur.

Furthermore, this scanning pattern 64 is an example of the variant mentioned in the introduction where a scanning pattern 64 can also describe just a part of a then superordinate scanning pattern. In the present case, the sector 98.1 corresponds to a line-to-line scanning pattern 64.1 and the sector 98.2 corresponds to a meandering scanning pattern 64.2, which together form the then superordinate sector scanning pattern 64.3.

Such a sector scanning pattern 98 can be used in particular even without a change in the pulse energy Ep.

This alternation concept can also be implemented in extended fashion if two and more intermediate scanning positions 112 are adjacent, as is shown in figures 24A and B and once again in figure 26 on the basis of the example of three adjacent intermediate scanning positions 112.

There, scanning patterns 64 are scanned in the scanning positions 74(n) and 74(n+4) and intermediate scanning patterns 116 are scanned in the scanning positions 74(n+1), 74(n+2) and 74(n+3). The scanning trajectory 78 comprises a jump sequence from the bottom upward from the scanning position 74(n) to the scanning position 74(n+1) to the scanning position 74(n+2) to the scanning position 74(n+3) and back again to the scanning position 74(n). If the alternation region 118 of the scanning pattern 64 has been scanned through, the intermediate scanning patterns 116 have also been scanned and the remaining part of the scanning pattern 64 is scanned and then there is again a jump downward to the full scanning pattern 64 in the scanning position 74(n+4).

In this case, therefore, the abovementioned jump takes place from a scanning position 74(n) to a scanning position 74(m) where m = n+2, n+3,... n+i, wherein here consequently m = n+4.

Here, too, each end 66b of each hatch line 66 of the intermediate scanning patterns 116 in the individual intermediate scanning positions 112 is the beginning of a respective pattern jump path 76.

The total ablation volume which is ablated by the scanning of the scanning pattern 64 and of the plurality of intermediate scanning patterns 116 linked therewith results from the volumes of the individual slices 62 which are defined by the ablation volume in each of the scanning positions 74. The slices 62 here are just no longer produced by a scanning process continuously over the entire scanning pattern 64/116, but rather arise progressively from alternation to alternation between the scanning positions 74.

Figure 27 shows a micrograph of a section of the internal lateral surface 80 of a temperature-regulating hollow structure 22 obtained in this way in a substrate 12. As is discernible and labeled, the internal lateral surface 80, in a region, here the upper region, in which ablation was effected only by scanning of the scanning patterns 64, is formed by a periodic structure 90 in the form of a rib structure 90a, which extends in the longitudinal direction 60 and is shaped in the radial direction. The ribs thereof are a formation of recurrent structural elements 94, with no projection into an image plane taking place here.

In the circumferential direction these structural elements 94 are at a distance of the order of magnitude of 0.5 to 1.5 times the distance between two adjacent hatch lines 66 and can be at a distance from one another of in particular between 10 $\mu$m and 30 $\mu$m, with preference between 15 $\mu$m and 25 $\mu$m and preferably approximately 20 $\mu$m. The radial shaping can be present with a ratio of 1:100 to 1:7 relative to the average diameter at a cross-section of the temperature-regulating hollow structure 22.

In an opposite region, here the lower region, in which the intermediate scanning patterns 116 were also scanned, the internal lateral surface 80 is formed by a structure 119 which is different therefrom and which has a significantly more uniform area with less shaping in the radial direction than the rib structure 90a. In particular, there are no ribs shaped in this way in the structure 119.

Such a surface structure or an at least similar surface structure having a rib structure 90a and a structure 91 which is different therefrom can also arise upon the application of intermediate scanning planes 112 in accordance with figures 23 and 24.

6.3 Contour scanning patterns

In the case of all the scanning patterns 64 described above, the respective ablation location 56 at the beginning 66a and at the end 66b of a hatch line 66 during scanning of the scanning pattern 64 is situated in the substrate 12 where the internal lateral surface 80 of the temperature-regulating hollow structure 22 arises or remains.

As a result of acceleration and retardation effects in the setting of the movable components of the focusing device 50, in particular the mirror 52 of the scanning device 52, local increases there in the incidence of the laser beam 46 can occur. At the beginnings 66a and ends 66b of the hatch lines 66, an accumulation of pulses of the laser beam 46 then takes place, as a result of which more energy is input there. This introduces local additional heating and heat accumulation effects into the substrate material 12a, which can in turn lead to undesired damage to the substrate material 12.

This risk is reduced by scanning patterns being designed as contour scanning patterns 120 which define a contour region 122 and a core region 124, wherein the contour region 122 at least sectionally radially surrounds the core region 124.

In this case, hatch lines 66 are scanned as core region 124 of the contour scanning pattern 120, wherein in the contour region 122 one or more hatch lines 66 are scanned in the form of contour hatch lines 126 which supplement the hatch lines 66 in the core region 124 and have a course along the contour of the contour scanning pattern 120. As a result, such a contour hatch line 126 in the contour region 122 thus runs at least sectionally along the contour of the temperature-regulating hollow structure 22 to be produced.

The hatch lines 66 in the core region 124 can again correspond to a scanning pattern 64 in the variants described above.

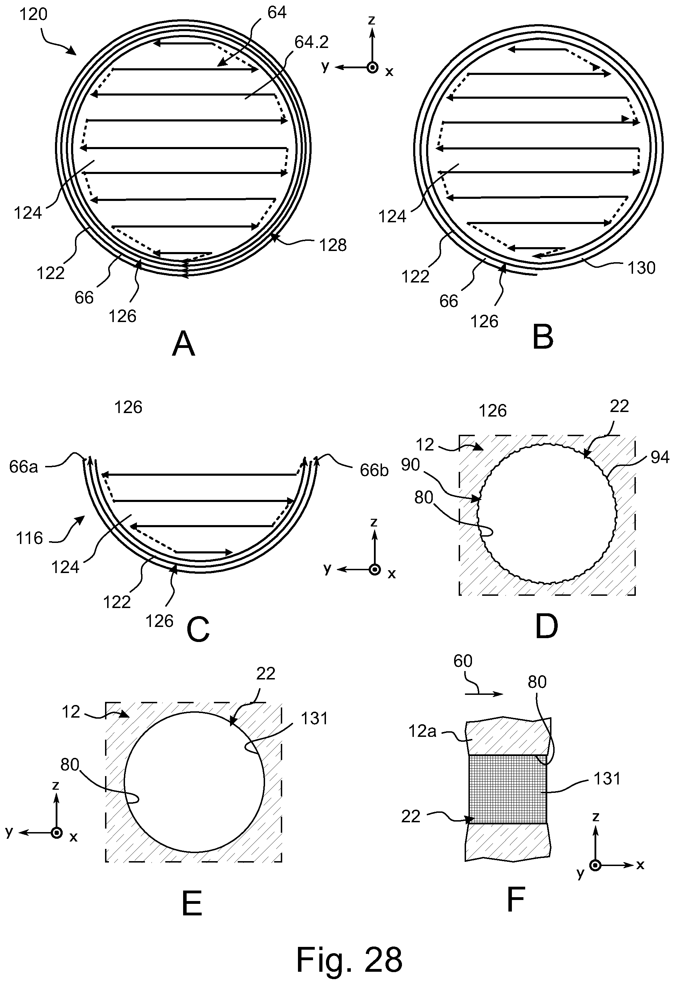

This is illustrated by figures 28A and 28B on the basis of two exemplary embodiments of a contour scanning pattern 120 in projection view, in which a meandering scanning pattern 64.2 is in each case intended to be scanned in the core region 124 and in which the respective contour region 122 is provided radially right at the outside.

In the case of the exemplary embodiment in accordance with figure 28A, a plurality of circular hatch lines 128 in the form of spaced-apart rings are arranged as contour hatch lines 126 in the contour region 122. In the case of the exemplary embodiment shown here, there are four circular hatch lines 128, but the number thereof can vary downward and upward. Circular means that these hatch lines 128 are intrinsically closed. In the case of the exemplary embodiment shown here, the circular hatch lines 128 are circle-shaped. There is a departure from this, however, if the scanning pattern is intended to produce cross-sectional areas other than circle areas at the ablation front.

In the case of the exemplary embodiment in accordance with figure 28B, there is arranged in the contour region 122 a spiral hatch line 130, the beginning 66a of which lies radially on the outside and the end 66b of which lies radially on the inside.

In both figures, the hatch jump path 68 between the last circular hatch line 128 of the contour region 122 in the scanning process and respectively the spiral hatch line 130 and the first hatch line 66 of the core region 124 is in each case provided with a reference sign.

During the scanning process, a contour scanning pattern 120 is scanned from radially on the outside to radially on the inside in such a way that first the contour region 122 and then the core region 124 are scanned.

If a contour scanning pattern 120 is scanned, the ablation direction ad for the slice 62 ablated in this way is defined by the scanning pattern 64 in the core region 124.

In this way, firstly as it were a circumferential groove is incorporated into the substrate material 12a, as a result of which in the substrate material 12a there is no longer a thermally conductive material connection between the ablation locations 56 at the hatch lines 66 of the scanning pattern 64 in the core region 124 and the encasing internal surface 80 of the temperature-regulating hollow structure 22.

The heat that arises during scanning of the core region 124 of the contour scanning pattern 120 then propagates in the longitudinal direction 60 into the substrate material 12a. However, since this substrate material 12a is ablated in a following scanning position 74, this has no adverse effects on the temperature-regulating hollow structure 22.

This concept of a contour scanning pattern 120 can also be implemented in the case of intermediate scanning patterns 116, wherein the contour region 122 can be provided for example only along the lateral surface 80 of the temperature-regulating hollow structure 22 and meandering contour hatch lines 126 are then preferably provided. This is shown by figure 28C. Although thermal effects again occur there at the beginning 66a and end 66b of the contour hatch line 126 situated right at the outside, this may be negligible.

By means of the contour scanning patterns 120, a periodic structure 90 can likewise be formed on the internal lateral surface 80 of the temperature-regulating hollow structure 22, as is illustrated by figure 28D in a manner not true to scale. Figure 28D, in contrast to figure 10, shows a section through the temperature-regulating hollow structure 22 and not a projection of a plurality of cross-sections into a plane.

What can additionally be achieved in particular by the use of contour scanning patterns 120 is that the internal lateral surface 8 of the temperature-regulating hollow structure 22 is formed at least regionally by a roughness structure 131 having a mean roughness Ra in accordance with DIN EN ISO 25178, version as at 06/2023, of between 10.0 $\mu$m and 5.0 $\mu$m, which in particular is between 10.0 $\mu$m and 6.5 $\mu$m, between 10.0 $\mu$m and 8.0 $\mu$m, between 8.5 $\mu$m and 5.0 $\mu$m, between 7.0 $\mu$m and 5.0 $\mu$m or between 8.5 $\mu$m and 6.5 $\mu$m, or having a mean roughness Ra of 5.0 $\mu$m and less, which in particular is between 5.0 $\mu$m and 0.1 $\mu$m, preferably between 4.5 $\mu$m and 0.125 $\mu$m, between 4.0 $\mu$m and 0.15 $\mu$m, between 3.5 $\mu$m and 0.175 $\mu$m or between 3.0 $\mu$m and 0.2 $\mu$m.

Such a roughness structure 131 is distinguished by the fact that it defines, in the sense of the mean roughness Ra, a continuously smooth surface region of the internal lateral surface 80. In particular, no structures with radial shapings of orders of magnitude which exceed the mean roughness Ra there are present there.

An internal lateral surface 80 of the temperature-regulating hollow structure 22 can result in which the roughness structure 131 extends out along the full circumference in the circumferential direction at least in a section in the longitudinal direction 60 of the temperature-regulating hollow structure 22.

This is illustrated by a solid circular line in figure 28E, and by a section in the longitudinal direction 60 of the temperature-regulating hollow structure 22 with a fine 90° cross-hatching in figure 28F.

In order that such a roughness structure 131 arises, for example the parameters of the processing beam 46 can be adapted, in particular with regard to the diameter at the ablation focus 48 if the contour hatch line 130 is scanned. Alternatively or supplementarily, for example, a contour scanning pattern 120 can also be scanned two or more times in one and the same scanning position 74, wherein two successive contour scanning patterns 120 are rotated relative to one another, such that their ablation foci 48A overlap at the internal lateral surface 80.

6.3.1 Extended 3D structure scanning principle

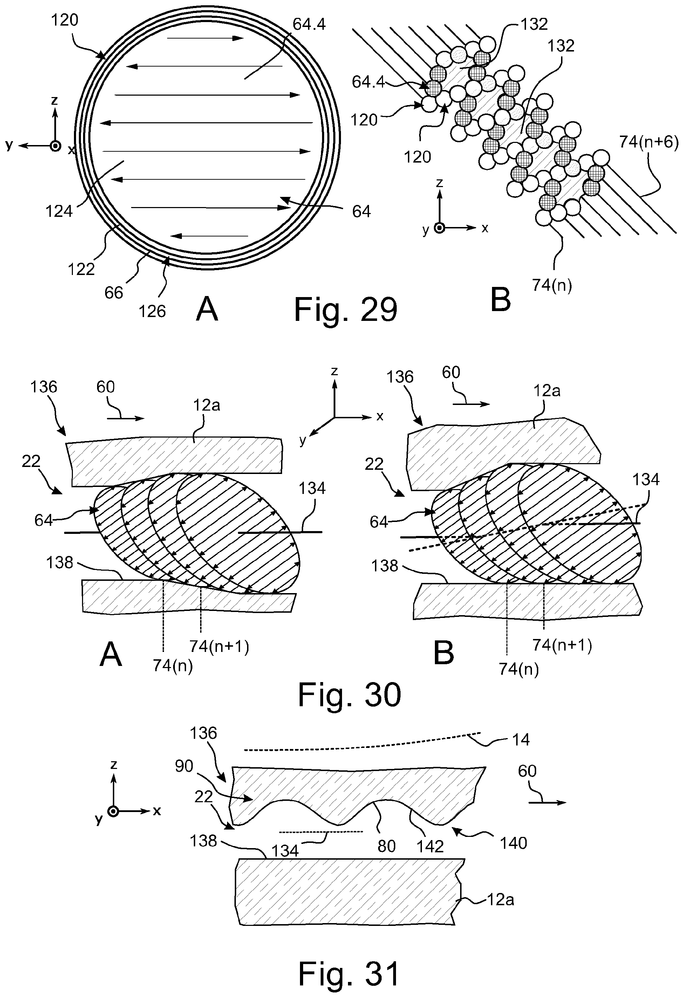

As was explained above regarding the use of shock waves and the groove scanning pattern 64.4, in the case of relatively large hatch distances hd between the hatch lines 66 material structures of the substrate material 12a may remain at the ablation location 56. As an alternative to rotating the same scanning pattern 64.4 to and fro in successive scanning positions 74, a 3D structure scanning principle can be implemented, in which scanning patterns are displaced relative to one another in scanning positions. This is shown by figure 29 with application of a contour scanning pattern 120.

In this case, figure 29A shows a projection view of a contour scanning pattern 120 in which a groove scanning pattern 64.4 with relatively large hatch distances hd is provided for the core region 124.

Figure 29B shows seven scanning positions 74, only the first and last of which are correspondingly designated by 74(n) and 74(n+6), respectively, and the pulses of the laser beam 46 with the foci 48 are again represented by circles.

The scanning pattern 120 is scanned once in the scanning position 74(n). The scanning pattern 120 is scanned twice in each case in the following two scanning positions 74(n+1) and 74(n+2). In figure 29B, a first scan in a scanning position 74 is represented by white circles and a second scan in this scanning position 74 is represented by hatched circles. Their sequence in the y-direction is merely dictated by the drawing. A respectively single scanning pattern or a respectively first scanning pattern in a scanning position 74 serves as a reference scanning pattern for the position of the first scanning pattern of a following scanning position 74(n+1).

In the second scanning position 74(n+1), for the first scan the groove scanning pattern 64.4 in the core region 124 is displaced relative to the contour region 122 in such a way that the hatch lines 66 are offset in the z-direction relative to the reference scanning pattern 64.4 in the scanning position 74(n), wherein the foci 48 are arranged so as still to overlap in the z-direction on two adjacent hatch lines 66 of the scan in the scanning position 74 and of the first scan in the scanning position 74(n+1). For the second scan in the scanning position 74(n+1), the groove scanning pattern 64.4 is displaced upward even further in the scanning position until the foci 48 are situated beside the foci 48 of the first scan in the scanning position 74(n+1). During the second scan, only the scanning pattern 64.4 can be scanned without a contour hatch line 126. Therefore, the reference signs 120 for the pattern of the first scan and 64.4 for the pattern of the second scan are assigned in scanning position (74(n+1).

This scheme is repeated in the then following scanning position 74(n+2). In the further scanning position 74(n+3), again a single contour scanning pattern 120 is scanned with an offset relative to the reference scanning pattern 64.4, etc.

As a result, lateral webs 132 composed of substrate material 12a arise or remain in this way, which webs run in the y-direction and have a rhombic cross-sectional contour.

The principle explained here by way of example can be modified by adjusting the framework parameters. By way of example, it is possible to change the slice distance sd and the displacement distance of the scanning patterns 64 in a common scanning position 74(n), which may lead for example to a different pitch angle of the cross-sectional rhombus of the webs formed here. Other cross-sectional geometries are possible; optionally, for this purpose, more than two or different scanning patterns are also scanned in the scanning positions in which a plurality of scanning patterns are scanned.

7. Change in the cross-sections of the temperature-regulating hollow structure

As was explained in the introduction, it may be expedient, if appropriate, for the temperature-regulating hollow structures 22 also to be formed with cross-sections that are different than circular cross-sections and are not constant in the longitudinal direction 60. This can be achieved during the scanning process by virtue of the fact that in two successive scanning positions 74 different scanning patterns 64, 116, 120 are scanned, the scanning area 72 of which differ in size and/or geometry.

This can help for example - in the context of cooling the optical element 8 - to increase the cooling capacity, which increases as the cross-sectional area of the flowing cooling fluid increases.

A first approach involves changing the scanning area 72 symmetrically with respect to the longitudinal central axis 134 of the temperature-regulating hollow structure 22 in the longitudinal direction 60. This approach can be carried out without difficulties in the case of a vertical section.

In figure 30, by contrast, 136 denotes a section of the temperature-regulating hollow structure 22 with a direction component in the x-direction, which section defines in the longitudinal direction 60 a respectively deepest marginal line 138 on the z-axis, and is shown for an enlargement of the cross-section.

In the course of a progressive enlargement of the cross-section symmetrically with respect to the longitudinal central axis in such sections 136, the ablated slice 62 in a scanning position 74(n+1) is always larger than the slice 62 in the preceding scanning position 74(n). If intermediate slices 114 are ablated, these have in relation to the longitudinal central axis 138 at least regionally a larger radial extent than the preceding slice 62 or intermediate slice 114.

If the scanning area 72 and thus the slice 62 at the deepest marginal line 138 of the temperature-regulating hollow structure 22 is at a deeper level than in the preceding scanning position 74, i.e. if the deepest marginal line 138 will have a course inclined downward relative to the xy-plane from the scanning position 74(n) to the scanning position 74(n+1), there is a change however in the relations with the substrate material 12a present there below the temperature-regulating hollow structure 22. This also applies in the circumferential direction perpendicular to the marginal line 138, i.e. in figure 30 in the directions out of and into the plane of the drawing. In practice, undesired damage has arisen there in the substrate material 12a. It is assumed that this is a cumulative effect which is dependent, inter alia, on the Rayleigh length $z_R$ and the energy of the laser beam 46 radiated into the solid material. The longer the Rayleigh length $z_R$, the deeper the damage may extend into the substrate material 12a since then even down into deeper regions an energy density/fluence H of the laser beam 46 is present to cause such damage.

Therefore, in such sections 136 of the temperature-regulating hollow structure 22, a scanning concept illustrated in figure 30B is carried out in which in the course of an enlargement of the scanning areas 72 or the slices 62 the scanning patterns 64, 116, 120 are set and scanned in such a way that the deepest marginal line 138 remains in the xy-plane without a slope or inclination between the scanning position 74(n) and the scanning position 74(n+1). This means that the conditions at the deepest marginal line 138 do not change. The temperature-regulating hollow structure 22 already formed runs below the topmost marginal line, not provided with a reference sign here, such that radiation into substrate material 12a cannot occur there.

If the cross-section is intended to be reduced in size, this can be done by a change in the scanning area 72 which is symmetrical about the longitudinal central axis 134.

Figure 31 shows a section 136 of a temperature-regulating hollow structure 22 produced in this way, which structure periodically widens and narrows there in the longitudinal direction 60. In this case, the cross-sectional area of a largest cross-section in the section 136 is larger than the cross-sectional area of the smallest cross-section in this section 136 preferably by a factor of between 1.2 and 3.

In this way, in the direction of the later carrier surface 14, a flow surface 140 with a harmonic structure is formed thus by periodically occurring elevations and depressions. In this case, the internal lateral surface 80 of the temperature-regulating hollow structure 22, in longitudinal sections, follows a wavy line 142 at least on one side. If the narrowed portions and widened portions were produced in accordance with figure 30A, such a wavy line is formed on both sides of the temperature-regulating hollow structure 22 in all longitudinal sections through the longitudinal central axis.

In the case of the variant used here according to figure 30B, however, there is a longitudinal section through the longitudinal central axis, namely the longitudinal section shown in figure 30B, in which the internal lateral surface 80 of the temperature-regulating hollow structure 22 follows a wavy line 142 on one side and a straight line on the other side, which straight line here describes the deepest marginal line 138. This can also be produced by scanning patterns 64 other than circular scanning patterns.

A harmonic structure should be understood here to mean a structure with fluidically soft transitions in which macroscopically there are no or only slightly shaped steps or edges which promote turbulences and vortices of a flowing fluid.

By this means, along the temperature-regulating channel 22 it is possible to increase the area of contact with the substrate material 12a in the direction of the carrier surface 14, thereby enabling a greater heat transfer between a temperature-regulating fluid flowing through and the substrate material 12a there.

The cross-sectional areas of the temperature-regulating channel 22 there are still circle areas and thus symmetrical with respect to the longitudinal central axis 134.

In a modification that is not shown separately, harmonic structures can also be formed on the underside of the temperature-regulating hollow structure 22.

7.1 Producing asymmetrical cross-sections

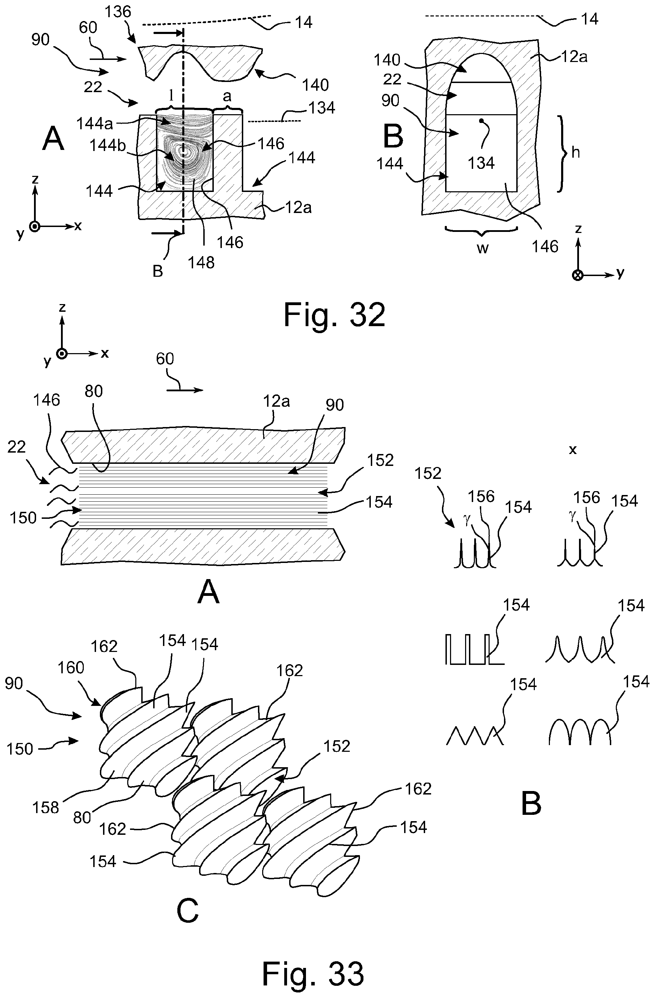

Figure 32, by contrast, shows an exemplary embodiment with asymmetrical cross-sectional areas in the longitudinal direction 60, through which, in addition to the harmonic structures 138 on the top side of the temperature-regulating hollow structure 22, on the underside thereof, as the side remote from the carrier surface 14, recesses 144 spaced apart from one another are carved, the transverse extent of which is constant. Figure 32A shows a longitudinal section and figure 32B the cross-section B from figure 32A, which clarifies the asymmetry with respect to the longitudinal central axis 134.

The recesses 144 have a length I in the x-direction, a width w (this designation w in the German text being derived from the English word) in the y-direction and a height h in the z-direction and are arranged at a distance a from the nearest recess 144, provided that there is one. These parameters I, w, h and a can have different values for different recesses.

The geometry and dimension of the recesses determined by the parameters I, w, z and a as well as by their cross-section and longitudinal section are geared to producing an upper flow zone 144a and a lower vortex zone 144b for the temperature-regulating fluid, which is designated here by 146. The upper flow zone 144a of a recess 144 is configured such that there is flow through it in the longitudinal direction 60 largely without turbulences or vortices, which is shown by flow lines of the temperature-regulating fluid 146 there in figure 32A. Just a kind of flow sink forms there.

Starting from a certain depth in the recess 144, however, the flow is disrupted at the boundary wall 146 of the recess that lies in the longitudinal direction 60, and a vortex flow 148 forms downward, the temperature-regulating fluid 146 circulating as it were in this vortex flow at least at times; this, too, is illustrated by flow lines. After one or more circulation cycles, a portion of this circulating temperature-regulating fluid passes again into the flowing-past part of the temperature-regulating fluid 146 and is then recirculated.

As a result, however, this reduces a heat transfer between the temperature-regulating fluid 146 and the substrate material 12a at the recesses 144. For cooling of the substrate 12 with a cooling fluid, that means for a temperature-regulating hollow structure 22 for the purposes of this exemplary embodiment that at the top side heat of the substrate material 12a is effectively absorbed by the cooling fluid, but this heat is not input into the substrate material 12 on the underside 12a to the extent that would be the case without the recesses 144. As a result, the heat overall can be dissipated from the substrate 12 particularly effectively by the cooling fluid flowing away.

Such recesses 144 on the underside of the temperature-regulating hollow structure 22 can also be provided without harmonic structures 140 being formed on the top side. Moreover, the harmonic structures 140 and recesses 144 can be provided in a manner offset in the longitudinal direction 160.

In this case, the flow behavior of the temperature-regulating fluid 146 in particular in the vortex zones 144b of the recesses 144 is not only determined by the dimensions l, w, h and a of the recesses 144 but also depends, inter alia, on the viscosity and the volumetric flow rate of the temperature-regulating fluid 146.

Such vortex flows 148 additionally have the advantageous property of producing only comparatively small FIVs ("flow induced vibrations") at the internal lateral surface 80 of the temperature-regulating hollow structure 22.

8. Structuring of the internal lateral surface

In order to counteract the FIVs to an even greater degree, the scanning patterns 64, 116, 120 which are scanned in the scanning positions 74(n) can be designed in such a way that periodic structures 90 as flow structures 150 which reduce the frictional resistance vis-à-vis a flowing liquid temperature-regulating fluid 146 are formed on the internal lateral surface 80 of the temperature-regulating hollow structure 22.

In practice, good flow behaviors were able to be achieved here in particular with riblet structures 152 with ribs 154 formed in the longitudinal direction 60, which is indicated merely highly schematically in figure 33A. Such ribs 154 can, but need not, have a sharp edge 156 at the free margin. Such a sharp edge 156 is then preferably formed in such a way that it encloses in cross-section an acute angle $\gamma$ of 10° or less, in particular 5° or less, and preferably 2°.

Figure 33B shows a few non-exhaustive examples of possible rib shapes in cross-section, with three ribs 154 formed one behind another in the circumferential direction always being shown.

On the internal lateral surface 80 of the temperature-regulating hollow structure 22, there may also be individual sections in the longitudinal direction 60 whose flow structures 150, optionally specifically ribs 154, are offset in the circumferential direction. Further modifications involve forming, in the circumferential direction of the temperature-regulating hollow structure 22, regions of the internal lateral surface 80 that are also only spaced apart from one another with flow structures 150.

The riblet structures 152 can also correspond to the surface 158 of a kind of scale structure 160 constructed from a multiplicity of individual scales 162 with such ribs 154. Such a surface 158 is derived from the scale surface of a shark. This is illustrated by figure 32C. This surface 158 then forms the internal lateral surface 80 of the temperature-regulating hollow structure 22.

In modifications not shown separately here, structures, in particular flow structures 150, can also be produced on the internal lateral surface 80 of the temperature-regulating hollow structure 22 by a correspondingly prestructured film or a correspondingly prestructured inlay being drawn into the temperature-regulating hollow structure 22.

Alternatively, firstly a film or an inlay that are smooth in regard to the desired structures can also be drawn into the temperature-regulating hollow structure 22 and only then processed in such a way that the desired structure, in particular a flow structure 150, is produced. By way of example, hoses, preferably corrugated hoses, with plastic inliners composed of polytetrafluoroethylene (PTFE), tetrafluoroethylene-hexafluoropropylene-vinylidene fluoride copolymer (THV) or the like can be used for this purpose. Preferably, such hoses can be provided at diverters of the temperature-regulating hollow structure 22, where a majority of the FIVs arise as a result of a flowing temperature-regulating fluid.

The structuring of the internal lateral surface of temperature-regulating hollow structures is also considered in the German patent application 10 2024 116 622.3, the entire disclosure of which is hereby incorporated by reference in the present application.

9. Apparatus pertaining to semiconductor technology/projection exposure apparatus

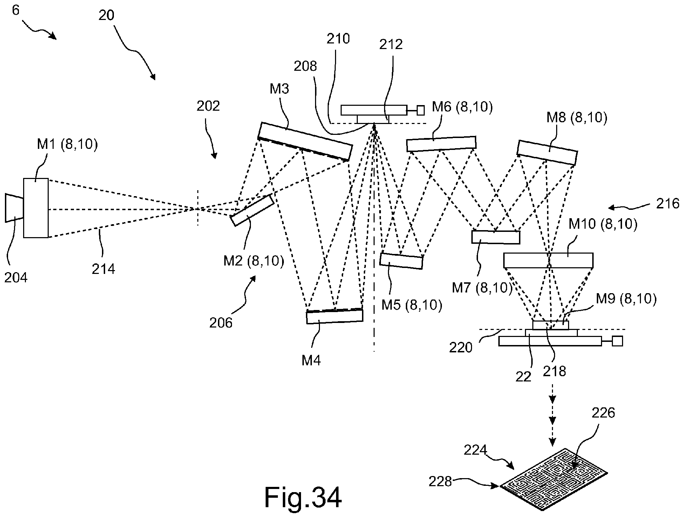

Figure 34 illustrates again an apparatus pertaining to semiconductor technology 6 on the basis of the example of a projection exposure apparatus 200 for EUV semiconductor lithography. Other apparatuses pertaining to semiconductor technology such as e.g. a mask inspection apparatus or a wafer inspection apparatus contain components in part identical or similar to those as explained here on the basis of the example of the EUV projection exposure apparatus 200.

The projection exposure apparatus 200 comprises an illumination system 202 with a radiation source 204 and an illumination optical unit 206 for illuminating an object field 208 in an object plane 210, in which a reflective reticle 212 is arranged. In the exemplary embodiment illustrated, the radiation source 204 is an EUV radiation source which emits EUV radiation as working radiation 214, in particular in a wavelength range of between 5 nm and 30 nm. The radiation source 204 can be a plasma source, for example an LPP (laser produced plasma) source or a GDPP (gas discharge produced plasma) source. Alternatively, a synchrotron-based radiation source or a free electron laser (FEL) can be used as the radiation source 204.

Moreover, the projection exposure apparatus 200 comprises a projection optical unit 216 for imaging the object field 208 into an image field 218 situated in an image plane 220 of the projection optical unit 216. As an example of an object 222, a wafer bearing a light-sensitive layer (referred to as a resist) is arranged in the image plane 220. Components for synchronously moving the reticle 212 and the wafer 222 are merely indicated in figure 34 and are not provided with reference signs.

The projection exposure apparatus 200 comprises a plurality of optical elements 8 in the form of mirrors Mn, which are consecutively numbered in accordance with their arrangement in the beam path of the projection exposure apparatus 200. In the present case, a total of 10 mirrors M1 to M10 are present in the beam path.

The mirrors M3 and M4 are embodied as facet mirrors containing a multiplicity of individual mirrors. Each of the other mirrors Mn is a mirror 10 with a monolithic mirror substrate 12 and a coating 16 borne thereby, as shown by way of example in figure 1. These mirrors are indicated as parallelepipeds in figure 34 for the sake of simplicity. In reality, however, the surfaces of the mirrors 10 that are exposed to the EUV radiation 214 and provided with the coating 16 are not plane, but rather curved, as likewise illustrated by figure 1.

The mirrors M1 to M4 in the illumination system 206 serve to illuminate a section of the reticle 212 with the desired illumination angle distribution. The mirrors M5 to M10 of the projection optical unit 216 image this section onto the wafer 222 in a reduced size. As a result, the structures contained in the reticle 212 are imaged onto the light-sensitive layer borne by the wafer 222.

With the aid of the optical elements 8, which in the present exemplary embodiment are formed as mirrors 10 for the EUV projection exposure apparatus 200 and the coating of which is configured at least to reflect at least 50% of EUV light impinging with normal or almost normal incidence, the object 222 is irradiated with the working radiation 214.

The apparatus 6 pertaining to semiconductor technology is part of a production process which can be used to produce a structured electronic component 224, which is shown in figure 27 schematically with produced structures 226 as the result of an overall production process comprising even further steps besides the process in the apparatus 6 pertaining to semiconductor technology. What is relevant here, however, is that the apparatus 6 pertaining to semiconductor technology comprises at least one optical element 8 which was produced in one of the ways encompassed by the method variants explained above.

The structured electronic component 224 is in particular a computer chip 228, during the production of which a projection exposure apparatus, here the projection exposure apparatus 200, is used, as was discussed in the introduction.

10. Single-hatch scanning patterns and helix scanning processes

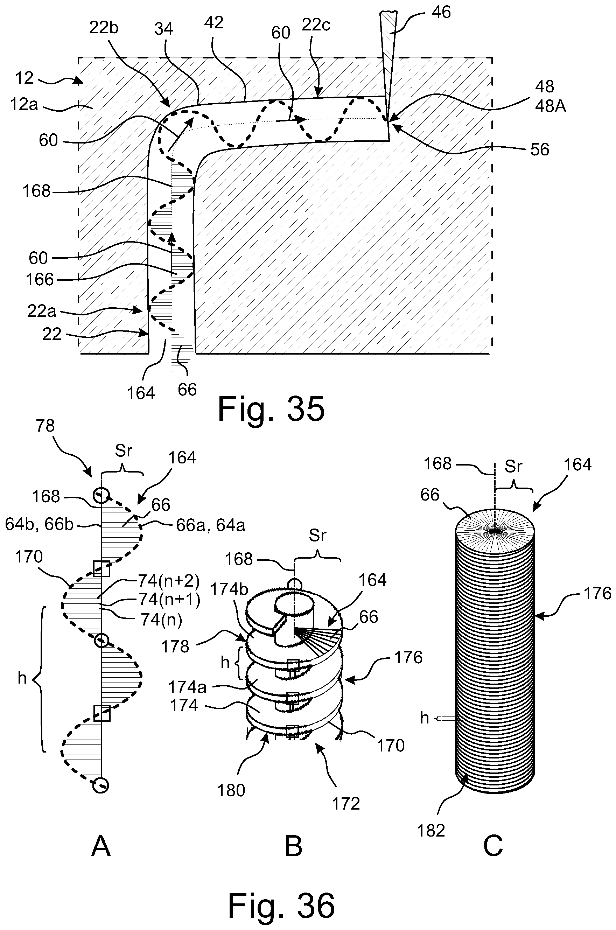

The scanning patterns 64, 116, 120 explained hitherto comprise a plurality of hatch lines 66. Figures 35 to 37 then elucidate the application of a single-hatch scanning pattern 164 which is distinguished by the fact that the number of hatch lines 66 is equal to one and such a single-hatch scanning pattern 164 comprises only a single hatch line 66.

In the following exemplary embodiments, this hatch line 66 is rectilinear; in modifications that are not shown separately, however, the hatch line 66 of a single-hatch scanning pattern 164 can also be curved and have an arcuate course.

The pattern scanning path of a single-hatch scanning pattern 164 is likewise defined by this hatch line 66, which correspondingly also predefines the scanning position 74. A slice 62 is then defined by that ablation volume which is ablated along this hatch line 66; a corresponding slice 62 produced by scanning of a single-hatch pattern 164 is referred to hereinafter as hatch slice 166.

During a scanning process with single-hatch scanning patterns 164, there are therefore no hatch jump paths 68. However, the end 66b and the beginning 66a of the hatch line 66 are simultaneously the jump end and jump beginning, respectively, and also the pattern end point 64b and pattern starting point 64a, respectively, of the single-hatch scanning pattern 164. Therefore, as already explained, a pattern jump path 76 proceeds from the jump end 66b of the hatch line 66 of the single-hatch scanning pattern 164 of a first scanning position 74(n) to a jump beginning 66a of a hatch line 66 of the single-hatch scanning pattern 64 of a second scanning position 74(m). The positions 66a, 64a and 66b, 64b shown in figure 36A, which are indicated only for one hatch line 66, can also be interchanged.

Single-hatch scanning patterns 164 can then be scanned in particular in a sequence in which the respective hatch lines 66 in different scanning positions 74(n) each extend in the radial direction between the longitudinal central axis 168 and the outer screw line 170 of a geometric, i.e. not really present, reference helix screw 172 with a screw flight 174, as elucidated by figures 35 and 36. A scanning process with such a sequence of the single-hatch scanning patterns defines a helix scanning process.

By means of such a helix scanning process, a screw volume 176 can be ablated in the longitudinal direction 60 of the temperature-regulating hollow structure 22 to be produced.

The longitudinal central axis 168 of the reference helix screw 172 need not be a straight axis, but rather is defined analogously to the longitudinal direction 60 of a temperature-regulating hollow structure 22 in each case at a midpoint taking into account the preceding course and the following course of the reference helix screw 172. The geometric helix screw 172 can thus also have a curved course, whereby flight sections can also overlap in the geometric consideration. The ablated screw volume 176 is then correspondingly curved.

A longitudinal section 178 of a geometric helix screw 172 can be described by a screw radius Sr and the pitch h. The pitch h is the distance measured in the longitudinal direction between each two adjacent sections 174a and 174b of the screw flight 174 of the helix screw 172, wherein in this way it is also possible to define a partial helix screw with such a short flight course in which there are no flight sections that are directly adjacent in the longitudinal direction. Both the screw radius Sr and the pitch h of the helix screw 172 can change along the longitudinal central axis 168 and need not remain constant.

In this way, it is possible, for example, to produce the temperature-regulating hollow structures 22 shown in figures 30 and 31 using a helix scanning process in which the screw radius Sr is varied along the longitudinal central axis, designated by 134 in figures 30 and 31.

The illustrations in figures 35 and 36a show a sequence of the single-hatch scanning patterns 164 which is greatly stretched in the longitudinal direction in order to elucidate the helix screw. In figure 36A, the crossing points indicating where the screw line 170 therein crosses the longitudinal central axis 168 of the helix screw 172 are alternately surrounded by a circle and a square shown black; the crossing points marked by a circle are located behind the plane of the drawing, and the crossing points marked by a square are located in front of the plane of the drawing. This is also shown in figure 36B.

10.1 Single-flight helix screw

Figures 35 and 36 illustrate a single instance of carrying out the helix scanning process, in which the ablated screw volume 176 thus corresponds to the helix screw 172 shown in figure 36B, which is a single-flight helix screw designated separately once again by 180 and comprising the single screw flight 174.

Figure 36B shows the helix screw 172 and thus the single-flight helix screw 180 with a rod-shaped longitudinal central axis 168 in order to clarify the screw course. In practice, however, the longitudinal central axis 168 is only geometric, which is shown by the shown hatch lines 66 of the single-hatch scanning patterns 164 in figure 36B.

During the helix scanning process, preferably the pitch h of the reference helix screw 172 and here, therefore, of the single-flight helix screw 180 is then chosen to be so small that a string full volume 182 is ablated which largely corresponds to the corresponding volume of the produced temperature-regulating hollow structure 22 in this section. This is illustrated by figure 36C, which shows a corresponding string full volume 182, in which case the single-hatch scanning patterns 164 and their hatch lines 66 are also supplementarily shown at the upper string end.

10.2 Multi-flight helix screws

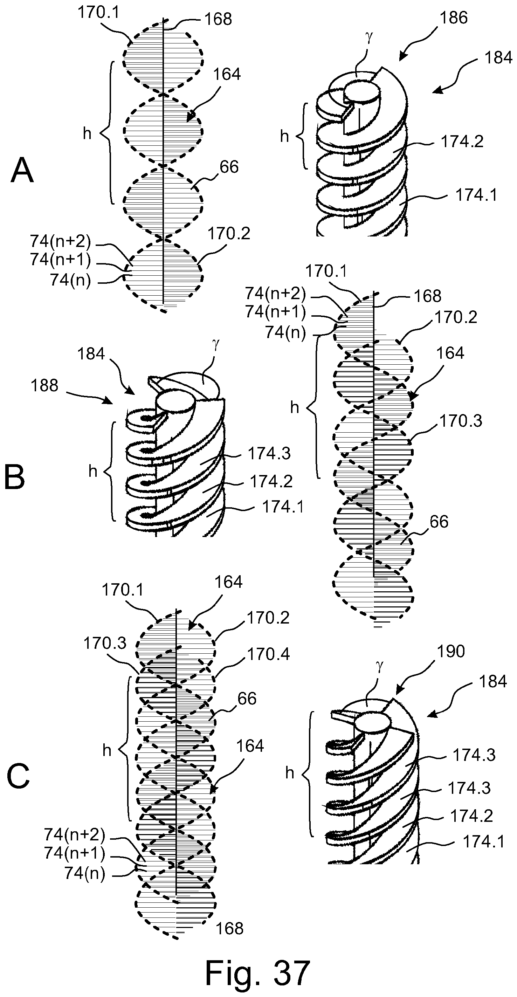

As shown in figure 37, a helix scanning process can also be carried out a number of times along one and the same longitudinal central axis 168 in such a way that the ablated screw volume 176 corresponds to a multi-flight helix screw 184 with a plurality of screw flights 174. For this purpose, two or more helix scanning processes are carried out in such a way that in a common scanning position 74 the single-hatch scanning patterns 164 of the helix scanning processes that are carried out separately are rotated by a rotation angle $\gamma$ in the circumferential direction. In this case, it is not necessary for the helix scanning processes to begin in one and the same scanning position 74.

In this case, the screw radii Sr and pitches h can be identical for each helix scanning process or can be defined individually for each helix scanning process along the longitudinal central axis 168, i.e. for each scanning position 74.

Figure 37A illustrates this for two helix scanning processes which are carried out with a rotation angle $\gamma$ of 180°, which results in a two-flight helix screw 186 with two screw flights 174.1 and 174.2. In this case, the pitch h is always the distance between two adjacent flight sections of one and the same screw flight 174.

Figure 37B illustrates how three helix scanning processes with a rotation angle $\gamma$ of 120° result in a three-flight helix screw 188 with three screw flights 174.1, 174.2 and 174.3. Accordingly, figure 37C illustrates how four helix scanning processes with a rotation angle $\gamma$ of 90° result in a four-flight helix screw 190 with four screw flights 174.1, 174.2, 174.3 and 174.3.

Put generally, a number n of helix scanning processes are carried out with a rotation angle $\gamma$ between two successive helix scanning processes.

The above examples elucidate this process for n = 2, 3, 4 where $\gamma$ = 360/n. However, the rotation angle can also be different than 360/n and given n > 2 can also be different between two respectively successive scanning passes.

The pitches h of the respective reference helix screws 172 for each helix scanning process are each coordinated here in such a way that after the corresponding number n of helix scanning processes has been carried out, the desired string full volume 182 has been ablated. In this case, the pitches h can be different for different helix scanning processes and can be variable within a respective helix scanning process.

10.3 Contour helix scanning processes

As explained above, the temperature-regulating hollow structures 22 define an internal lateral surface 80, the structural formation of which depends on the completed scanning trajectory 78, inter alia.

The internal lateral surface 80 can then be processed and formed with the aid of a contour helix scanning process that likewise uses single-hatch scanning patterns 164. A contour scanning process is generally carried out in addition to the above-explained scanning process(es) by which material has already been ablated in order to form the temperature-regulating hollow structure 22.

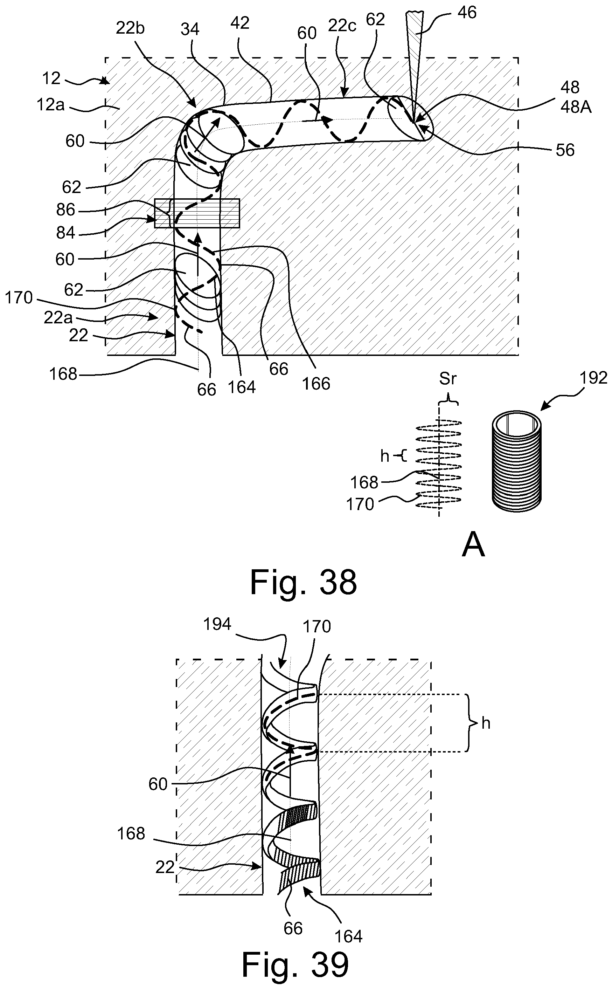

Figure 38 shows this on the basis of a contour helix scanning process in which successively scanned single-hatch scanning patterns 164 follow the course of the outer screw line 170 of a geometric reference helix screw 172 in accordance with figure 36B. Each stroke of the screw line 170 shown in figure 38 here represents a single-hatch scanning pattern 164 or the hatch line 66 thereof.

In this case, the hatch lines 66 are thus correspondingly curved. In one modification, the hatch lines 66 of the single-hatch scanning patterns 164 used can also be rectilinear and be scanned in such a way that each hatch line 66 lies approximately tangentially against the screw line 170.

The resulting hatch slice 166 is then in each case the ablation volume along a section of a helix coil 192, as shown in figure 38A alongside a screw line 170 that is shown once again. This helix coil 192 illustrates a full volume which is ablated as a result along the internal lateral surface 80 of the temperature-regulating hollow structure 22.

In figure 38, the illustration of the screw line 170 is again stretched in the direction of the longitudinal central axis 168 for the sake of clarity. In practice, the pitch h is regularly chosen in such a way that the helix coil 192 defines a full volume and there are no spacings between hatch slices 166 that are adjacent in the direction of the longitudinal central axis 168.

The lengths of the hatch lines 66 of the individual single-hatch scanning patterns 164 can be different. Optionally, during the contour helix scanning process, it is also possible for just a single single-hatch scanning pattern 164 to be scanned, the hatch line 66 of which then corresponds to the screw line 170 over the entire extent thereof. The hatch slice 166 is then the full volume of the helix coil 192.

Figure 39 illustrates a modification of the contour helix scanning process, wherein a plurality of single-hatch scanning patterns 164 with a direction component pointing in the same direction as the longitudinal central axis 168 or the longitudinal direction 60 of the temperature-regulating hollow structure 22 are scanned along the screw line 170 of the reference helix screw 172.

As a result, in this way a volume corresponding to a helical strip 194 is ablated, as shown in figure 39. There, too, the illustration is chosen so as to be stretched again in the longitudinal direction; in practice, the pitch h is such that the strip edges of the helical strip 194 lie against one another.

10.3 Partial pattern scanning process

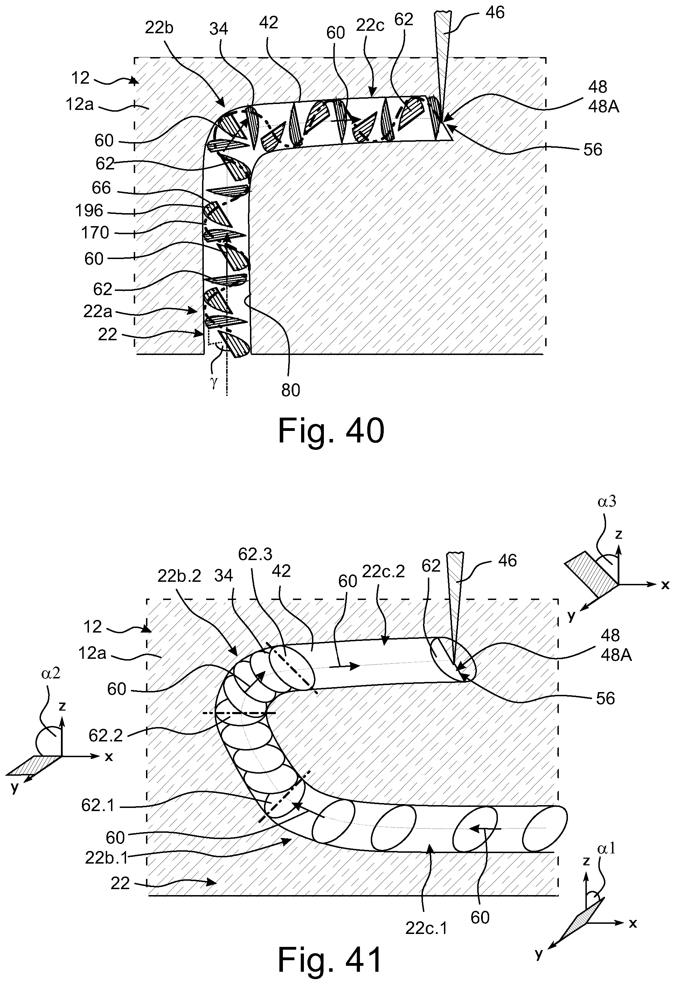

Figure 40 illustrates a helix scanning process in which partial cross-section scanning patterns 196 are scanned, which are distinguished by the fact that they cover only a radially outer part of the cross-section of the temperature-regulating hollow structure 22 to be produced which adjoins the internal lateral surface 80 of the temperature-regulating hollow structure 22.

By way of example, a partial cross-section scanning pattern 196 corresponds to the scanning pattern 64 in the intermediate scanning position 112, as was explained above with reference to figure 23.

The partial cross-section scanning patterns 196 are scanned in a partial pattern scanning process in which these are arranged in the scanning positions 74 in such a way that each ablated slice 62 lies on the outside against a screw line 170. Identical or different partial cross-section scanning patterns 196 are scanned in each scanning position 74, wherein the partial cross-section scanning patterns 196 in two successive scanning positions 74(n) and 74(n+1) are rotated by a rotation angle $\gamma$ in the circumferential direction.

In the exemplary embodiment presently shown, the partial cross-section scanning patterns 196 cover a semicircle and half of the cross-section of the temperature-regulating hollow structure 22, where the rotation angle $\gamma = 45°$. However, the partial cross-section scanning patterns 196 can also cover other area regions of the cross-section of the temperature-regulating hollow structure 22 and be scanned with rotation angles $\gamma$ adapted thereto. Partial cross-section scanning patterns 196 scanned in different scanning positions 74 may also be of different sizes and possibly not extend as far as the longitudinal central axis 168, whereby scanning need not be effected across the longitudinal central axis 168 in every scanning position 74.

As a result of the rotation of the partial cross-section scanning patterns 196 in different scanning positions 74 by the rotation angle y, a uniform material ablation is achieved in all regions of the temperature-regulating hollow structure 22.

For more intensive processing of the internal lateral surface 80, specific sections of the temperature-regulating hollow structure 22 can be scanned a number of times in this way, wherein the sequence of the partial cross-section scanning patterns 196 in this section relative to the scanning positions 74 is repeated or begins in a different scanning position 74. In the latter case, the partial cross-section scanning patterns 196 are alternately interspersed, as it were, relative to the scanning processes already carried out.

This concept can also be utilized in the application of the intermediate scanning position 112 by means of a plurality of intermediate slices 114 being produced.

11. Variation of the pitch angle $\alpha$

As has already been explained with regard to figure 3, the slices 62 are tilted by a pitch angle $\alpha$ relative to the yz-plane, wherein the pitch angles $\alpha$ can also be different from slice to slice.

Such changes in the pitch angle $\alpha$ are visible particularly if the intention is to form temperature-regulating hollow structures 22 with sections whose longitudinal direction 60 is at a similar angle with respect to the yz-plane.

Figure 41 shows a sectional view corresponding to figure 3 again, with a temperature-regulating hollow structure 22 having two regions 22c.1 and 22c.2 with a horizontal direction component, which are connected by an arc section, which in turn comprises two successive arc regions 222b.1 and 22b.2. There is no vertical section 22a in that case.

In the case of the slice 62.1 and the preceding slices in the section 22c.1, the pitch angle $\alpha1 = -45$ in the case of angles of the longitudinal direction 60 of the temperature-regulating hollow structure 22 with respect to the yz-plane of between 90°, which corresponds to a horizontal course, and approximately 45°, which corresponds to an inclination upward toward the left. The negative pitch angle $\alpha1 = -45°$ is illustrated in the coordinate system shown.

In the second arc region 22b.2, in particular, the longitudinal direction 60 of the temperature-regulating hollow structure runs at an angle of -45° with respect to the yz-plane. If the scanning pattern 64 were scanned there with the same pitch angle $\alpha = -45$, a very large scanning pattern 64 would have to be scanned in order to ablate the cross-section of the temperature-regulating hollow structure 22 in the longitudinal direction 60 there. In this case, problems may arise in particular when rinsing such large regions in order to rinse away the ablated substrate material. What is more, severe arcs over approximately 180° may also give rise to shading that precludes a scanning process.

This is avoided if the pitch angle $\alpha$ is chosen depending on the angle of the longitudinal direction 60 of the temperature-regulating hollow structure 22 with respect to the yz-plane. Figure 41 illustrates this on the basis of three different pitch angles $\alpha$.

In the case of the slice 62.2 and the preceding slices, the pitch angle $\alpha2 = 90°$ in the case of angles of the longitudinal direction 60 of the temperature-regulating hollow structure 22 with respect to the yz-plane of between 45° and 0°, which corresponds to a vertical course.

In the case of the slice 62.3 and the preceding slices, the pitch angle is then $\alpha3 = +45°$, i.e. positive as in figure 3.

Figure 41 serves only to elucidate the concept; the pitch angles $\alpha$ chosen in practice for the respective slices 62 or the scanning patterns to be scanned therefor depend on the overall circumstances. Overall, however, largely any desired freeform shapes of the temperature-regulating hollow structures 22 can be produced in this way.

In order to calculate the scanning process, the temperature-regulating hollow structure 22 to be produced can be subdivided into individual sections, for example, for which an appropriate pitch angle $\alpha$ is calculated. If there is a change in the pitch angle $\alpha$ in the process, small regions are scanned in an overlapping manner in order to attain a uniform transition between the individual sections. The number of individual sections is arbitrary and can also be very high. Optionally, the pitch angle $\alpha$ can be varied so that the angle of the slice 62 with respect to the longitudinal direction 60 of the temperature-regulating hollow structure 22 remains the same at every position.

12. Polylines and microvectors

In the case of the contour scanning patterns 120 explained with reference to figures 28 and 29, the difficulty that occurs, primarily when scanning the contour region 122, is that with processing systems or focusing devices 50 used at the present time, straight lines can be scanned between a starting point and an end point, at each of which the processing light beam or the laser beam 46 has to stop. It follows from this that a circular or spiral trajectory is generally effected by the scanning of very many short lines which meet at deflection points. The circular hatch lines 128 and spiral hatch lines 130 described above are scanned in this way.

A large number of acceleration and retardation effects occur in the implementation, as a result of which the scanning of corresponding circular hatch lines 128 or spiral hatch lines 130 is time-consuming. Moreover, some focusing devices 50 established on the market are not designed for scans of short lines required and technical problems may occur.

In order to avoid this, a circular hatch line 128 or spiral hatch line 130 can be represented by polylines which can be scanned by a focusing device without the retardations and accelerations that are necessary otherwise. Polylines are in turn produced in terms of control engineering by a sequence of so-called microvectors, which can be implemented as an extremely small vector unit within a single clock cycle of commercially established RTC boards or modules used and corresponding fast hardware.

Two successive polylines can in turn be linked again by microvectors. If finely resolved interpolation point grids are supplementarily used as well, a particularly high accuracy and dimensional fidelity can be attained in particular for rounded freeform shapes. Finely resolved interpolation point grids are, in particular, interpolation point grids whose line length is in the range of less than 100 $\mu$m or in which the transition angle between two individual lines is less than 5°.

Figuratively speaking, the laser beam 46 is guided on a kind of vectorially established arc trajectory at a deflection point, in which case the laser is no longer deactivated between the individual trajectories, but rather is activated and moves at full speed through the individual interpolation points. Depending on the speed and the angle between the individual vectors, although this results in a higher inaccuracy than the operating mode with deflection trajectories, the resulting error owing to the very small angles is negligibly small and has no adverse effects on the quality of the temperature-regulating hollow structure 22. What can be achieved, rather, by way of a corresponding adaptation of the angle and speed parameters is that the transitions between the individual vectors are completely smoothed, whereby overall a continuous circular trajectory without sharp edges or bends is obtained.

It is known in the prior art to use RTC boards or modules in a so-called skywriting mode 3, which is able to independently recognize and directly implement suitable polylines on the basis of the desired target trajectory, i.e. here for example on the basis of a desired circular hatch line 128 or spiral hatch line 130.

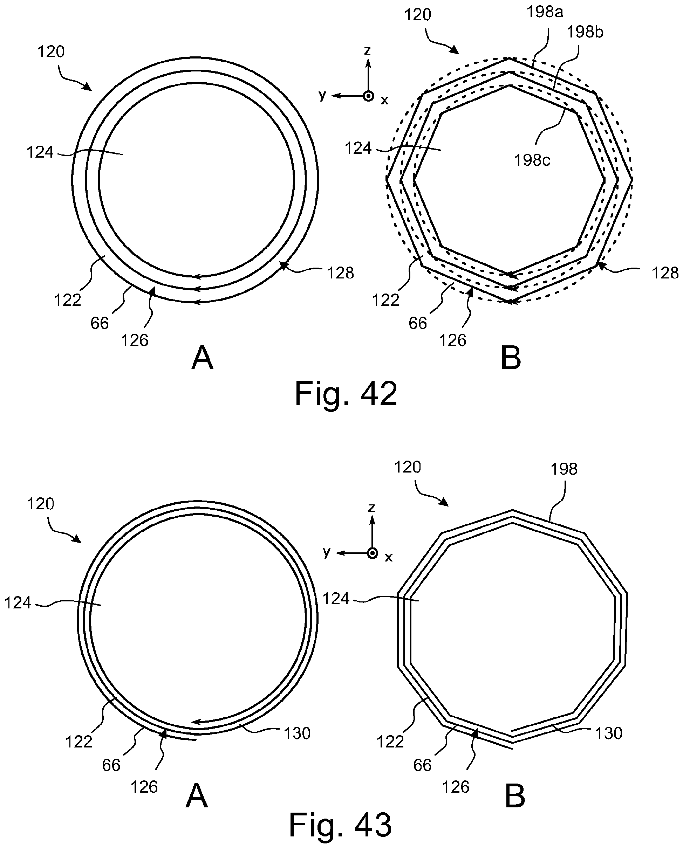

Figure 42 illustrates this concept for the contour region 122 of the contour scanning pattern 120 with three circular hatch lines 128; the core region 124 is illustrated there without hatch lines 66. Figure 42A shows the target trajectories and figure 42B shows three polylines 198a, 198b and 198c in each case highly schematically as an octagon in order to clarify the deflection points and the delaying, in the case of which the laser beam 46 is correspondingly guided at the deflection points. By virtue of the delaying illustrated in a clarified manner by the dashed lines in figure 42B, continuous trajectories then arise at the deflection trajectories and as a result they approximate the desired circular pattern to a greater level than is predefined by the interpolation points of the octagon.

Figure 43 correspondingly shows the application of a polyline 198 for producing a spiral hatch line 130. Figure 42A again shows the target trajectory and figure 42B the polyline 198 highly schematically with distinct deflection angles.

13. Modified contour scanning patterns/spiral scanning patterns

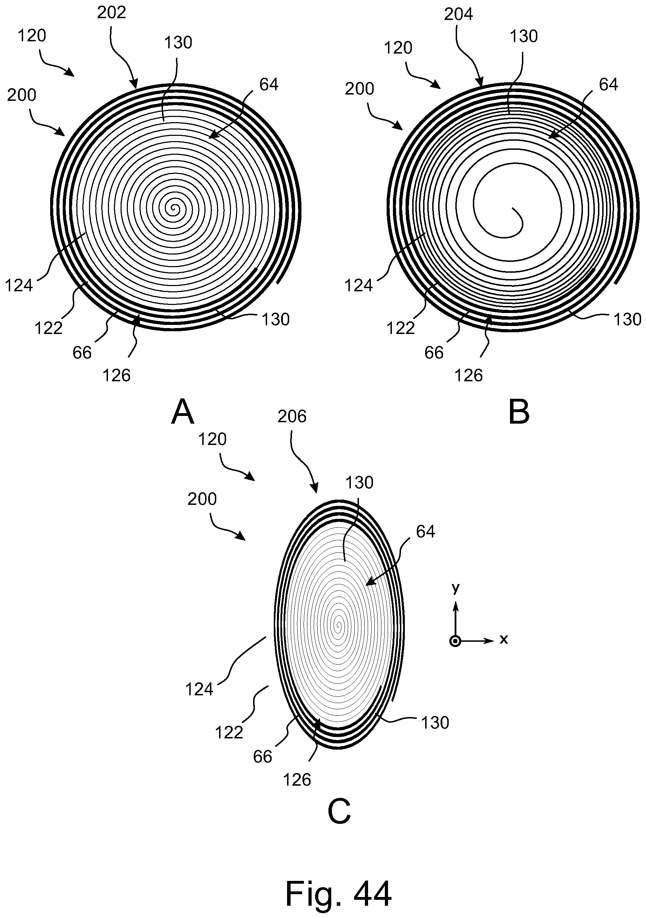

Figure 44 shows modified contour scanning patterns 120, in which both the contour region 122 and the core region 124 comprise a spiral hatch line 130, such that the contour scanning pattern 120 overall is formed as a spiral scanning pattern 200 with a continuous spiral hatch line 130. In one modification, there may also be a spacing between the spiral hatch lines 130 in the contour region 122 and in the core region 124.

In the case of the spiral scanning pattern 200 shown in figure 44A, the spiral hatch line 130 is an Archimedes' spiral 202 with a constant spacing between two adjacent sections of the spiral line.

In the case of the spiral scanning pattern 200 shown in figure 44B, the spiral hatch line 130 is a logarithmic spiral 204.

By way of example, the spiral hatch line 130 can be defined in its xy-plane by

$$r = \sqrt{\cos(\alpha)\, r(x)^2 + \sin(\alpha) r(y)^2}$$

. This xy-plane serves to describe the spiral hatch line 130 and is not the xy-plane of the coordinate system which is anchored with the substrate 12.

In this case, in each revolution n, the radius r of the spiral trajectory is calculated numerically depending on the applicable angle for every point of the spiral trajectory. This firstly involves defining what two radii r(x) in the x-direction and r(y) in the y-direction the spiral is intended to have.

Figure 44C shows an exemplary embodiment in which the spiral hatch line 130 of the spiral scanning pattern 200 is a complex spiral 206 which meets these conditions. An ellipse can also be scanned with such a complex spiral 206. The complex spiral 206 shown schematically illustrates a spiral in which the spacings of the spiral lines in the x-direction are not constant and become smaller radially toward the outside, whereas the spacings of the spiral lines in the y-direction are constant.

In order to deliberately ablate radially outer regions on the internal lateral surface 80 or radially inner regions on the longitudinal axis 60 of a temperature-regulating hollow structure 22, the complex spiral 206 can also be defined in its xy-plane by the function

$$y = \frac{(1+a)*x^b}{(x^{b-1}+a)} \quad .$$

This results in spiral trajectories with spiral lines positioned more closely at the outer edge, which then transition to a constant spacing.

Other suitable functions are sigmoid functions which guide spirals in which the outer and the central spiral lines run next to one another more closely than the middle spiral lines arranged therebetween.

Examples of such functions are

$$y = \frac{a}{1+e^{-bx+c}} \; ; \; a * e^{e^{-bx+c}} + d$$

and

$$y = a * tan(bx + c) + d$$

In this context, the course of the spiral hatch line 130 can be influenced directly by way of the value range of the function used. By way of example, a spiral that forms only the contour region 122 of the contour scanning pattern 120 can be represented in this way.

In principle, spirals with a flexible course are calculable in this way, which can be scanned as spiral hatch lines 130.

14. Concluding remarks

All of the methods, steps, sequences, concepts and principles above can be combined with one another, which is also reflected in the combinations of features specified in the claims. By way of example, one, a plurality or all of the scanning patterns explained can be used in the production of temperature-regulating hollow structures 22. In this case, different parameters described with respect to the processing light beam 46 can also be implemented supplementarily.

**Claims**

1. Method for incorporating temperature-regulating hollow structures (22) into a substrate (12), in particular into a substrate for an optical element, in particular for a mirror (10) for an EUV projection exposure apparatus, comprising the following steps:

(A) providing a substrate (12) consisting of a substrate material (12a);
(B) progressively focusing a processing light beam (46) on ablation locations (56) at which temperature-regulating hollow structures (22) are intended to arise, such that the substrate material (12a) is modified or ablated at the ablation locations (54), wherein that side of the temperature-regulating hollow structure (22) which is reached first by the processing light beam (46) defines the top side of the temperature-regulating hollow structure (22) and the direction upward as positive z-direction of a coordinate system which is anchored in a rotationally fixed manner with the substrate (12);
wherein
(C) a scanning process is carried out in which the processing light beam (46) is guided with a focus (48) in such a way that an ablation focus (48A) is moved along a scanning trajectory (78) through the substrate (12), wherein at the ablation focus (48A) the processing light beam (46) inputs energy with an energy density H into the substrate material (12a), which is high enough that the substrate material (12a) is modified or ablated;

**characterized in that**

(D) the scanning trajectory (78) comprises a plurality of scanning patterns (64, 116, 120, 164) which each define a pattern scanning path and are scanned in scanning positions (74), such that an ablation volume defining a slice (62, 114, 166) is ablated in each scanning position (74(n));
Wherein

(E) the scanning positions (74) are spaced apart from one another in a longitudinal direction (60) of the temperature-regulating hollow structure (22) to be produced;

(F) the scanning trajectory (78) additionally comprises pattern jump paths (76) in each case between a scanning pattern (64) of a first scanning position (74(n)) and a scanning pattern (64) of a second scanning position (74(m)).

2. Method according to Claim 1, **characterized in that** a scanning pattern (64, 116, 120, 164) defines a number of one or a plurality of hatch lines (66) along which the ablation focus (48A) is guided in a scanning direction from a beginning (66a) to an end (66b) of a respective hatch line (66), wherein given a number of a plurality of hatch lines (66) a hatch jump path (68) comprised by the scanning trajectory (78) is in each case defined between the end (66b) of a first hatch line (66) and the beginning (66a) of a second hatch line (66), wherein

(G1) as scanning patterns (64) line-to-line scanning patterns with hatch lines (66) which have the same scanning direction are scanned;
and/or

(G2) as scanning patterns (64) meandering scanning patterns with hatch lines (66) which have opposite scanning directions are scanned;
and/or

(G3) as scanning patterns (64) sector scanning patterns are scanned which

(a) have sectors (98), each of which is assigned a hatch distance hd at which two adjacent hatch lines (66) run, wherein the hatch distance hd in a sector (98) differs from the hatch distance hd in at least one adjacent sector (98);
and/or

(b) have sectors (98) in which the sequence of the scanning directions of the hatch lines (66) is different;
and/or

(G4) as scanning patterns (64) groove scanning patterns with hatch lines (66) which run at a hatch distance hd from one another which is greater than the beam diameter of the processing light beam (46) at the ablation focus (48A) are scanned;
and/or

(G5) as scanning pattern (64) an intermediate scanning pattern (116) is scanned in a scanning position (74) which defines an intermediate scanning position (112), wherein the hatch lines (66) of the intermediate scanning pattern (116) cover a smaller area than the hatch lines (66) of a scanning pattern (64) which was scanned previously in a preceding scanning position (74) which is not an intermediate scanning position (112);
and/or

(G6) as scanning pattern (64) a contour scanning pattern (120) is scanned which has hatch lines (66) as core region (124) and additionally a contour region (122) which at least sectionally surrounds the core region (124) and in which one or more hatch lines (66) are scanned as contour hatch lines (126) which supplement the hatch lines (66) in the core region (124) and have a course along the contour of the contour scanning pattern (120), wherein the contour hatch lines (126) comprise in particular circular hatch lines (128) or at least one spiral hatch line (130);
and/or

(G7) as scanning patterns (64) single-hatch scanning patterns (164) are scanned in which the number of hatch lines (66) is equal to one;
and/or

(G8) as scanning pattern (64) a partial cross-section scanning pattern (196) is scanned which covers only a radially outer part of the cross-section of a section of the temperature-regulating hollow structure (22) to be produced;
wherein

in these steps (G1), (G2), (G3), (G4), (G5), (G6), (G7) or (G8) the scanning pattern (64) is in each case scanned as such or as part of a then superordinate scanning pattern.

3. Method according to Claim 2, **characterized in that** a pattern jump path (76) in each case runs between the end (66b) of a hatch line (66) of a scanning pattern (64) in a first scanning position (74(n)) and the beginning (66a) of a hatch line (66) of a scanning pattern (64) in a second scanning position (74(m)) and

(H1) the scanning trajectory (78) between two adjacent scanning positions (74(n)) and (74(n+1)) comprises exactly one pattern jump path (76);
and/or

(H2) the scanning trajectory (78) between two adjacent scanning positions (74(n)) and (74(m)) comprises two or more pattern jump paths (76).

4. Method according to Claim 3, wherein step (G5) is carried out in such a way that

(a) an intermediate scanning position (112) runs between two scanning positions (74) which are not intermediate scanning positions;
or
(b) a plurality of intermediate scanning positions (112) are adjacent.

5. Method according to Claim 4, wherein each end (66b) of each hatch line (66) of the intermediate scanning pattern (116) is the beginning of a pattern jump path (76).

6. Method according to any of Claims 2 to 5, **characterized in that** the scanning of a scanning pattern (64, 116, 120, 164) results in a slice (62, 114, 166) being ablated in an ablation direction ad, wherein

(I1) slices (62, 114, 166) are ablated in two or more successive scanning positions (74) in the same ablation direction ad;
or
(I2) slices (62, 114, 166) are ablated in two or more successive scanning positions (74) with different ablation directions ad.

7. Method according to Claim 6, **characterized in that**

(J1) step (I1) is carried out with the ablation direction ad from the bottom upward or with the ablation direction ad from the top downward, in particular with the ablation direction ad from the bottom upward;
or
(J2) step (I2) is carried out, wherein the scanning patterns (64, 116) are scanned in two successive scanning positions (74(n), 74(n+1)) in a manner rotated relative to one another by a rotation angle $\beta$, in particular where $\beta$ = 10°, in the circumferential direction;
or
(J3) step (I2) is carried out, wherein the scanning patterns (64, 116) are scanned in such a way that slices (62, 114, 166) are ablated in two successive scanning positions (74(n), 74(n+1)) with opposite ablation directions ad;
or
(J4) step (J3) is carried out and the ablation direction ad in the first of the two successive scanning positions 74(n), 74(n+1) runs from the bottom upward or from the top downward.

8. Method according to any of Claims 2 to 7, **characterized in that** step (G3)(a) is carried out, wherein the hatch lines (66) of the sector (98) with a larger hatch distance hd are scanned with a processing light beam (46) having a greater pulse energy ($E_P$) than the pulse energy ($E_P$) of the processing light beam (46) when scanning a sector (98) with a smaller hatch distance hd.

9. Method according to Claim 8, **characterized in that** the hatch lines (66) with larger hatch distances hd, in two successive scanning positions (74), are scanned in a manner offset relative to one another in a direction transversely with respect to the scanning direction of the hatch lines (66).

10. Method according to any of Claims 2 to 9, **characterized in that** the pulse energy $E_P$ of the processing light beam (46) is set in such a way that the ablation focus (48A) is attained in a defocus plane (100) at a distance (D) above the focus (48), in which defocus plane the processing light beam (46) has a larger beam diameter than the focus (48) of the processing light beam (46).

11. Method according to Claim 10, **characterized in that** the peak pulse power Ps of the processing light beam (46) is less than the pulse power $P_L$ of the self-focusing threshold of the processing light beam (46).

12. Method according to any of Claims 2 to 11, **characterized in that** the processing light beam (46) is a processing light beam operated in a burst mode.

13. Method according to any of Claims 2 to 12, **characterized in that** step (G4) is carried out, wherein a groove scanning pattern (64.4) is scanned twice in the same scanning position (74) and the groove scanning pattern during the second scan is scanned in a manner rotated, in particular rotated by 90°, relative to the groove scanning pattern of the first scan, such that the hatch lines (66) of the two groove scanning patterns cross one another in the relevant scanning position (74).

14. Method according to any of Claims 2 to 13, **characterized in that** step (G6) is carried out, wherein in the case of the contour scanning pattern (120) a groove scanning pattern is scanned in the core region (124) and contour scanning patterns (120) are scanned in a plurality of scanning positions (74) in such a way that lateral webs (132) composed of substrate material (12a) are formed.

15. Method according to any of Claims 2 to 14, **characterized in that** step (G6) is carried out, wherein

    (a) the contour hatch lines (126) are circular hatch lines (128) and the hatch lines (66) in the core region (124) are circular hatch lines (128) or spiral hatch lines (130);
    or
    (b) the contour hatch lines (126) are spiral hatch lines (130) and the hatch lines (66) in the core region (124) are circular hatch lines (128) or spiral hatch lines (130).

16. Method according to Claim 15, **characterized in that** the contour hatch lines (126) and the hatch lines (66) in the core region are spiral hatch lines (130), such that the contour scanning pattern (120) defines a spiral scanning pattern (200), in particular a spiral scanning pattern (200) with a continuous spiral hatch line (130).

17. Method according to Claim 16, **characterized in that** the spiral hatch line (130) of the spiral scanning pattern (200)

    (a) is an Archimedes' spiral (202); or
    (b) is a logarithmic spiral (204); or
    (c) is a complex spiral (206) which

    (c1) is defined in its xy-plane by $\mathrm{r} = \sqrt{\cos(\alpha)\, r(x)^2 + \sin(\alpha) r(y)^2}$ ; or
    (c2) is defined in its xy-plane by the function

$$y = \frac{(1+a)*x^b}{(x^{b-1}+a)} \;;$$

    or
    (c3) is defined in its xy-plane by a sigmoid function and in particular by the functions

$$y = \frac{a}{1+e^{-bx+c}} \;;\; a * e^{e^{-bx+c}} + d$$

    or

$$y = a * tan(bx + c) + d \,.$$

18. Method according to any of Claims 2 to 17, **characterized in that** step (G6) is carried out, wherein a circular hatch line (128) or a spiral hatch line (130) is scanned by polylines and/or microvectors.

19. Method according to any of Claims 2 to 18, **characterized in that** step (G7) is carried out, wherein the single-hatch scanning patterns (164) are scanned in a helix scanning process in a sequence in which the respective hatch lines (66) in different scanning positions (74(n)) each extend in the radial direction between a longitudinal central axis (168) and an outer screw line (170) of a geometric reference helix screw (172) with a screw flight (174), such that a screw volume (176) is ablated in the longitudinal direction (60).

20. Method according to Claim 19, **characterized in that**

(a) the helix scanning process is carried out once in such a way that the ablated screw volume (176) corresponds to a single-flight helix screw (180) with a single screw flight (174);

or

(b) the helix scanning process is carried out repeatedly in such a way that the ablated screw volume (176) corresponds to a multi-flight helix screw (184) with a plurality of screw flights (174) by virtue of two or more helix scanning processes being carried out in such a way that in a common scanning position (74) the single-hatch scanning patterns (164) of the helix scanning processes carried out separately are rotated by a rotation angle ($\gamma$) in the circumferential direction.

21. Method according to Claim 20, **characterized in that** one or more pitches (h) of each reference helix screw (172) for a helix scanning process are chosen in such a way that a string full volume (182) is ablated.

22. Method according to any of Claims 2 to 21, **characterized in that** step (G7) is carried out, wherein a contour helix scanning process is carried out in such a way that

(a) a plurality of single-hatch scanning patterns (164) are scanned in a sequence in which successively scanned single-hatch scanning patterns (164) follow the course of the outer screw line (170) of a geometric reference helix screw (172) or lie approximately tangentially against the screw line (170);

or

(b) a single single-hatch scanning pattern (164) is scanned with a hatch line (66) which corresponds to the screw line (170) of a geometric reference helix screw (172);

or

(c) wherein a plurality of single-hatch scanning patterns (164) with a direction component pointing in the same direction as a longitudinal central axis (168) of a geometric reference helix screw (172) or as the longitudinal direction (60) of the temperature-regulating hollow structure (22) are scanned along the screw line (170) of the reference helix screw (172).

23. Method according to any of Claims 2 to 21, **characterized in that** step (G8) is carried out, wherein partial cross-section scanning patterns (196) are scanned in a partial pattern scanning process in which these are arranged in the scanning positions (74) in such a way that each ablated slice (62) lies on the outside against a screw line (170) of a geometric reference helix screw (172).

24. Method according to Claim 23, characterzied in that identical or different partial cross-section scanning patterns (196) are scanned in each scanning position (74), wherein the partial cross-section scanning patterns (196) in two successive scanning positions 74(n) and 74(n+1) are rotated by a rotation angle ($\gamma$) in the circumferential direction.

25. Method according to any of Claims 2 to 24, **characterized in that**, in two adjacent scanning positions (74(n), 74(n+1)), scanning patterns (64) that are scanned are such that the slice (62, 114, 166) in the second scanning position (74(n+1)) has at least regionally a larger radial extent than the slice (62, 114, 166) in the first scanning position (74(n)), wherein the deepest marginal line (136) of the temperature-regulating hollow structure (22) remains in the same xy-plane of the coordinate system.

26. Method according to any of Claims 1 to 25, **characterized in that** slices (62, 114) are ablated which are tilted by a pitch angle ($\alpha$) relative to the yz-plane of the coordinate system which is anchored in a rotationally fixed manner with the substrate (12), wherein there are at least two slices (62, 114) which are ablated with different pitch angles ($\alpha$).

27. Method according to Claim 26, **characterized in that** the pitch angle ($\alpha$) of a slice (62, 114) is selected depending on the angle formed between the longitudinal direction (60) of the temperature-regulating hollow structure (22) to be produced and the yz-plane of the coordinate system which is anchored in a rotationally fixed manner with the substrate (12).

28. Method for producing an optical element, in particular for producing a mirror (10) for an EUV projection exposure apparatus, **characterized in that** temperature-regulating hollow structures (22) are incorporated into the substrate (12) in accordance with the method according to any of Claims 1 to 27 and further processing comprises one or more steps of chemical and/or physical processing of at least one surface of the substrate (12) and also producing or applying a coating (16) on the substrate (12), which coating is configured at least to reflect at least 50% of EUV light impinging with normal or almost normal incidence.

29. Substrate for producing an optical element, in particular for producing a mirror (10) for an EUV projection exposure apparatus, wherein the substrate (12) has temperature-regulating hollow structures (22) incorporated into the substrate (12) in accordance with the method according to any of Claims 1 to 27.

30. Substrate for producing an optical element, in particular for producing a mirror (10) for an EUV projection exposure apparatus, wherein the substrate (12) has temperature-regulating hollow structures (22), in particular temperature-regulating hollow structures (22) incorporated into the substrate (12) in accordance with the method according to any of Claims 1 to 27,
**characterized in that**
at least one temperature-regulating hollow structure (22) defines an internal lateral surface (80) which

a) is formed at least regionally by a periodic structure (90) with a radial shaping;
and/or
b) is formed at least regionally by a roughness structure (131) having a mean roughness Ra in accordance with DIN EN ISO 25178, version as at 06/2023, of between 10.0 $\mu$m and 5.0 $\mu$m, which in particular is between 10.0 $\mu$m and 6.5 $\mu$m, between 10.0 $\mu$m and 8.0 $\mu$m, between 8.5 $\mu$m and 5.0 $\mu$m, between 7.0 $\mu$m and 5.0 $\mu$m or between 8.5 $\mu$m and 6.5 $\mu$m, or having a mean roughness Ra of 5.0 $\mu$m and less, which in particular is between 5.0 $\mu$m and 0.1 $\mu$m, preferably between 4.5 $\mu$m and 0.125 $\mu$m, between 4.0 $\mu$m and 0.15 $\mu$m, between 3.5 $\mu$m and 0.175 $\mu$m or between 3.0 $\mu$m and 0.2 $\mu$m.

31. Substrate according to Claim 30, **characterized in that**

a) the periodic structure (90) is formed in such a way that, upon a projection of successive cross-sections (84) of a section (86) of the temperature-regulating hollow structure (22) into an image plane (88), said periodic structure defines a contour line (92) of the internal lateral surface (80) which has a periodic course of recurring structural elements (94) at least in a section in the circumferential direction;
and/or
b) the roughness structure is formed in such a way that it extends out along the full circumference in the circumferential direction at least in a section in the longitudinal direction (60) of the temperature-regulating hollow structure (22).

32. Substrate according to Claim 31, **characterized in that** the periodic structure (90) is formed with different kinds of structural elements (94) which occur periodically in the circumferential direction, which in particular can also be superimposed.

33. Substrate according to any of Claims 29 to 32, **characterized in that** the periodic structure (90) is formed in the form of a rib structure (90a) with ribs as structural elements (94), which extends in the longitudinal direction (60) of the temperature-regulating hollow structure (22) and has a radial shaping.

34. Substrate according to Claim 33, **characterized in that** the ribs of the rib structure (90a) in the circumferential direction are at a distance of the order of magnitude of 0.5 to 1.5 times the distance between two adjacent hatch lines (66), in particular between 10 $\mu$m and 30 $\mu$m, with preference between 15 $\mu$m and 25 $\mu$m and preferably approximately 20 $\mu$m, and radially have a shaping with a ratio of 1:100 to 1:7 relative to the average diameter at a cross-section of the temperature-regulating hollow structure (22).

35. Substrate according to any of Claims 30 to 34, **characterized in that** the periodic structure (90), in particular in the form of the rib structure (90a) according to Claim 20 or 21, is formed in a first region of the internal lateral surface (80) of the temperature-regulating hollow structure (22) and the internal lateral surface (80) of the temperature-regulating hollow structure (22), in a second region, is formed by a structure (119) which is different than the periodic structure (90) and which has a more uniform area with smaller shaping in the radial direction than the periodic structure (90).

36. Substrate according to Claim 35, **characterized in that** the first region and the second region are arranged on opposite sides of the temperature-regulating hollow structure (22).

37. Substrate according to any of Claims 29 to 36, **characterized in that** the temperature-regulating hollow structure (22), in particular periodically, repeatedly widens and narrows in the longitudinal direction (60).

38. Substrate according to Claim 37, **characterized in that** the cross-sections of the temperature-regulating hollow structure (22) in the repeatedly widening section are asymmetrical with respect to the longitudinal central axis of the temperature-regulating hollow structure (22).

39. Substrate according to Claim 37 or 38, **characterized in that** a flow surface (140) with periodically occurring elevations and depressions is formed in such a way that the internal lateral surface (80) of the temperature-regulating hollow structure (22), in longitudinal sections through the longitudinal central axis, follows a wavy line (142) at least on one side, wherein there is in particular at least one longitudinal section through the longitudinal central axis in which the internal lateral surface (80) of the temperature-regulating hollow structure (22) follows a wavy line (142) on one side and a straight line (138) on the other side.

40. Substrate according to any of Claims 37 to 39, **characterized in that** the temperature-regulating hollow structure (22) has recesses (144) which are spaced apart from one another in the longitudinal direction and which have at least one height h at which vortex flows (148) of a temperature-regulating fluid (146) flowing through the temperature-regulating hollow structures (22) occur, in which the temperature-regulating fluid (146) circulates at least at times.

41. Substrate according to any of Claims 29 to 40, **characterized in that** flow structures (150) which reduce the frictional resistance vis-à-vis a flowing liquid temperature-regulating fluid (146) are formed on the internal lateral surface (80) of the temperature-regulating hollow structure (22).

42. Substrate according to Claim 41, **characterized in that** the flow structures (150) are riblet structures (152) with ribs (154) formed in the longitudinal direction (60).

43. Substrate according to Claim 41, **characterized in that** the riblet structures (152) correspond to the surface (158) of a scale structure (160) composed of a multiplicity of individual scales (162) with ribs (154).

44. Optical element, in particular a mirror (10) for an EUV projection exposure apparatus, comprising a substrate (12), **characterized in that**
the substrate (12) is a substrate (12) according to any of Claims 29 to 43.

45. Optical element according to Claim 44, **characterized in that** the optical element (8) is a mirror (10) for an EUV projection exposure apparatus, wherein the substrate (12) has a carrier surface (14) bearing a coating (16) configured at least to reflect at least 50% of EUV light impinging with normal or almost normal incidence.

46. Processing system for incorporating temperature-regulating hollow structures (22) into a substrate (12), in particular into a substrate for a mirror (10) for an EUV projection exposure apparatus, comprising

a) a light source (44), by which a processing light beam (46) is generable;
b) a focusing device (50), by means of which the processing light beam (46) is focusable on ablation locations (56) at which temperature-regulating hollow structures (22) are intended to arise;
c) a control device (58), by means of which the focusing device (50) is controllable; **characterized in that**
d) the processing system (40) is configured in such a way that it controls the focusing device (50) in the manner such that the method according to any of Claims 1 to 28 is carried out.

47. Apparatus pertaining to semiconductor technology, in particular an EUV projection exposure apparatus (200), a mask inspection apparatus or a wafer inspection apparatus, in which an object (222) is irradiatable with a working radiation (214) with the aid of at least one optical element (8), **characterized in that** the optical element (8) is an optical element (8) according to Claim 44 or 45.

48. Apparatus according to Claim 47, **characterized in that** the apparatus is an EUV projection exposure apparatus (200) and **in that** the at least one optical element (8) is a mirror (10) according to Claim 45.

49. Structured electronic component, **characterized in that** the structured electronic component (224) was produced with the aid of an apparatus (6) pertaining to semiconductor technology according to Claim 47 or 48 and using at least one optical element (8) according to Claim 44 or 45.

Fig. 1

Fig. 2

Fig. 3

Fig. 4

Fig. 5

Fig. 6

A                             B

Fig. 7

Fig. 8

Fig. 9

# Fig. 10

# Fig. 11

# Fig. 12

# Fig. 13

Fig. 14

Fig. 15

Fig. 16

Fig. 17

A                                                                B

Fig. 18

**Fig. 19**

A      **Fig. 20**      B

**Fig. 21**

Fig. 22

Fig. 23

Fig. 24

Fig. 25

Fig. 26

Fig. 27

Fig. 28

Fig. 29

Fig. 30

Fig. 31

Fig. 32

Fig. 33

Fig.34

Fig. 35

A         B         C

Fig. 36

Fig. 37

Fig. 38

Fig. 39

Fig. 40

Fig. 41

Fig. 42

Fig. 43

Fig. 44

Europäisches
Patentamt
European
Patent Office
Office européen
des brevets

# EUROPEAN SEARCH REPORT

**Application Number**

EP 24 18 2338

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JIA XIANSHI ET AL: "Advances in Laser Drilling of Structural Ceramics", NANOMATERIALS, vol. 12, no. 2, 11 January 2022 (2022-01-11), page 230, XP093253364, ISSN: 2079-4991, DOI: 10.3390/nano12020230 * Sections 1-6; Figures * | 1-7, 10-15 | INV. C03C15/00 C03C17/34 C03C23/00 B23K26/082 G03F7/00 |
| X | US 11 077 526 B2 (ELECTRO SCIENT IND INC [US]) 3 August 2021 (2021-08-03) * claims; figures; col. 1,2,7,45-48,63,65,66 * | 1-9, 12-15 | |
| X | EP 3 335 826 A1 (UNIV DEGLI STUDI DELLINSUBRIA [IT]) 20 June 2018 (2018-06-20) * claims; figures; par. [0040]-[0046],[0054]-[0056],[0060]-[0067], [0075] * | 1-7, 13-15 | |
| X | US 5 223 692 A (LOZIER TODD B [US] ET AL) 29 June 1993 (1993-06-29) * claims; figures; col. 6,7 * | 1-7, 13-15 | TECHNICAL FIELDS SEARCHED (IPC) C03C B23K B81C G03F |

-/--

The present search report has been drawn up for all claims

| Place of search | Date of completion of the search | Examiner |
|---|---|---|
| Munich | 27 February 2025 | Zandonà, Alessio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 24 18 2338

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LEE HYEON-MIN ET AL: "Determining the machining parameters for femtosecond laser helical drilling of aluminosilicate glass substrate", INTERNATIONAL JOURNAL OF PRECISION ENGINEERING AND MANUFACTURING, vol. 18, no. 7, 1 July 2017 (2017-07-01), pages 923-930, XP093253913, Springer ISSN: 2234-7593, DOI: 10.1007/s12541-017-0109-1 Retrieved from the Internet: URL:http://link.springer.com/article/10.10 07/s12541-017-0109-1/fulltext.html> * Figures; Section 2 * | 1-7, 13-15 | |
| X | WO 2021/126662 A1 (AVAVA INC [US]) 24 June 2021 (2021-06-24) * claims; figures; par. [0030]-[0035],[0064],[0071]-[0075] * | 1-7 | |
| X | DE 10 2019 219179 A1 (ZEISS CARL SMT GMBH [DE]) 10 June 2021 (2021-06-10) * claims; par. [0006],[0020]; figures * | 1-3,5-7 | TECHNICAL FIELDS SEARCHED (IPC) |

The present search report has been drawn up for all claims

| Place of search | Date of completion of the search | Examiner |
|---|---|---|
| Munich | 27 February 2025 | Zandonà, Alessio |

EPO FORM 1503 03.82 (P04C01)

page 2 of 2

Europäisches
Patentamt

European
Patent Office

Office européen
des brevets

**Application Number**

EP 24 18 2338

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☒ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

## ANNEX TO THE EUROPEAN SEARCH REPORT
## ON EUROPEAN PATENT APPLICATION NO.

EP 24 18 2338

27-02-2025

| Patent document cited in search report | | Publication date | Patent family member(s) | | Publication date |
|---|---|---|---|---|---|
| US 11077526 | B2 | 03-08-2021 | CN | 108025396 A | 11-05-2018 |
| | | | CN | 112091421 A | 18-12-2020 |
| | | | CN | 116213918 A | 06-06-2023 |
| | | | JP | 6921057 B2 | 18-08-2021 |
| | | | JP | 7404316 B2 | 25-12-2023 |
| | | | JP | 2018532595 A | 08-11-2018 |
| | | | JP | 2021181121 A | 25-11-2021 |
| | | | JP | 2023175958 A | 12-12-2023 |
| | | | KR | 20180039747 A | 18-04-2018 |
| | | | KR | 20240010086 A | 23-01-2024 |
| | | | TW | 201718158 A | 01-06-2017 |
| | | | TW | 202132034 A | 01-09-2021 |
| | | | TW | 202304626 A | 01-02-2023 |
| | | | TW | 202400340 A | 01-01-2024 |
| | | | US | 2019001442 A1 | 03-01-2019 |
| | | | US | 2021316400 A1 | 14-10-2021 |
| | | | WO | 2017044646 A1 | 16-03-2017 |
| EP 3335826 | A1 | 20-06-2018 | EP | 3335826 A1 | 20-06-2018 |
| | | | WO | 2018109049 A1 | 21-06-2018 |
| US 5223692 | A | 29-06-1993 | NONE | | |
| WO 2021126662 | A1 | 24-06-2021 | EP | 4076827 A1 | 26-10-2022 |
| | | | US | 2021187668 A1 | 24-06-2021 |
| | | | WO | 2021126662 A1 | 24-06-2021 |
| DE 102019219179 | A1 | 10-06-2021 | CN | 114787092 A | 22-07-2022 |
| | | | DE | 102019219179 A1 | 10-06-2021 |
| | | | JP | 2023505681 A | 10-02-2023 |
| | | | US | 2022299731 A1 | 22-09-2022 |
| | | | WO | 2021115643 A1 | 17-06-2021 |

**REFERENCES CITED IN THE DESCRIPTION**

**Patent documents cited in the description**

- DE 102023205568
- DE 102021214310
- DE 102024116622